(19) Europäisches Patentamt
European Patent Office
Office européen des brevets

(11) **EP 4 637 150 A1**

(12) **EUROPEAN PATENT APPLICATION**
published in accordance with Art. 153(4) EPC

(43) Date of publication:
**22.10.2025 Bulletin 2025/43**

(21) Application number: **24741236.4**

(22) Date of filing: **09.01.2024**

(51) International Patent Classification (IPC):
*H04N 19/182* *(2014.01)*

(52) Cooperative Patent Classification (CPC):
**H04N 19/124; H04N 19/182; H04N 19/44**

(86) International application number:
**PCT/CN2024/071323**

(87) International publication number:
**WO 2024/149238 (18.07.2024 Gazette 2024/29)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **09.01.2023 CN 202310028884**
**22.03.2023 CN 202310295323**

(71) Applicant: **Huawei Technologies Co., Ltd.**
**Shenzhen, Guangdong 518129 (CN)**

(72) Inventors:
• **KANG, Ning**
**Shenzhen, Guangdong 518129 (CN)**
• **ZHANG, Shifeng**
**Shenzhen, Guangdong 518129 (CN)**
• **LI, Zhenguo**
**Shenzhen, Guangdong 518129 (CN)**

(74) Representative: **Thun, Clemens**
**Mitscherlich PartmbB**
**Patent- und Rechtsanwälte**
**Karlstraße 7**
**80333 München (DE)**

(54) **DATA ENCODING METHOD, DATA DECODING METHOD, AND RELATED APPARATUSES**

(57)    A data encoding method and a data decoding method are provided and are applied to the data coding field. The method includes: obtaining a target symbol; obtaining, based on a first mapping relationship, first information and second information that correspond to the target symbol, where the first information and the second information are obtained based on probability information corresponding to the target symbol; obtaining first encoded data through a first operation based on the first information and status information of an encoder; and updating the status information through a second operation based on the second information, to obtain second encoded data. The first encoded data and the second encoded data are used to obtain an encoding result of the target symbol, and the first operation and the second operation do not include a division operation. In this application, index information in an encoding table includes only symbols, and a mapped object includes only the first information and the second information. This is equivalent to reducing memory usage in the encoding table, avoiding an operation that consumes a large amount of memory, and balancing memory and a delay.

```
┌────────────────────────────────────────────┐
│           Obtain a target symbol            │── 601
└────────────────────────────────────────────┘
                      │
                      ▼
┌────────────────────────────────────────────┐
│ Obtain, based on a first mapping relationship, first │── 602
│ information and second information that correspond   │
│ to the target symbol, where the first information    │
│ and the second information are obtained based on     │
│ probability information corresponding to the         │
│ target symbol                                        │
└────────────────────────────────────────────┘
                      │
                      ▼
┌────────────────────────────────────────────┐
│ Obtain first encoded data through a first            │── 603
│ operation based on the first information and         │
│ status information of an encoder                     │
└────────────────────────────────────────────┘
                      │
                      ▼
┌────────────────────────────────────────────┐
│ Update the status information through a second       │── 604
│ operation based on the second information, to        │
│ obtain second encoded data, where the first          │
│ encoded data and the second encoded data are         │
│ used to obtain an encoding result of the target      │
│ symbol, and the first operation and the second       │
│ operation do not include a division operation        │
└────────────────────────────────────────────┘
```

FIG. 6

## Description

This application claims priorities to Chinese Patent Application No. 202310028884.0, filed with the China National Intellectual Property Administration on January 9, 2023 and entitled "DATA ENCODING METHOD, DATA DECODING METHOD, AND RELATED APPARATUS", and to Chinese Patent Application No. 202310295323.7, filed with the China National Intellectual Property Administration on March 22, 2023 and entitled "DATA ENCODING METHOD, DATA DECODING METHOD, AND RELATED APPARATUS", both of which are incorporated herein by reference in their entireties.

## TECHNICAL FIELD

This application relates to the data coding field, and in particular, to a data encoding method, a data decoding method, and a related apparatus thereof.

## BACKGROUND

Artificial intelligence (artificial intelligence, AI) is a theory, a method, a technology, and an application system that simulate, extend, and expand human intelligence by using a digital computer or a machine controlled by a digital computer, to perceive an environment, obtain knowledge, and achieve an optimal result based on the knowledge. In other words, artificial intelligence is a branch of computer science, and is intended to figure out the essence of intelligence and produce a new intelligent machine that can react in a manner similar to human intelligence. Artificial intelligence is to study design principles and implementation methods of various intelligent machines, so that the machines possess perception, inference, and decision-making functions.

Media compression generally includes one or more stages of prediction, frequency transformation, and quantization, followed by entropy encoding. Corresponding media decompression generally includes entropy decoding, followed by one or more stages of inverse quantization, inverse frequency transformation, and prediction. Generally, entropy encoding converts input symbols into encoded data with a lower bit rate by utilizing redundancy in the input symbols (for example, by using patterns of a plurality of input symbols with common values and a plurality of input symbols with rare values). Entropy decoding converts the encoded data into output symbols corresponding to the input symbols. There are many variants of entropy encoding/decoding, which provide different trade-offs in terms of compression efficiency and computational complexity. For example, Huffman encoding/decoding is computationally simple, but has poor compression efficiency for some distribution of values of input symbols. In addition, arithmetic encoding/decoding usually has much better compression efficiency at the cost of much higher computational complexity.

Asymmetric numeral system (ANS) encoding/decoding potentially provides high compression efficiency and low computational complexity. However, existing ANS-based encoding includes division, a modulo operation, and judgment, existing ANS-based decoding includes a binary search operation, and the foregoing operations are all time-consuming. In addition, a large quantity of items in an encoding table and a decoding table are used during encoding and decoding. In scenarios with extensive distribution such as AI compression, an encoding table and a decoding table occupy a large amount of memory.

## SUMMARY

This application provides a data encoding method and a data decoding method, to balance memory and a delay.

According to a first aspect, this application provides a data encoding method. The method includes: obtaining a target symbol; obtaining, based on a first mapping relationship, first information and second information that correspond to the target symbol, where the first information and the second information are obtained based on probability information corresponding to the target symbol; obtaining first encoded data through a first operation based on the first information and status information of an encoder; and updating the status information through a second operation based on the second information, to obtain second encoded data. The first encoded data and the second encoded data are used to obtain an encoding result of the target symbol, and the first operation and the second operation do not include a division operation.

In this application, index information in an encoding table includes only symbols, and a mapped object includes only the first information and the second information. This is equivalent to reducing memory usage in the encoding table, avoiding an operation that consumes a large amount of memory, and balancing memory and a delay.

In a possible implementation, the first information or the second information represents an integer value.

In a possible implementation, the first operation and the second operation do not include a judgment operation.

In a possible implementation, the first operation includes: performing a summation operation on the first information and the status information, and performing a bit shift operation on a summation result of the summation operation; and selecting some bits from the status information as the first encoded data, where locations of the some bits in the status information are determined based on a shift result of the bit shift operation.

In a possible implementation, the second operation includes: performing a summation operation on the status information and a value M, and performing a bit shift operation on a summation result of the summation operation, where the probability information includes a quantization probability, and M is a denominator of the quantization probability; and performing a summation operation on a shift result of the bit shift operation and the second information.

In a possible implementation, the probability information includes a value of a probability mass function PMF, and the value of the PMF is constructed in the following manner: sequentially determining a value of a PMF of each of a plurality of symbols, where the plurality of symbols include the target symbol.

When a value of a PMF of the target symbol is determined, a total value of remaining PMFs other than a PMF of a determined symbol is multiplied by a probability of the target symbol, a ratio of a multiplication result of the multiplication to a remaining probability obtained by excluding the determined symbol is calculated, and the PMF of the target symbol is determined based on a relationship between the ratio and a preset fifth value.

In a possible implementation, the fifth value is 1, and the relationship is taking a larger value.

In a possible implementation, the probability information includes a value of a cumulative distribution function CDF, and the value of the CDF is constructed in the following manner: sequentially determining a value of a CDF of each symbol in a preset order, where the preset order is determined based on a relationship between values of PMFs corresponding to a plurality of symbols, and the plurality of symbols include the target symbol, where when probability distribution corresponding to the probability information of the target symbol is symmetric distribution, the preset order is an alternating order along two sides of a peak point in the symmetric distribution; or when probability distribution corresponding to the probability information of the target symbol is discrete distribution, the preset order is specifically a descending order; or when probability distribution corresponding to the probability information of the target symbol is discrete distribution, the preset order is specifically an ascending order.

In a possible implementation, the target symbol is obtained by transforming pixel data of an image, data obtained by transforming the pixel data of the image meets preset distribution, the transform is further used to obtain a distribution feature of the pixel data, the distribution feature includes a mean value or a variance; and the method further includes: determining, from a plurality of mapping relationships based on the distribution feature, the first mapping relationship corresponding to the distribution feature.

In a possible implementation, a plurality of distribution features include a first distribution feature and a second distribution feature, and an entropy of the first distribution feature is greater than an entropy of the second distribution feature; and a value of a denominator of a quantization probability in a mapping relationship corresponding to the second distribution feature is greater than that of a denominator of a quantization probability in a mapping relationship corresponding to the first distribution feature.

In a multi-distribution scenario, different quantization probability denominators may be used to reduce an encoding length. During data encoding, a prediction model and entropy encoding may be included, and the prediction model may input original data, and output a distribution index and to-be-encoded data (for example, the target symbol in this application). An entropy may be calculated based on the distribution index. A larger quantization probability denominator may be used for distribution with a smaller entropy.

In a possible implementation, the first information in the first mapping relationship is constructed in the following manner: performing a summation operation on a preset sixth value and a quantity of leftmost bits that are consecutive 0s in the value of the PMF of the target symbol; and performing a bit shift operation on a summation result of the summation operation, and performing a subtraction operation on a shift result of the bit shift operation and a shift result of a bit shift operation performed on the value of the PMF of the target symbol, to obtain the first information; or performing a bit shift operation on a summation result of the summation operation, performing a subtraction operation on a shift result of the bit shift operation and a shift result of a bit shift operation performed on the value of the PMF of the target symbol, and performing an summation operation on an operation result of the subtraction operation and a value M, to obtain the first information, where the probability information includes a quantization probability, and M is a denominator of the quantization probability.

In embodiments of this application, the PMF calculation method and the CDF calculation method can ensure that a codeword length is reduced without changing memory and a delay.

In a possible implementation, the second information in the first mapping relationship is constructed in the following manner: performing a subtraction operation on the value of the CDF of the target symbol and the value of the PMF of the target symbol, to obtain the second information; or performing a subtraction operation on the value of the CDF of the target symbol and the value of the PMF of the target symbol, and performing a summation operation on an operation result of the subtraction operation and the value M, to obtain the second information, where the probability information includes the quantization probability, and M is the denominator of the quantization probability.

In a possible implementation, the second information in the first mapping relationship is constructed in the following manner: when a result of a subtraction operation performed on the value of the CDF of the target symbol and the value of the PMF of the target symbol is greater than or equal to 0, using the result of the subtraction operation as the second information; or when a result of a subtraction operation performed on the value of the CDF of the target symbol and the value of the PMF of the target symbol is less than 0, performing a summation operation on the operation result of the subtraction operation and the value M, to obtain the second information, where the probability information includes the quantization probability, and M is the denominator of the quantization probability.

In a possible implementation, to further reduce memory usage, the first information and the second information may be combined and then stored, and after obtaining combined data, the encoder may restore the first information and the second information according to a specific operation rule.

In a possible implementation, an integer value corresponding to the target symbol may be obtained based on the first mapping relationship; and the integer value is restored to the first information and the second information through a third operation, where the first information and the second information each are an integer value. The foregoing manner can reduce memory consumption, shorten memory read time, and further improve throughput on some hardware devices (for example, a server).

For example, a plurality of integer parameters (at most one of which is a signed integer) may be combined into a single parameter. The method is as follows: placing a signed integer on the leftmost side, and then sequentially storing the parameters by bit based on a quantity of bits of each parameter through a shift operation and a bit OR operation; and when a symbol is read, restoring each parameter through a shift operation and a bit AND operation.

In a possible implementation, the probability information includes PMF information corresponding to each symbol, and the PMF information includes a first value and a second value; a sum of the first value and the second value is the value of the PMF; the probability information further includes CDF information corresponding to each symbol, and the CDF information includes a third value and a fourth value; and the third value and the fourth value are constructed in the following manner:

sequentially determining, in the preset order through accumulation based on first values of the plurality of symbols, a third value corresponding to each symbol; and

sequentially determining, in the preset order through accumulation based on second values and third values of the plurality of symbols, a fourth value corresponding to each symbol.

In a possible implementation, the second information includes first sub-information (which may also be referred to as a status addend 1), second sub-information (which may also be referred to as a status threshold), and third sub-information (which may also be referred to as a status addend 2).

The first sub-information in the first mapping relationship is constructed in the following manner: performing a subtraction operation on a third value of the target symbol and the value of the PMF of the target symbol, to obtain the first sub-information.

The second sub-information in the first mapping relationship is constructed in the following manner: performing a summation operation on the third value of the target symbol and a first value of the target symbol, and performing a subtraction operation on an operation result of the summation operation and 1, to obtain the second sub-information.

The third sub-information in the first mapping relationship is constructed in the following manner: performing a subtraction operation on a fourth value of the target symbol and the third value of the target symbol, and performing a subtraction operation on an operation result of the subtraction operation and the first value of the target symbol, to obtain the third sub-information.

In a possible implementation, the second operation includes:

performing a summation operation on the status information and the value M, and performing a bit shift operation on a summation result of the summation operation, where the probability information includes the quantization probability, and M is the denominator of the quantization probability; and performing a summation operation on a shift result of the bit shift operation and the first sub-information; and

when an operation result of the summation operation is greater than the second sub-information, using a summation result of the operation result of the summation operation and the third sub-information as the second encoded data; or when an operation result of the summation operation is less than the second sub-information, using the operation result of the summation operation as the second encoded data.

The foregoing manner may be applicable to, but is not limited to, single-peak symmetric distribution (for example, Gaussian distribution, logistic distribution, or Laplace distribution), and is used to reduce an encoding length, but an encoding calculation amount is increased.

In a possible implementation, when the value M is 256, the first information is stored by using 10 bits, the first sub-information is stored by using 8 bits, the second sub-information is stored by using 7 bits, the third sub-information is stored by using 7 bits, a sum of the first values of the plurality of symbols is 128, and the third sub-information is less than 128.

This application further provides a data encoding method, applied to an asymmetric numeral system ANS-based encoder. The method includes: obtaining a first symbol, where a sum of a quantization probability corresponding to the first symbol and a quantization probability corresponding to a second symbol is 1, a difference between the quantization probability corresponding to the first symbol and 1 is less than a threshold, and a difference between the quantization probability corresponding to the second symbol and 0 is less than the threshold; and when a value relationship between status information of an encoder and a value M meets a first condition, performing a first operation on the status information and the value M to obtain first encoded data, and updating the status information to 0; or when a value relationship between status information of the encoder and a value M does not meet a first condition, adding 1 to the status information.

In a possible implementation, the method further includes: obtaining the second symbol; and using the status information of the encoder as the first encoded data, and updating the status information to a difference between the value M and 1.

The foregoing embodiment may be specific to an encoding and decoding solution for a case in which there are two types of symbols in total and a probability of a single symbol is close to 1. In this embodiment, there is no need to construct encoding and decoding tables. Therefore, no additional memory is required to store the tables.

According to a second aspect, this application provides a data decoding method. The method includes: obtaining status information of a decoder and a memory bit, where the status information corresponds to a first bit, and the first bit is a current to-be-decoded bit; and determining, based on a first mapping relationship, first information, second information, and third information that correspond to the status information, where the first information is a target symbol corresponding to the first bit, the target symbol is a decoding result of the first bit, the second information indicates a quantity of bits selected from the memory bit, the third information is used to perform a summation operation with a bit selected from the memory bit based on the third information, a result of the summation operation is used to update the status information, updated status information corresponds to a second bit, and the second bit is a to-be-decoded bit after the first bit.

In a possible implementation, the method further includes: removing, from the memory bit, the selected bit, to obtain an updated memory bit.

In a possible implementation, the first information, the second information, or the third information represents an integer value.

In a possible implementation, the first information in the first mapping relationship is constructed in the following manner: using x that satisfies $C(x) \leq s < (C(x) + P(x))$ as the first information, where C represents a value of a CDF, P represents a value of a PMF, and s represents the status information.

In a possible implementation, the first information in the first mapping relationship is constructed in the following manner:

using x that satisfies $C1(x) \leq s < C1(x) + P1(x)$ or $C2(x) \leq s < C2(x) + P2(x)$ as the first information, where C1 represents a third value corresponding to a CDF, P1 represents a first value corresponding to a PMF, C2 represents a fourth value corresponding to the CDF, P2 represents a second value corresponding to the PMF, s represents the status information, and a sum of the first value and the second value is a value of the PMF.

In a possible implementation, the second information in the first mapping relationship is constructed in the following manner:

using a value of $clz(s' - C(x) + P(x)) + X$ as the second information, where clz represents taking a quantity of leftmost bits that are consecutive 0s in a value, X is a preset fifth value, and s' is obtained in the following manner:

if $C2(x) \leq s$, $s' = P1(x) + s - C2(x) + P(x)$; or if $C2(x) > s$, $s' = s - C1(x) + P(x)$.

In a possible implementation, the third information in the first mapping relationship is constructed in the following manner: performing a bit shift operation on a value of $s' - C(x) + P(x)$, to obtain the third information, where a shift quantity of the bit shift operation is obtained based on the second information.

In a possible implementation, the second information in the first mapping relationship is constructed in the following manner: using a value of $clz(s - C(x) + P(x)) + X$ as the second information, where clz represents taking a quantity of leftmost bits that are consecutive 0s in a value, and X is a preset fifth value.

In a possible implementation, the third information in the first mapping relationship is constructed in the following manner:

performing a bit shift operation on a value of $s - C(x) + P(x)$, to obtain the third information, where a shift quantity of the bit shift operation is obtained based on the second information; or

performing a bit shift operation on a value of $s - C(x) + P(x)$, and subtracting a value M from an operation result of the bit shift operation, to obtain the third information, where M is the denominator of the quantization probability, and a shift quantity of the bit shift operation is obtained based on the second information.

In a possible implementation, the first information, the second information, or the third information is obtained based on probability information; the probability information includes a value of a probability mass function PMF; and the value of the PMF is constructed in the following manner: sequentially determining a value of a PMF of each of a plurality of symbols, where the plurality of symbols include the target symbol, and when a value of a PMF of the target symbol is determined, a total value of remaining PMFs other than a PMF of a determined symbol is multiplied by a probability of the target symbol, a ratio of a multiplication result of the multiplication to a remaining probability obtained by excluding the determined symbol is calculated, and the PMF of the target symbol is determined based on a relationship between the ratio and a preset value.

In a possible implementation, the preset value is 1, and the relationship is taking a larger value.

In a possible implementation, the first information, the second information, or the third information is obtained based on the probability information, the probability information includes the value of the cumulative distribution function CDF, and the value of the CDF is constructed in the following manner:

sequentially determining a value of a CDF of each symbol in a preset order, where the preset order is determined based on a relationship between values of PMFs corresponding to the plurality of symbols, and the plurality of symbols include the target symbol, where

when probability distribution corresponding to the probability information of the target symbol is symmetric distribution, the preset order is an alternating order along two sides of a peak point in the symmetric distribution; or

when probability distribution corresponding to the probability information of the target symbol is discrete distribution, the preset order is specifically a descending order; or

when probability distribution corresponding to the probability information of the target symbol is discrete distribution, the preset order is specifically an ascending order.

In a possible implementation, the method further includes:

obtaining an encoding result, where the encoding result is obtained by encoding pixel data of an image, and the status information and the memory bit are obtained based on the encoding result;

processing the encoding result, to obtain a distribution feature of the pixel data, where the distribution feature includes a mean value or a variance; and

determining, from a plurality of mapping relationships based on the distribution feature, the first mapping relationship corresponding to the distribution feature.

This application further provides a data decoding method, applied to an asymmetric numeral system ANS-based decoder. The method includes:

obtaining status information of the decoder, where the status information corresponds to a first bit, and the first bit is a current to-be-decoded bit; and

if the status information is a difference between a value M and 1, determining that a decoding result of the first bit is a second symbol, and updating the status information to a result of reading the value M bits from a memory bit; or

if the status information is not a difference between a value M and 1, determining that a decoding result of the first bit is a first symbol; and if the status information is 0, updating the status information to a summation result of a difference between the value M and 2 and a value of 1 bit read from the memory bit; or if the status information is not 0, updating the status information to a difference between the status information and 1, where updated status information corresponds to a second bit, and the second bit is a to-be-decoded bit after the first bit.

According to a third aspect, this application provides a data encoding apparatus. The apparatus includes:

an obtaining module, configured to obtain a target symbol; and

an encoding module, configured to: obtain, based on a first mapping relationship, first information and second information that correspond to the target symbol, where the first information and the second information are obtained based on probability information corresponding to the target symbol;

obtain first encoded data through a first operation based on the first information and status information of the encoder; and

update the status information through a second operation based on the second information, to obtain second encoded data.

The first encoded data and the second encoded data are used to obtain an encoding result of the target symbol, and the first operation and the second operation do not include a division operation.

In a possible implementation, the first information or the second information represents an integer value.

In a possible implementation, the first operation and the second operation do not include a judgment operation.

In a possible implementation, the first operation includes:

performing a summation operation on the first information and the status information, and performing a bit shift operation on a summation result of the summation operation; and

selecting some bits from the status information as the first encoded data, where locations of the some bits in the status information are determined based on a shift result of the bit shift operation.

In a possible implementation, the second operation includes:

performing a summation operation on the status information and a value M, and performing a bit shift operation on a summation result of the summation operation, where the probability information includes a quantization probability, and M is a denominator of the quantization probability; and

performing a summation operation on a shift result of the bit shift operation and the second information.

In a possible implementation, the probability information includes a value of a probability mass function PMF, and the value of the PMF is constructed in the following manner:

sequentially determining a value of a PMF of each of a plurality of symbols, where the plurality of symbols include the target symbol, where

when a value of a PMF of the target symbol is determined, a total value of remaining PMFs other than a PMF of a determined symbol is multiplied by a probability of the target symbol, a ratio of a multiplication result of the multiplication to a remaining probability obtained by excluding the determined symbol is calculated, and the PMF of the target symbol is determined based on a relationship between the ratio and a preset fifth value.

In a possible implementation, the fifth value is 1, and the relationship is taking a larger value.

In a possible implementation, the probability information includes a value of a cumulative distribution function CDF, and the value of the CDF is constructed in the following manner:

sequentially determining a value of a CDF of each symbol in a preset order, where the preset order is determined based on a relationship between values of PMFs corresponding to the plurality of symbols, and the plurality of symbols include the target symbol, where

when probability distribution corresponding to the probability information of the target symbol is symmetric distribution, the preset order is an alternating order along two sides of a peak point in the symmetric distribution; or

when probability distribution corresponding to the probability information of the target symbol is discrete distribution, the preset order is specifically a descending order; or

when probability distribution corresponding to the probability information of the target symbol is discrete distribution, the preset order is specifically an ascending order.

In a possible implementation, the target symbol is obtained by transforming pixel data of an image, data obtained by transforming the pixel data of the image meets preset distribution, the transform is further used to obtain a distribution feature of the pixel data, and the distribution feature includes a mean value or a variance; and the obtaining module is further configured to:

determine, from a plurality of mapping relationships based on the distribution feature, the first mapping relationship corresponding to the distribution feature.

In a possible implementation, a plurality of distribution features include a first distribution feature and a second distribution feature, and an entropy of the first distribution feature is greater than an entropy of the second distribution feature; and

a value of a denominator of a quantization probability in a mapping relationship corresponding to the second distribution feature is greater than that of a denominator of a quantization probability in a mapping relationship corresponding to the first distribution feature.

In a possible implementation, the first information in the first mapping relationship is constructed in the following manner:

performing a summation operation on a preset sixth value and a quantity of leftmost bits that are consecutive 0s in the value of the PMF of the target symbol; and

performing a bit shift operation on a summation result of the summation operation, and performing a subtraction operation on a shift result of the bit shift operation and a shift result of a bit shift operation performed on the value of the PMF of the target symbol, to obtain the first information; or

performing a bit shift operation on a summation result of the summation operation, performing a subtraction operation on a shift result of the bit shift operation and a shift result of a bit shift operation performed on the value of the PMF of the target symbol, and performing a summation operation on an operation result of the subtraction operation and a value M, to obtain the first information, where the probability information includes the quantization probability, and M is the denominator of the quantization probability.

In a possible implementation, the second information in the first mapping relationship is constructed in the following manner:

performing a subtraction operation on a value of a CDF of the target symbol and the value of the PMF of the target symbol, to obtain the second information; or

performing a subtraction operation on a value of a CDF of the target symbol and the value of the PMF of the target symbol, and performing a summation operation on an operation result of the subtraction operation and a value M, to obtain the second information, where the probability information includes the quantization probability, and M is the denominator of the quantization probability.

In a possible implementation, the second information in the first mapping relationship is constructed in the following manner:

when a result of a subtraction operation performed on a value of a CDF of the target symbol and the value of the PMF of the target symbol is greater than or equal to 0, using the result of the subtraction operation as the second information; or

when a result of a subtraction operation performed on a value of a CDF of the target symbol and the value of the PMF of the target symbol is less than 0, performing a summation operation on the operation result of the subtraction operation and a value M, to obtain the second information, where the probability information includes the quantization probability, and M is the denominator of the quantization probability.

In a possible implementation, the encoding module is specifically configured to:

obtain, based on the first mapping relationship, an integer value corresponding to the target symbol; and restore the integer value to the first information and the second information through a third operation, where the first information and the second information each are an integer value.

In a possible implementation, the probability information includes PMF information corresponding to each symbol, and the PMF information includes a first value and a second value; a sum of the first value and the second value is the value of the PMF; the probability information further includes CDF information corresponding to each symbol, and the CDF information includes a third value and a fourth value; and the third value and the fourth value are constructed in the following manner:

sequentially determining, in the preset order through accumulation based on first values of the plurality of symbols, a third value corresponding to each symbol; and sequentially determining, in the preset order through accumulation based on second values and third values of the plurality of symbols, a fourth value corresponding to each symbol.

In a possible implementation, the second information includes first sub-information, second sub-information, and third sub-information.

The first sub-information in the first mapping relationship is constructed in the following manner: performing a subtraction operation on a third value of the target symbol and the value of the PMF of the target symbol, to obtain the first sub-information.

The second sub-information in the first mapping relationship is constructed in the following manner: performing a summation operation on the third value of the target symbol and a first value of the target symbol, and performing a subtraction operation on an operation result of the summation operation and 1, to obtain the second sub-information.

The third sub-information in the first mapping relationship is constructed in the following manner: performing a subtraction operation on a fourth value of the target symbol and the third value of the target symbol, and performing a subtraction operation on an operation result of the subtraction operation and the first value of the target symbol, to obtain the third sub-information.

In a possible implementation, the second operation includes:

performing a summation operation on the status information and the value M, and performing a bit shift operation on a summation result of the summation operation, where the probability information includes the quantization probability, and M is the denominator of the quantization probability; and performing a summation operation on a shift result of the bit shift operation and the first sub-information; and

when an operation result of the summation operation is greater than the second sub-information, using a summation result of the operation result of the summation operation and the third sub-information as the second encoded data; or when an operation result of the summation operation is less than the second sub-information, using the operation result of the summation operation as the second encoded data.

In a possible implementation, when the value M is 256, the first information is stored by using 10 bits, the first sub-information is stored by using 8 bits, the second sub-information is stored by using 7 bits, the third sub-information is stored by using 7 bits, a sum of the first values of the plurality of symbols is 128, and the third sub-information is less than 128.

This application further provides a data encoding apparatus, used in an asymmetric numeral system ANS-based encoder. The apparatus includes:

an obtaining module, configured to obtain a first symbol, where a sum of a quantization probability corresponding to the first symbol and a quantization probability corresponding to a second symbol is 1, a difference between the quantization probability corresponding to the first symbol and 1 is less than a threshold, and a difference between the quantization probability corresponding to the second symbol and 0 is less than the threshold; and

an encoding module, configured to: when a value relationship between status information of the encoder and a value M meets a first condition, perform a first operation on the status information and the value M to obtain first encoded data, and update the status information to 0; or

when a value relationship between status information of the encoder and a value M does not meet a first condition, add 1 to the status information.

In a possible implementation, the obtaining module is further configured to:
obtain the second symbol.

The encoding module is further configured to: use status information of the encoder as the first encoded data, and update the status information to a difference between the value M and 1.

According to a fourth aspect, this application provides a data decoding apparatus. The apparatus includes:

an obtaining module, configured to obtain status information of a decoder and a memory bit, where the status information corresponds to a first bit, and the first bit is a current to-be-decoded bit; and

a decoding module, configured to determine, based on a first mapping relationship, first information, second information, and third information that correspond to the status information, where the first information is a target symbol corresponding to the first bit, the target symbol is a decoding result of the first bit, the second information indicates a quantity of bits selected from the memory bit, the third information is used to perform a summation operation with a bit selected from the memory bit based on the third information, a result of the summation operation is used to update the status information, updated status information corresponds to a second bit, and the second bit is a to-be-decoded bit after the first bit.

In a possible implementation, the decoding module is further configured to:
remove, from the memory bit, the selected bit, to obtain an updated memory bit.

In a possible implementation, the first information, the second information, or the third information represents an integer value.

In a possible implementation, the first information in the first mapping relationship is constructed in the following manner:

using x that satisfies $C(x) \leq s < (C(x) + P(x))$ as the first information, where C represents a value of a CDF, P represents a value of a PMF, and s represents the status information; or

using x that satisfies $C1(x) \leq s < C1(x) + P1(x)$ or $C2(x) \leq s < C2(x) + P2(x)$ as the first information, where C1 represents a third value corresponding to a CDF, P1 represents a first value corresponding to a PMF, C2 represents a fourth value corresponding to the CDF, P2 represents a second value corresponding to the PMF, s represents the status information, and a sum of the first value and the second value is a value of the PMF.

In a possible implementation, the second information in the first mapping relationship is constructed in the following manner:

using a value of $clz(s - C(x) + P(x)) + X$ as the second information, where clz represents taking a quantity of leftmost bits that are consecutive 0s in a value, and X is a preset fifth value; or

performing a bit shift operation on a value of s - C(x) + P(x), to obtain the third information, where a shift quantity of the bit shift operation is obtained based on the second information; or

performing a bit shift operation on a value of s - C(x) + P(x), and subtracting a value M from an operation result of the bit shift operation, to obtain the third information, where M is a denominator of the quantization probability, and a shift quantity of the bit shift operation is obtained based on the second information; or

using a value of clz(s' - C(x) + P(x)) + X as the second information, where clz represents taking a quantity of leftmost bits that are consecutive 0s in a value, X is a preset fifth value, and s' is obtained in the following manner:

if C2(x) ≤ s, s' = P1(x) + s - C2(x) + P(x); or if C2(x) > s, s' = s - C1(x) + P(x).

In a possible implementation, the third information in the first mapping relationship is constructed in the following manner:

performing the bit shift operation on the value of s - C(x) + P(x), to obtain the third information, where the shift quantity of the bit shift operation is obtained based on the second information; or

performing the bit shift operation on the value of s - C(x) + P(x), and subtracting the value M from the operation result of the bit shift operation, to obtain the third information, where M is the denominator of the quantization probability, and the shift quantity of the bit shift operation is obtained based on the second information; or

performing a bit shift operation on a value of s' - C(x) + P(x), to obtain the third information, where a shift quantity of the bit shift operation is obtained based on the second information.

In a possible implementation, the first information, the second information, or the third information is obtained based on probability information, the probability information includes a value of a probability mass function PMF, and the value of the PMF is constructed in the following manner:

sequentially determining a value of a PMF of each of a plurality of symbols, where the plurality of symbols include the target symbol, where

when a value of a PMF of the target symbol is determined, a total value of remaining PMFs other than a PMF of a determined symbol is multiplied by a probability of the target symbol, a ratio of a multiplication result of the multiplication to a remaining probability obtained by excluding the determined symbol is calculated, and the PMF of the target symbol is determined based on a relationship between the ratio and a preset value.

In a possible implementation, the preset value is 1, and the relationship is taking a larger value.

In a possible implementation, the first information, the second information, or the third information is obtained based on the probability information, the probability information includes the value of the cumulative distribution function CDF, and the value of the CDF is constructed in the following manner:

sequentially determining a value of a CDF of each symbol in a preset order, where the preset order is determined based on a relationship between values of PMFs corresponding to the plurality of symbols, and the plurality of symbols include the target symbol, where

when probability distribution corresponding to the probability information of the target symbol is symmetric distribution, the preset order is an alternating order along two sides of a peak point in the symmetric distribution; or

when probability distribution corresponding to the probability information of the target symbol is discrete distribution, the preset order is specifically a descending order; or

when probability distribution corresponding to the probability information of the target symbol is discrete distribution, the preset order is specifically an ascending order.

In a possible implementation, the obtaining module is further configured to:

obtain an encoding result, where the encoding result is obtained by encoding pixel data of an image, and the status information and the memory bit are obtained based on the encoding result;

process the encoding result, to obtain a distribution feature of the pixel data, where the distribution feature includes a mean value or a variance; and

determine, from a plurality of mapping relationships based on the distribution feature, the first mapping relationship corresponding to the distribution feature.

This application further provides a data decoding apparatus, used in an asymmetric numeral system ANS-based decoder. The apparatus includes:

an obtaining module, configured to obtain status information of the decoder, where the status information corresponds to a first bit, and the first bit is a current to-be-decoded bit; and

a decoding module, configured to: if the status information is a difference between a value M and 1, determine that a decoding result of the first bit is a second symbol, and update the status information to a result of reading the value M bits from a memory bit; or

if the status information is not a difference between a value M and 1, determine that a decoding result of the first bit is a first symbol; and if the status information is 0, update the status information to a summation result of a difference between the value M and 2 and a value of 1 bit read from the memory bit; or if the status information is not 0, update the status information to a difference between the status information and 1, where updated status information corresponds to a second bit, and the second bit is a to-be-decoded bit after the first bit.

According to a fifth aspect, an embodiment of this application provides a data encoding apparatus. The apparatus may include a storage, a processor, and a bus system, the storage is configured to store a program, and the processor is configured to execute the program in the storage, to perform any optional method in the first aspect.

According to a sixth aspect, an embodiment of this application provides a data decoding apparatus. The apparatus may include a storage, a processor, and a bus system, the storage is configured to store a program, and the processor is configured to execute the program in the storage, to perform any optional method in the second aspect.

According to a seventh aspect, an embodiment of this application provides a computer-readable storage medium. The computer-readable storage medium stores a computer program, and when the computer program is run on a computer, the computer is enabled to perform the method according to the first aspect and any optional implementation of the first aspect, and the second aspect and any optional implementation of the second aspect.

According to an eighth aspect, an embodiment of this application provides a computer program product, including code. When the code is executed, the method according to the first aspect and any optional implementation of the first aspect, and the second aspect and any optional implementation of the second aspect is implemented.

According to a ninth aspect, this application provides a chip system. The chip system includes a processor, configured to support an execution device or a training device in implementing functions in the foregoing aspects, for example, sending or processing data or information in the foregoing methods. In a possible design, the chip system further includes a storage. The storage is configured to store program instructions and data that are necessary for the execution device or the training device. The chip system may include a chip, or may include a chip and another discrete component.

## BRIEF DESCRIPTION OF DRAWINGS

FIG. 1A is a block diagram of an example of a video coding system used to implement embodiments of the present invention;

FIG. 1B is a block diagram of an example of another video coding system used to implement embodiments of the present invention;

FIG. 2 is a block diagram of an example structure of an encoder used to implement embodiments of the present invention;

FIG. 3 is a block diagram of an example structure of a decoder used to implement embodiments of the present invention;

FIG. 4 is a block diagram of an example of a video coding device used to implement embodiments of the present invention;

FIG. 5 is a schematic flowchart of a data encoding method according to an embodiment of this application;

FIG. 6 is a schematic flowchart of a data encoding method according to an embodiment of this application;

FIG.7 is a schematic flowchart of a data encoding method according to an embodiment of this application;

FIG. 8 is a schematic flowchart of a data encoding method according to an embodiment of this application;

FIG. 9 is a schematic flowchart of a data decoding method according to an embodiment of this application;

FIG. 10A is a schematic flowchart of a data decoding method according to an embodiment of this application;

FIG. 10B is a schematic flowchart of a data decoding method according to an embodiment of this application;

FIG. 11 is a diagram of a structure of a data encoding apparatus according to an embodiment of this application;

FIG. 12 is a diagram of a structure of a data decoding apparatus according to an embodiment of this application;

FIG. 13 is a diagram of an execution device according to an embodiment of this application;

FIG. 14 is a diagram of a server according to an embodiment of this application; and

FIG. 15 is a diagram of a chip according to an embodiment of this application.

## DESCRIPTION OF EMBODIMENTS

The following describes embodiments of the present invention with reference to accompanying drawings in embodiments of the present invention. Terms used in embodiments of the present invention are merely intended to explain specific embodiments of the present invention, and are not intended to limit the present invention.

The following describes embodiments of this application with reference to the accompanying drawings. A person of ordinary skill in the art may learn that, with development of technologies and emergence of a new scenario, the technical solutions provided in embodiments of this application are also applicable to similar technical problems.

In the specification, claims, and the accompanying drawings of this application, terms "first", "second", and the like are intended to distinguish between similar objects but do not necessarily indicate a specific order or sequence. It should be understood that the terms used in such a way are interchangeable in proper circumstances, which is merely a discrimination manner that is used when objects having a same attribute are described in embodiments of this application. In addition, the terms "include", "have" and any other variants mean to cover non-exclusive inclusion, so that a process, method, system, product, or device that includes a series of units is not necessarily limited to those units, but may include other units not expressly listed or inherent to such a process, method, system, product, or device.

In embodiments of the present invention, "at least one" means one or more, and "a plurality of" means two or more. "And/or" describes an association relationship between associated objects, and represents that three relationships may exist. For example, A and/or B may represent the following cases: A exists alone, both A and B exist, and B exists alone, where A and B may be singular or plural. The character "/" generally indicates an "or" relationship between associated objects. "At least one item (piece) of" or a similar expression thereof means any combination of these items, including a singular item (piece) or any combination of plural items (pieces). For example, at least one item (piece) of a, b, or c may represent a, b, c, a and b, a and c, b and c, or a, b, and c, where a, b, and c may be singular or plural.

Many of technologies and tools described in embodiments of this application are described with reference to a media encoder/decoder system. The media encoder/decoder system is, for example, a video encoder/decoder system, an audio encoder/decoder system, or a texture encoder/decoder system. Alternatively, the technologies and the tools described in embodiments of this application may be generally implemented in a data encoder/decoder system used to encode/decode text data or other types of data.

Terms used in embodiments of the present invention are merely intended to explain specific embodiments of the present invention, and are not intended to limit the present invention. The following first briefly describes some concepts that may be used in embodiments of the present invention.

It should be understood that this application is not limited to video coding, and may also be used for audio, texture, or image coding. The following uses video coding as an example for description.

Video coding usually refers to processing of a sequence of pictures that form a video or a video sequence. In the field of video coding, terms "picture (picture)", "frame (frame)", or "image (image)" may be used as synonyms. Video coding used in this specification indicates video encoding or video decoding. Video encoding is performed on a source side, and usually includes processing (for example, compressing) an original video picture to reduce an amount of data for representing the video picture, so that the video picture is stored and/or transmitted more efficiently. Video decoding is performed on a destination side, and usually includes inverse processing relative to an encoder, to reconstruct a video picture. "Coding" of a video picture in embodiments should be understood as "encoding" or "decoding" of a video sequence. A combination of an encoding part and a decoding part is also referred to as coding (encoding and decoding).

A video sequence includes a series of images (pictures), an image is further partitioned into slices (slice), and a slice is further partitioned into blocks (block). In video coding, coding processing is performed per block. In some new video coding standards, a concept of a "block" is further extended. For example, a macroblock (macroblock, MB) is introduced in the H.264 standard, and the macroblock may be further partitioned into a plurality of prediction blocks (partition) for predictive coding. In the high efficiency video coding (high efficiency video coding, HEVC) standard, a plurality of block units are functionally divided based on fundamental concepts such as a coding unit (coding unit, CU), a prediction unit (prediction unit, PU), and a transform unit (transform unit, TU), and are described by using a new tree-based structure. For example, the CU may be partitioned into smaller CUs based on a quad-tree, and a smaller CU may continue to be partitioned to generate a quad-tree structure. The CU is a basic unit for partitioning and coding a to-be-coded image. The PU and the TU also have a similar tree structure. The PU may correspond to a prediction block and is a basic unit of predictive coding. The CU is further partitioned into a plurality of PUs in a partitioning mode. The TU may correspond to a transform block and is a basic unit for transforming a prediction residual. However, all of the CU, the PU, and the TU are essentially concepts of blocks (or image blocks). For a concept of an image block (for example, a first image block and a second image block) in embodiments of this application, refer to descriptions herein.

For example, in HEVC, a CTU is partitioned into a plurality of CUs by using a quad-tree structure represented as a coding tree. A decision on whether to code a picture area using inter-picture (temporal) or intra-picture (spatial) prediction is made at a CU level. Each CU may be further partitioned into one, two, or four PUs based on a PU partitioning type. A same prediction process is applied within a PU, and related information is transmitted to a decoder on a PU basis. After a residual block is obtained by applying the prediction process based on the PU partitioning type, the CU may be partitioned into transform units (transform unit, TU) based on another quad-tree structure similar to the coding tree used for the CU. In the latest development of video compression technologies, a quad-tree and binary tree (Quad-tree and binary tree, QTBT) partition frame is used to partition a coding block. In a QTBT block structure, a CU may be square or rectangular.

In this specification, for ease of description and understanding, a to-be-processed image block in a currently encoded image (referred to as a to-be-processed image block for short) may be referred to as a current block. For example, in encoding, a to-be-processed image block is a block currently being encoded, and in decoding, a to-be-processed image block is a block currently being decoded. A decoded image block that is in a reference image and that is used to predict the current block is referred to as a reference block. In other words, the reference block is a block that provides a reference signal for the current block. The reference signal represents a pixel value in an image block. A block that is in the reference image and that provides a prediction signal for the current block may be referred to as a prediction block. The prediction signal represents a pixel value, a sampling value, or a sampling signal in the prediction block. For example, after a plurality of reference blocks are traversed, an optimal reference block is found, and the optimal reference block provides prediction for the current block, and may be referred to as the prediction block.

In lossless video coding, original video pictures can be reconstructed, that is, reconstructed video pictures have same quality as the original video pictures (assuming that no transmission loss or other data loss occurs during storage or transmission). In lossy video coding, further compression is performed through, for example, quantization, to reduce an amount of data required for representing video pictures, and the video pictures cannot be completely reconstructed on a decoder side, that is, quality of reconstructed video pictures is lower or poorer than that of original video pictures.

Several H.261 video coding standards belong to "lossy hybrid video coding" (that is, spatial and temporal prediction in a sample domain is combined with 2D transform coding for applying quantization in a transform domain). Each picture of a video sequence is usually partitioned into a set of non-overlapping blocks, and coding is usually performed at a block level. In other words, on an encoder side, a video is usually processed, that is, encoded, at a block (video block) level. For example, a prediction block is generated through spatial (intra-picture) prediction and temporal (inter-picture) prediction, the prediction block is subtracted from a current block (a block that is currently being processed or to-be-processed) to obtain a residual block, and the residual block is transformed and quantized in a transform domain to reduce an amount of data to be transmitted (compressed). On a decoder side, inverse processing relative to an encoder is applied to the encoded or compressed block to reconstruct the current block for representation. Furthermore, the encoder duplicates a decoder processing loop, so that the encoder and the decoder generate same prediction (for example, intra prediction and inter prediction) and/or reconstruction, for processing, that is, for coding subsequent blocks.

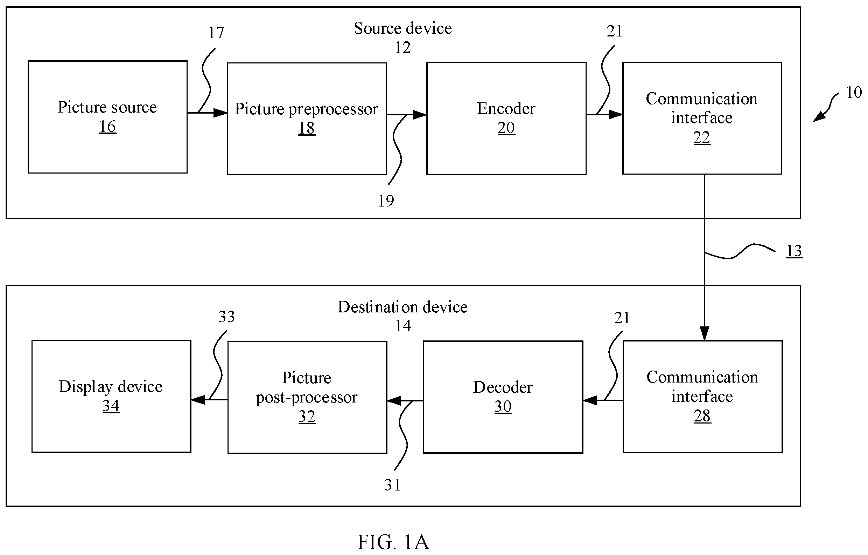

The following describes a system architecture to which embodiments of the present invention are applied. FIG. 1A is a block diagram of an example of a video encoding and decoding system 10 to which embodiments of the present invention are applied. As shown in FIG. 1A, the video encoding and decoding system 10 may include a source device 12 and a destination device 14. The source device 12 generates encoded video data. Therefore, the source device 12 may be referred to as a video encoding apparatus. The destination device 14 may decode the encoded video data generated by the source device 12. Therefore, the destination device 14 may be referred to as a video decoding apparatus. The source device 12, the destination device 14, or various implementation solutions of the source device 12 and the destination device 14 may include one or more processors and a storage coupled to the one or more processors. The storage may include but is not limited to a RAM, a ROM, an EEPROM, a flash memory, or any other medium that can be used to store desired program code in a form of an instruction or a data structure accessible to a computer, as described in this specification. The source device 12 and the destination device 14 may include various apparatuses, including a desktop computer, a mobile computing apparatus, a notebook (for example, laptop) computer, a tablet computer, a set-top box, a handheld telephone such as a so-called "smart" phone, a television, a camera, a display apparatus, a digital media player, a video game console, a vehicle-mounted computer, a wireless communication device, or the like.

Although the source device 12 and the destination device 14 are depicted as separate devices in FIG. 1A, a device embodiment may alternatively include both the source device 12 and the destination device 14 or functionalities of both the source device 12 and the destination device 14, that is, the source device 12 or a corresponding functionality of the source device 12 and the destination device 14 or a corresponding functionality of the destination device 14. In such an embodiment, the source device 12 or the corresponding functionality of the source device 12 and the destination device 14 or the corresponding functionality of the destination device 14 may be implemented by using same hardware and/or software, separate hardware and/or software, or any combination thereof.

The source device 12 may be communicatively connected to the destination device 14 through a link 13, and the destination device 14 may receive the encoded video data from the source device 12 through the link 13. The link 13 may include one or more media or apparatuses that can move the encoded video data from the source device 12 to the destination device 14. In an example, the link 13 may include one or more communication media that enable the source device 12 to directly transmit the encoded video data to the destination device 14 in real time. In this example, the source device 12 may modulate the encoded video data according to a communication standard (for example, a wireless communication protocol), and may transmit modulated video data to the destination device 14. The one or more communication media may include a wireless communication medium and/or a wired communication medium, for example, a radio frequency (RF) spectrum or one or more physical transmission lines. The one or more communication media may form a part of a packet-based network, and the packet-based network is, for example, a local area network, a wide area network, or a global network (for example, the internet). The one or more communication media may include a router, a switch, a base station, or another device that facilitates communication from the source device 12 to the destination device 14.

The source device 12 includes an encoder 20. Optionally, the source device 12 may further include a picture source 16, a picture preprocessor 18, and a communication interface 22. In a specific implementation form, the encoder 20, the picture source 16, the picture preprocessor 18, and the communication interface 22 may be hardware components in the source device 12, or may be software programs in the source device 12. The following describes the components separately.

The picture source 16 may include or may be any type of picture capturing device, configured to, for example, capture a real-world picture, and/or any type of picture or comment (for screen content encoding, some texts on a screen are also considered as a part of a to-be-encoded picture or image). For example, the picture capturing device may be a computer graphics processor configured to generate computer animation pictures, or may be any type of device configured to obtain and/or provide real-world pictures, computer animation pictures (for example, screen content, virtual reality (virtual reality, VR) pictures), and/or any combination thereof (augmented reality (augmented reality, AR) pictures). The picture source 16 may be a camera configured to capture a picture or a storage configured to store a picture. The picture source 16 may further include any type of (internal or external) interface through which a previously captured or generated picture is stored and/or a picture is obtained or received. When the picture source 16 is a camera, the picture source 16 may be, for example, a local camera or an integrated camera integrated in the source device. When the picture source 16 is a storage, the picture source 16 may be a local storage or, for example, an integrated storage integrated in the source device. When the picture source 16 includes an interface, the interface may be, for example, an external interface for receiving a picture from an external video source. The external video source is, for example, an external picture capturing device such as a camera, an external storage, or an external picture generation device. The external picture generation device is, for example, an external computer graphics processor, a computer, or a server. The interface may be any type of interface according to any proprietary or standardized interface protocol, for example, a wired or wireless interface or an optical interface.

A picture may be considered as a two-dimensional array or matrix of picture elements (picture element). A picture element in the array may also be referred to as a sampling point. A quantity of sampling points in horizontal and vertical directions (or axes) of the array or the picture is used to define a size and/or resolution of the picture. Three color components are usually used to represent a color. To be specific, the picture may be represented as or include three sampling arrays. For example, in an RBG format or color space, a picture includes corresponding red, green, and blue sampling arrays. However, in video coding, each pixel is usually represented in a luminance/chrominance format or color space. For example, a picture in a YUV format includes a luminance component indicated by Y (sometimes indicated by L) and two chrominance components indicated by U and V The luminance (luma) component Y represents luminance or gray level intensity (for example, both are the same in a grayscale picture), and the two chrominance (chroma) components U and V represent chrominance or color information components. Correspondingly, the picture in the YUV format includes a luminance sampling array of luminance sampling values (Y) and two chrominance sampling arrays of chrominance values (U and V). A picture in the RGB format may be transformed or converted to a picture in the YUV format, and vice versa. This process is also referred to as color conversion or transform. If a picture is monochrome, the picture may include only a luminance sampling array. In embodiments of the present invention, a picture transmitted from the picture source 16 to the picture processor may also be referred to as raw picture data 17.

The picture preprocessor 18 is configured to: receive the raw picture data 17, and preprocess the raw picture data 17 to obtain a preprocessed picture 19 or preprocessed picture data 19. For example, preprocessing performed by the picture preprocessor 18 may include trimming, color format transformation (for example, transformation from an RGB format to a YUV format), color correction, or denoising.

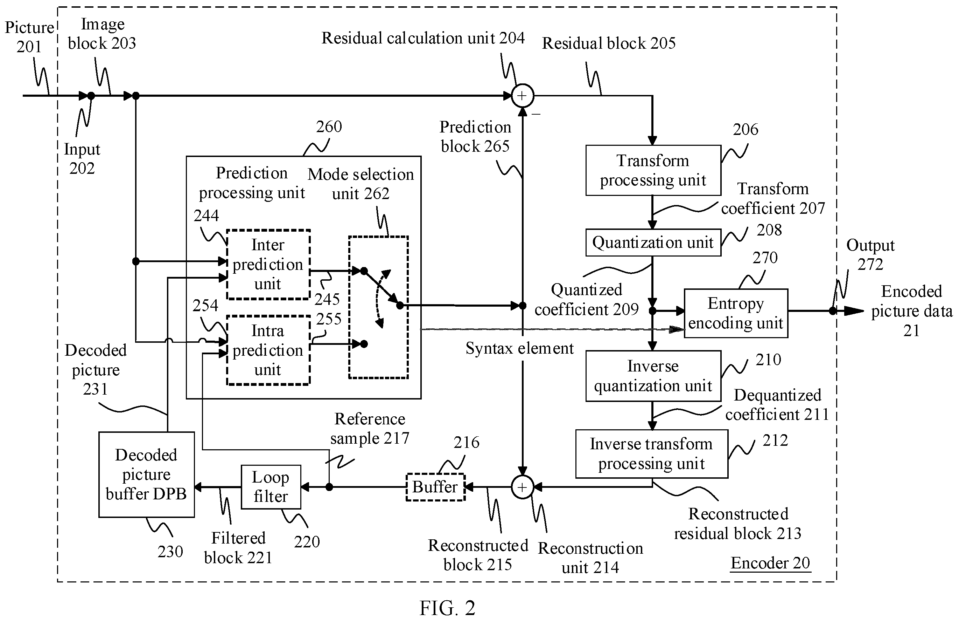

The encoder 20 (or referred to as an encoder 20) is configured to: receive the preprocessed picture data 19, and process the preprocessed picture data 19 in a related prediction mode, to provide encoded picture data 21 (the following further describes structural details of the encoder 20 based on FIG. 2, FIG. 4, or FIG. 5). In some embodiments, the encoder 20 may be configured to perform embodiments described below, to implement a video encoding method described in the present invention.

The communication interface 22 may be configured to: receive the encoded picture data 21, and transmit the encoded picture data 21 to the destination device 14 or any other device (for example, a storage) through the link 13 for storage or direct reconstruction. The any other device may be any device configured for decoding or storage. The communication interface 22 may be, for example, configured to encapsulate the encoded picture data 21 into an appropriate format, for example, a data packet, for transmission through the link 13.

The destination device 14 includes a decoder 30. Optionally, the destination device 14 may further include a communication interface 28, a picture post-processor 32, and a display device 34. The following describes the components separately.

The communication interface 28 may be configured to receive the encoded picture data 21 from the source device 12 or any other source. The any other source is, for example, a storage device. The storage device is, for example, an encoded picture data storage device. The communication interface 28 may be configured to transmit or receive the encoded picture data 21 through the link 13 between the source device 12 and the destination device 14 or through any type of network. The link 13 is, for example, a direct wired or wireless connection, and the any type of network is, for example, a wired or wireless network or any combination thereof, any type of private or public network, or any combination thereof. The communication interface 28 may be, for example, configured to decapsulate the data packet transmitted through the communication interface 22, to obtain the encoded picture data 21.

Both the communication interface 28 and the communication interface 22 may be configured as unidirectional communication interfaces or bidirectional communication interfaces, and may be configured to, for example, send and receive messages to establish a connection, and acknowledge and exchange any other information related to a communication link and/or data transmission such as encoded picture data transmission.

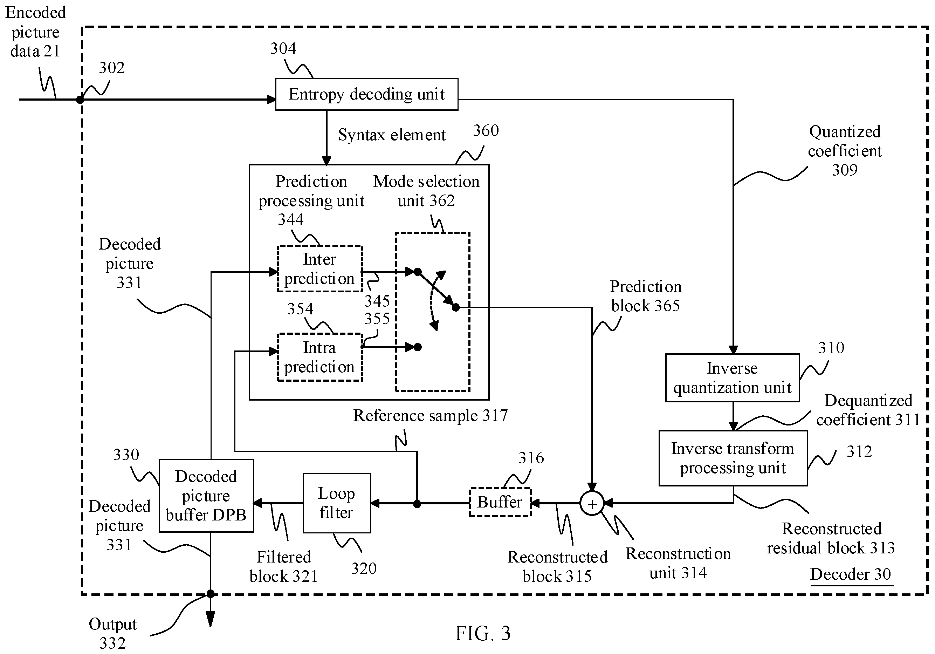

The decoder 30 (also referred to as a decoder 30) is configured to: receive the encoded picture data 21, and provide decoded picture data 31 or a decoded picture 31 (the following further describes structural details of the decoder 30 based on FIG. 3, FIG. 4, or FIG. 5). In some embodiments, the decoder 30 may be configured to perform embodiments described below, to implement a video decoding method described in the present invention.

The picture post-processor 32 is configured to post-process the decoded picture data 31 (also referred to as reconstructed picture data) to obtain post-processed picture data 33. Post-processing performed by the picture post-processor 32 may include color format transformation (for example, transformation from a YUV format to an RGB format), color correction, trimming, re-sampling, or any other processing, and may be further configured to transmit the post-processed picture data 33 to the display device 34.

The display device 34 is configured to receive the post-processed picture data 33 to display a picture, for example, to a user or a viewer. The display device 34 may be or include any type of display configured to present a reconstructed picture, for example, an integrated or external display or monitor. For example, the display may include a liquid crystal display (liquid crystal display, LCD), an organic light emitting diode (organic light emitting diode, OLED) display, a plasma display, a projector, a micro LED display, a liquid crystal on silicon (liquid crystal on silicon, LCoS), a digital light processor (digital light processor, DLP), or any other type of display.

Although the source device 12 and the destination device 14 are depicted as separate devices in FIG. 1A, a device embodiment may alternatively include both the source device 12 and the destination device 14 or functionalities of both the source device 12 and the destination device 14, that is, the source device 12 or a corresponding functionality of the source device 12 and the destination device 14 or a corresponding functionality of the destination device 14. In such an embodiment, the source device 12 or the corresponding functionality of the source device 12 and the destination device 14 or the corresponding functionality of the destination device 14 may be implemented by using same hardware and/or software, separate hardware and/or software, or any combination thereof.

A person skilled in the art clearly learns, based on the descriptions, that existence and (accurate) division of functionalities of different units or functionalities of the source device 12 and/or the destination device 14 shown in FIG. 1A may vary with an actual device and application. The source device 12 and the destination device 14 may include any one of various devices, including any type of handheld or stationary device, for example, a notebook or laptop computer, a mobile phone, a smartphone, a tablet or a tablet computer, a video camera, a desktop computer, a set-top box, a television, a camera, a vehicle-mounted device, a display device, a digital media player, a video game console, a video streaming transmission device (such as a content service server or a content distribution server), a broadcast receiver device, and a broadcast transmitter device, and may not use or may use any type of operating system.

Both the encoder 20 and the decoder 30 may be implemented as any one of various appropriate circuits, for example, one or more microprocessors, digital signal processors (digital signal processor, DSP), application-specific integrated circuits (application-specific integrated circuit, ASIC), field-programmable gate arrays (field-programmable gate array, FPGA), discrete logic, hardware, or any combination thereof. If the technologies are implemented partially by using software, a device may store software instructions in an appropriate non-transitory computer-readable storage medium, and may execute instructions by using hardware such as one or more processors, to perform the technologies of this disclosure. Any one of the foregoing content (including hardware, software, a combination of hardware and software, and the like) may be considered as one or more processors.

In some cases, the video encoding and decoding system 10 shown in FIG. 1A is merely an example, and the technologies of the present invention may be applied to a video coding setting (for example, video encoding or video decoding) that does not need to include any data communication between encoding and decoding devices. In another example, data may be retrieved from a local storage, streamed over a network, or the like. A video encoding device may encode data and store data into the storage, and/or a video decoding device may retrieve the data from the storage and decode the data. In some examples, encoding and decoding are performed by devices that do not communicate with each other but simply encode data to the storage and/or retrieve the data from the storage and decode the data.

It should be understood that the encoder 20 may be deployed on a terminal device or a cloud-side server, and the decoder 30 may be deployed on the terminal device or the cloud-side server; or the encoder 20 and the decoder 30 may be jointly deployed on the terminal device or the cloud-side server.

In a scenario, the encoder 20 and the decoder 30 may be deployed on a terminal device. The encoder 20 may encode and compress a video on the terminal device, perform secondary compression (or referred to as incremental storage compression) based on the video encoding method provided in embodiments of this application, and store compressed data. When the video needs to be played, the stored compressed data may be decoded.

In a scenario, the encoder 20 and the decoder 30 may be deployed on a plurality of terminal devices. The encoder 20 may encode and compress a video on a terminal device, perform secondary compression (or referred to as incremental storage compression) based on the video encoding method provided in embodiments of this application, and transmit compressed data to another terminal device. When the another device needs to play the video, the another device may decode the stored compressed data.

In a scenario, the encoder 20 and the decoder 30 may be deployed on a terminal device and a cloud-side server. The encoder 20 may encode and compress a video on the terminal device, perform secondary compression (or referred to as incremental storage compression) based on the video encoding method provided in embodiments of this application, and transmit the compressed data to the server.

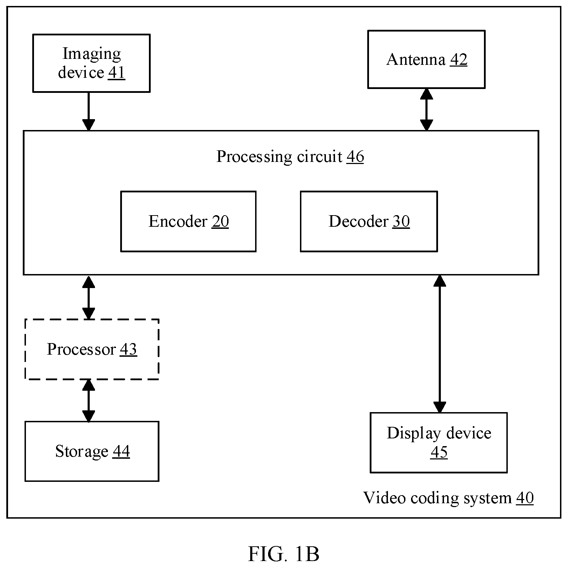

FIG. 1B is an illustrative diagram of an example of a video coding system 40 including the encoder 20 in FIG. 2 and/or the decoder 30 in FIG. 3 according to an example embodiment. The video coding system 40 can implement combinations of various techniques in embodiments of the present invention. In the illustrated implementation, the video coding system 40 may include an imaging device 41, an encoder 20, a decoder 30 (and/or a video encoder/decoder implemented by using a logic circuit of a processing unit 46), an antenna 42, one or more processors 43, one or more storages 44, and/or a display device 45.

As shown in FIG. 1B, the imaging device 41, the antenna 42, the processing unit 46, the logic circuit, the encoder 20, the decoder 30, the processors 43, the storages 44, and/or the display device 45 can communicate with each other. As described, although the video coding system 40 is illustrated with the encoder 20 and the decoder 30, the video coding system 40 may include only the encoder 20 or only the decoder 30 in different examples.

In some examples, the antenna 42 may be configured to transmit or receive encoded data of video data. Further, in some examples, the display device 45 may be configured to present the video data. In some examples, the logic circuit may be implemented by using the processing unit 46. The processing unit 46 may include application-specific integrated circuit (application-specific integrated circuit, ASIC) logic, a graphics processing unit, a general-purpose processor, and the like. The video coding system 40 may also include the optional processor 43. Similarly, the optional processor 43 may include application-specific integrated circuit (application-specific integrated circuit, ASIC) logic, a graphics processing unit, a general-purpose processor, and the like. In some examples, the logic circuit may be implemented by hardware, for example, video coding dedicated hardware, and the processor 43 may be implemented by general-purpose software, an operating system, or the like. In addition, the storage 44 may be any type of storage, for example, a volatile memory (for example, a static random access memory (Static Random Access Memory, SRAM), a dynamic random access memory (Dynamic Random Access Memory, DRAM)), or a non-volatile memory (for example, a flash memory). In a non-limitative example, the storage 44 may be implemented by using a cache memory. In some examples, the logic circuit may access the storage 44 (for example, for implementing an image buffer). In other examples, the logic circuit and/or the processing unit 46 may include a storage (for example, a cache) for implementing an image buffer or the like.

In some examples, the encoder 20 implemented by using the logic circuit may include an image buffer (which is implemented by using, for example, the processing unit 46 or the storage 44) and a graphics processing unit (which is implemented by using, for example, the processing unit 46). The graphics processing unit may be communicatively coupled to the image buffer. The graphics processing unit may include the encoder 20 implemented by using the logic circuit, to implement various modules that are described with reference to FIG. 2 and/or any other encoder system or subsystem described in this specification. The logic circuit may be configured to perform various operations described in this specification.

In some examples, the decoder 30 may be implemented by using the logic circuit in a similar manner, to implement various modules that are described with reference to the decoder 30 in FIG. 3 and/or any other decoder system or subsystem described in this specification. In some examples, the decoder 30 implemented by using the logic circuit may include an image buffer (implemented by using the processing unit 2820 or the storage 44) and a graphics processing unit (which is implemented by using, for example, the processing unit 46). The graphics processing unit may be communicatively coupled to the image buffer. The graphics processing unit may include the decoder 30 implemented by using the logic circuit, to implement various modules that are described with reference to FIG. 3 and/or any other decoder system or subsystem described in this specification.

In some examples, the antenna 42 may be configured to receive the encoded data of the video data. As described, the encoded data may include data, an indicator, an index value, mode selection data, and the like that are related to an encoded video frame and that are described in this specification, for example, data related to encoding partitioning (for example, a transform coefficient or a quantized transform coefficient, an optional indicator (as discussed), and/or data defining encoding partitioning). The video coding system 40 may further include the decoder 30 that is coupled to the antenna 42 and that is configured to decode the encoded data. The display device 45 is configured to display a video frame.

It should be understood that in embodiments of the present invention, for the example described with reference to the encoder 20, the decoder 30 may be configured to perform a reverse process. With regard to a signaling syntax element, the decoder 30 may be configured to: receive and parse such syntax element, and correspondingly decode related video data. In some examples, the encoder 20 may entropy encode a syntax element into encoded video data. In such examples, the decoder 30 may parse such the syntax element, and correspondingly decode related video data.

FIG. 2 is a schematic/conceptual block diagram of an example of an encoder 20 configured to implement embodiments of the present invention. In the example of FIG. 2, the encoder 20 includes a residual calculation unit 204, a transform processing unit 206, a quantization unit 208, an inverse quantization unit 210, an inverse transform processing unit 212, a reconstruction unit 214, a buffer 216, a loop filter unit 220, a decoded picture buffer (decoded picture buffer, DPB) 230, a prediction processing unit 260, and an entropy encoding unit 270. The prediction processing unit 260 may include an inter prediction unit 244, an intra prediction unit 254, and a mode selection unit 262. The inter prediction unit 244 may include a motion estimation unit and a motion compensation unit (not shown in the figure). The encoder 20 shown in FIG. 2 may also be referred to as a hybrid video encoder or a video encoder based on a hybrid video coder.

For example, the residual calculation unit 204, the transform processing unit 206, the quantization unit 208, the prediction processing unit 260, and the entropy encoding unit 270 form a forward signal path of the encoder 20; and the inverse quantization unit 210, the inverse transform processing unit 212, the reconstruction unit 214, the buffer 216, the loop filter 220, the decoded picture buffer (decoded picture buffer, DPB) 230, and the prediction processing unit 260 form a backward signal path of the encoder. The backward signal path of the encoder corresponds to a signal path of a decoder (refer to a decoder 30 in FIG. 3).

The encoder 20 receives, for example, via an input 202, a picture 201 or an image block 203 of the picture 201, for example, a picture in a sequence of pictures forming a video or a video sequence. The image block 203 may also be referred to as a current encoded block or a to-be-processed image block, and the picture 201 may be referred to as a current picture or a to-be-encoded picture (especially when the current picture is distinguished from another picture in video encoding, for example, the another picture is a previously encoded and/or decoded picture in a same video sequence, that is, a video sequence that also includes the current picture).

In an embodiment, the encoder 20 may include a partitioning unit (not depicted in FIG. 2), configured to partition the picture 201 into a plurality of blocks such as the image block 203. The picture 201 is usually partitioned into a plurality of non-overlapping blocks. The partitioning unit may be configured to use a same block size for all pictures in a video sequence and a corresponding grid defining the block size, or change a block size between pictures, subsets, or picture groups and partition each picture into corresponding blocks.

In one example, the prediction processing unit 260 of the encoder 20 may be configured to perform any combination of the partitioning technologies described above.

For example, similar to the picture 201, the image block 203 is also or may be considered as a two-dimensional array or matrix of sampling points with sampling values, although a size of the image block 203 is smaller than that of the picture 201. In other words, the image block 203 may include, for example, one sampling array (for example, a luminance array in a case of a monochrome picture 201), three sampling arrays (for example, one luminance array and two chrominance arrays in a case of a color picture), or any other quantity and/or type of arrays depending on an applied color format. A quantity of sampling points in horizontal and vertical directions (or axes) of the image block 203 is used to define a size of the image block 203.

The encoder 20 shown in FIG. 2 is configured to encode the picture 201 block by block, for example, perform encoding and prediction on each image block 203.

The residual calculation unit 204 is configured to calculate a residual block 205 based on the picture image blocks 203 and a prediction block 265 (further details about the prediction block 265 are provided below), for example, obtain the residual block 205 in a sample domain by subtracting a sample value of the prediction block 265 from sample values of the picture image blocks 203 sample by sample (pixel by pixel).

The transform processing unit 206 is configured to apply a transform, for example, a discrete cosine transform (discrete cosine transform, DCT) or a discrete sine transform (discrete sine transform, DST), on a sample value of the residual block 205, to obtain a transform coefficient 207 in a transform domain. The transform coefficient 207 may also be referred to as a transform residual coefficient, and represent the residual block 205 in the transform domain.

The transform processing unit 206 may be configured to apply an integer approximation of the DCT/DST, such as a transform specified in HEVC/H.265. Compared with an orthogonal DCT transform, such integer approximation is usually scaled by a factor. To preserve a norm of the residual block processed by forward and inverse transforms, applying an additional scale factor is a part of a transform process. The scale factor is usually selected based on some constraints. For example, the scale factor is a power of 2 for a shift operation, a bit depth of the transform coefficient, or a tradeoff between accuracy and implementation costs. For example, a specific scale factor is specified for an inverse transform, for example, specified by the inverse transform processing unit 212 on a decoder 30 side (and a specific scale factor is specified for a corresponding inverse transform, for example, specified by the inverse transform processing unit 212 on an encoder 20 side), and a corresponding scale factor for a forward transform may be specified accordingly, for example, specified by the transform processing unit 206 on the encoder 20 side.

The quantization unit 208 is configured to quantize the transform coefficient 207, for example, through scalar quantization or vector quantization, to obtain a quantized transform coefficient 209. The quantized transform coefficient 209 may also be referred to as a quantized residual coefficient 209. A quantization process may reduce a bit depth related to a part of the transform coefficient 207 or the entire transform coefficient 207. For example, an n-bit transform coefficient may be rounded down to an m-bit transform coefficient during quantization, where n is greater than m. A quantization degree may be modified by adjusting a quantization parameter (quantization parameter, QP). For example, for scalar quantization, different scales may be applied to achieve finer or coarser quantization. A smaller quantization step size corresponds to finer quantization, and a larger quantization step size corresponds to coarser quantization. An appropriate quantization step size may be indicated by the quantization parameter (quantization parameter, QP). For example, the quantization parameter may be an index to a predefined set of appropriate quantization step sizes. For example, a smaller quantization parameter may correspond to finer quantization (a smaller quantization step size), and a larger quantization parameter may correspond to coarser quantization (a larger quantization step size), or vice versa. Quantization may include division by a quantization step size and corresponding quantization or inverse quantization, for example, performed by using the inverse quantization 210, or may include multiplication by a quantization step size. Embodiments according to some standards such as HEVC may use the quantization parameter to determine a quantization step size. Generally, the quantization step size may be calculated based on the quantization parameter by using fixed point approximation of an equation that includes division. An additional scale factor may be introduced for quantization and dequantization, to restore the norm of the residual block, where the norm of the residual block may be modified due to a scale used in the fixed point approximation of the equation used for the quantization step size and the quantization parameter. In an example implementation, a scale of the inverse transform may be combined with a scale of dequantization. Alternatively, a customized quantization table may be used and transmitted, for example, included in encoded data, from an encoder to a decoder through a signal. Quantization is a lossy operation, and a larger quantization step size indicates a larger loss.

The inverse quantization unit 210 is configured to apply inverse quantization of the quantization unit 208 to a quantized coefficient to obtain a dequantized coefficient 211, for example, apply, based on or by using a same quantization step size as that used by the quantization unit 208, an inverse quantization scheme of a quantization scheme applied by the quantization unit 208. The dequantized coefficient 211 may also be referred to as a dequantized residual coefficient 211, and correspond to the transform coefficient 207. However, due to a loss caused by quantization, a dequantized coefficient is usually different from a transform coefficient.

The inverse transform processing unit 212 is configured to apply an inverse transform of a transform applied by the transform processing unit 206, for example, an inverse discrete cosine transform (discrete cosine transform, DCT) or an inverse discrete sine transform (discrete sine transform, DST), to obtain an inverse transform block 213 in a sample domain. The inverse transform block 213 may also be referred to as an inverse transform dequantized block 213 or an inverse transform residual block 213.

The reconstruction unit 214 (for example, a summator 214) is configured to add the inverse transform block 213 (that is, a reconstructed residual block 213) to the prediction block 265 to obtain a reconstructed block 215 in the sample domain. For example, a sample value of the reconstructed residual block 213 is added to the sample value of the prediction block 265.

Optionally, a buffer unit 216 (referred to as a "buffer" 216 for short) of a line buffer 216 is configured to buffer or store the reconstructed block 215 and the corresponding sample value, for example, for intra prediction. In other embodiments, the encoder may be configured to use an unfiltered reconstructed block and/or a corresponding sample value stored in the buffer unit 216 for any type of estimation and/or prediction, for example, for intra prediction.

For example, in an embodiment, the encoder 20 may be configured, so that the buffer unit 216 is not only configured to store the reconstructed block 215 for intra prediction 254, but also configured for a loop filter unit 220 (not shown in FIG. 2), and/or so that, for example, the buffer unit 216 and a decoded picture buffer unit 230 form one buffer. In another embodiment, the encoder 20 may be configured use a filtered block 221 and/or a block or sample from the decoded picture buffer 230 (the block or sample is not shown in FIG. 2) as inputs or bases for intra prediction 254.

The loop filter unit 220 (or referred to as a "loop filter" 220 for short) is configured to filter the reconstructed block 215 to obtain a filtered block 221, to smooth pixel transitions or improve video quality. The loop filter unit 220 is intended to represent one or more loop filters, such as a deblocking filter, a sample-adaptive offset (sample-adaptive offset, SAO) filter, or another filter, such as a bilateral filter, an adaptive loop filter (adaptive loop filter, ALF), a sharpening or smoothing filter, or a collaborative filter. Although the loop filter unit 220 is shown in FIG. 2 as an in-loop filter, the loop filter unit 220 may be implemented as a post-loop filter in other configurations. The filtered block 221 may also be referred to as a filtered reconstructed block 221. The decoded picture buffer 230 may store a reconstructed encoded block after the loop filter unit 220 performs a filtering operation on the reconstructed encoded block.

In an embodiment, the encoder 20 (correspondingly, the loop filter unit 220) may be configured to output a loop filter parameter (for example, sample adaptive offset information). For example, the loop filter parameter may be directly output, or may be entropy encoded by the entropy encoding unit 270 or any other entropy encoding unit for outputting, so that, for example, the decoder 30 may receive and apply the same loop filter parameter for decoding.

The entropy encoding unit 270 is configured to perform entropy encoding based on an output (for example, the quantized transform coefficient) from the quantization unit 208 and side information. The entropy encoding unit 270 may be configured to determine parameters such as a transform coefficient representing quantization, the side information, and the like. The entropy encoding unit 270 may be configured to: predict a value of a parameter based on context information, and then encode a difference between an actual value and a predicted value. For a target symbol representing a to-be-encoded value, the entropy encoding unit 270 may be configured to perform entropy encoding in various manners. Typical entropy coding technologies include Exponential-Golomb (Exponential-Golomb) coding, Golomb-Rice (Golomb-Rice) coding, context-adaptive binary arithmetic coding ("CABAC"), differential coding, Huffman coding, run length coding, Lempel-Ziv ("LZ") coding, dictionary coding, RANS coding, ANS coding, TANS coding, or other variants of ANS coding, and combinations thereof. In embodiments of this application, the entropy encoding unit 270 may perform one or more variants of ANS coding.

The decoded picture buffer (decoded picture buffer, DPB) 230 may be a reference picture storage that stores reference picture data for use in video data encoding by the encoder 20. The DPB 230 may be formed by any one of a plurality of storage devices, for example, a dynamic random access memory (dynamic random access memory, DRAM) (including a synchronous DRAM (synchronous DRAM, SDRAM), a magnetoresistive RAM (magnetoresistive RAM, MRAM), and a resistive RAM (resistive RAM, RRAM)), or another type of storage device. The DPB 230 and the buffer 216 may be provided by a same storage device or separate storage devices. In an example, the decoded picture buffer (decoded picture buffer, DPB) 230 is configured to store the filtered block 221. The decoded picture buffer 230 may be further configured to store other previously filtered blocks, for example, previously reconstructed and filtered blocks 221, of the same current picture or of different pictures, for example, previously reconstructed pictures, and may provide complete previously reconstructed, namely, decoded, pictures (and corresponding reference blocks and samples) and/or a partially reconstructed current picture (and corresponding reference blocks and samples), for example, for inter prediction. In an example, if the reconstructed block 215 is reconstructed without in-loop filtering, the decoded picture buffer (decoded picture buffer, DPB) 230 is configured to store the reconstructed block 215.

The prediction processing unit 260, also referred to as a block prediction processing unit 260, is configured to: receive or obtain the image block 203 (a current image block 203 of a current picture 201) and reconstructed picture data, for example, reference samples of a same (current) picture from the buffer 216 and/or reference picture data 231 of one or more previously decoded pictures from the decoded picture buffer 230, and process such data for prediction, that is, to provide the prediction block 265 that may be an inter prediction block 245 or an intra prediction block 255.

The mode selection unit 262 may be configured to select a prediction mode (for example, an intra or inter prediction mode) and/or a corresponding prediction block 245 or 255 used as the prediction block 265, for calculation of the residual block 205 and reconstruction of the reconstructed block 215.

In an embodiment, the mode selection unit 262 may be configured to select a prediction mode (for example, select from prediction modes supported by the prediction processing unit 260), where the prediction mode provides an optimal match or a minimum residual (the minimum residual means better compression in transmission or storage), or provides minimum signaling overheads (the minimum signaling overheads mean better compression in transmission or storage), or considers or balances both. The mode selection unit 262 may be configured to determine a prediction mode based on rate distortion optimization (rate distortion optimization, RDO), that is, select a prediction mode that provides minimum rate distortion optimization or select a prediction mode whose related rate distortion satisfies at least a prediction mode selection criterion.

The following describes in detail prediction processing performed by an example of the encoder 20 (for example, by the prediction processing unit 260) and mode selection performed by an example of the encoder 20 (for example, by the mode selection unit 262).

As described above, the encoder 20 is configured to determine or select the best or optimal prediction mode from a set of (pre-determined) prediction modes. The set of prediction modes may include, for example, an intra prediction mode and/or an inter prediction mode.

In a possible implementation, a set of intra prediction modes may include a plurality of different intra prediction modes, for example, non-directional modes such as a DC (or mean value) mode and a planar mode, or directional modes as defined in H.265, or may include 67 different intra prediction modes, for example, non-directional modes such as a DC (or mean value) mode and a planar mode, or directional modes as defined in developing H.266.

In a possible implementation, a set of inter prediction modes depends on an available reference picture (that is, at least some of decoded pictures stored in the DBP 230) and other inter prediction parameters, for example, depends on whether the entire reference picture is used or only a part of the reference picture is used, for example, a search window area around an area of a current block is searched for an optimal matching reference block, and/or for example, depends on whether pixel interpolation such as half-pixel and/or quarter-pixel interpolation is applied. The set of inter prediction modes may include, an advanced motion vector prediction (Advanced Motion Vector Prediction, AMVP) mode and a merge (merge) mode. During specific implementation, the set of inter prediction modes may include an affine motion model-based prediction mode described in embodiments of the present invention, for example, an affine motion model-based advanced motion vector prediction mode (Affine AMVP mode) or an affine motion model-based merge mode (Affine Merge mode). Specific examples are a control point-based AMVP mode (an inherited control point motion vector prediction method or a constructed control point motion vector prediction method), and a control point-based merge mode (an inherited control point motion vector prediction method or a constructed control point motion vector prediction method). The set of inter prediction modes may further include an advanced temporal motion vector prediction (advanced temporal motion vector prediction, ATMVP) method, a PLANAER method, or the like, or may include a sub-block-based merge mode (Sub-block based merging mode) formed by combining the affine motion model-based merge mode, the ATMVP method, and/or the PLANAR method, or the like. In this embodiment of the present invention, inter prediction for the to-be-processed image block may be applied to unidirectional prediction (forward or backward), bidirectional prediction (forward and backward), or multiframe prediction. When inter prediction for the to-be-processed image block is applied to bidirectional prediction, generalized bi-prediction (Generalized Bi-prediction, GBi) of block-level bidirectional prediction, also referred to as a weighted prediction method, may be used. In an example, the intra prediction unit 254 may be configured to execute any combination of inter prediction technologies described below.

In addition to the foregoing prediction modes, a skip mode and/or a direct mode may be also applied in this embodiment of the present invention.

The prediction processing unit 260 may be further configured to: partition the image block 203 into smaller block partitions or sub-blocks, for example, by iteratively using quad-tree (quad-tree, QT) partitioning, binary-tree (binary-tree, BT) partitioning, ternary-tree (triple-tree, TT) partitioning, or any combination thereof, and perform prediction, for example, for each of the block partitions or sub-blocks. Mode selection includes selection of a tree structure of the partitioned image block 203 and selection of a prediction mode used for each of the block partitions or sub-blocks.

The inter prediction unit 244 may include a motion estimation (motion estimation, ME) unit (not shown in FIG. 2) and a motion compensation (motion compensation, MC) unit (not shown in FIG. 2). The motion estimation unit is configured to: receive or obtain the picture image block 203 (the current picture image block 203 of the current picture 201) and a decoded picture 231, or at least one or more previously reconstructed blocks, such as reconstructed blocks of one or more other/different previously decoded pictures 231; and perform motion estimation based on a determined inter prediction mode. For example, a video sequence may include the current picture and the previously decoded picture 31, or in other words, the current picture and the previously decoded picture 31 may be a part of or form a sequence of pictures forming the video sequence.

For example, the encoder 20 may be configured to: select a reference block from a plurality of reference blocks of a same picture or different pictures of a plurality of other pictures (reference images), and provide the motion estimation unit (not shown in FIG. 2) with a reference picture and/or an offset (spatial offset) between a position (X, Y coordinates) of the reference block and a position of a current block as an inter prediction parameter. The offset is also referred to as a motion vector (motion vector, MV).

The motion compensation unit is configured to: obtain the inter prediction parameter, and perform inter prediction based on or by using the inter prediction parameter, to obtain the inter prediction block 245. Motion compensation performed by the motion compensation unit (not shown in FIG. 2) may include taking out or generating a prediction block (predictor) based on a motion/block vector determined by using motion estimation (possibly by performing interpolation of sub-pixel accuracy). An additional pixel sample may be generated from a known pixel sample by using interpolation filtering. This potentially increases a quantity of candidate prediction blocks that may be used to encode a picture block. Upon receiving a motion vector for a PU of the current picture block, the motion compensation unit 246 may locate a prediction block to which the motion vector points in a reference picture list. The motion compensation unit 246 may further generate a syntax element associated with a block and a video slice for use by the decoder 30 in decoding picture blocks of the video slice.

Specifically, the inter prediction unit 244 may transmit a syntax element to the entropy encoding unit 270, where the syntax element, for example, includes an inter prediction parameter (for example, indication information of an inter prediction mode that is used for prediction of the current block and that is selected after a plurality of inter prediction modes are traversed), and an index number of a candidate motion vector list, and optionally, further includes a GBi index number, a reference frame index, and the like. In a possible application scenario, if there is only one inter prediction mode, the inter prediction parameter may not be carried in the syntax element. In this case, the decoder 30 side may directly perform decoding in a default prediction mode. It can be understood that the inter prediction unit 244 may be configured to perform any combination of inter prediction technologies.

The intra prediction unit 254 is configured to obtain, for example, receive, the picture block 203 (the current picture block) and one or more previously reconstructed blocks, for example, reconstructed neighboring blocks, of the same picture for intra estimation. For example, the encoder 20 may be configured to select an intra prediction mode from a plurality of (pre-determined) intra prediction modes.

In an embodiment, the encoder 20 may be configured to select an intra prediction mode according to an optimization criterion, for example, based on a minimum residual (for example, an intra prediction mode providing the prediction block 255 that is most similar to the current picture block 203) or minimum rate distortion.

The intra prediction unit 254 is further configured to determine the intra prediction block 255 based on, for example, an intra prediction parameter of the selected intra prediction mode. In any case, after selecting an intra prediction mode for a block, the intra prediction unit 254 is further configured to provide the intra prediction parameter, that is, information indicating the selected intra prediction mode for the block, to the entropy encoding unit 270. In an example, the intra prediction unit 254 may be configured to perform any combination of intra prediction technologies.

Specifically, the intra prediction unit 254 may transmit a syntax element to the entropy encoding unit 270, where the syntax element includes an intra prediction parameter (for example, indication information of an intra prediction mode used for prediction of a current block after a plurality of intra prediction modes are traversed). In a possible application scenario, if there is only one intra prediction mode, the intra prediction parameter may not be carried in the syntax element. In this case, the decoder 30 side may directly perform decoding in a default prediction mode.

The entropy encoding unit 270 is configured to apply an entropy coding algorithm or scheme (for example, a variable length coding (variable length coding, VLC) scheme, a context adaptive VLC (context adaptive VLC, CAVLC) scheme, an arithmetic coding scheme, a context adaptive binary arithmetic coding (context adaptive binary arithmetic coding, CABAC), a syntax-based context-adaptive binary arithmetic coding (syntax-based context-adaptive binary arithmetic coding, SBAC), a probability interval partitioning entropy (probability interval partitioning entropy, PIPE) coding, or other entropy encoding and decoding methods or technologies) to one or all of the quantized residual coefficient 209, the inter prediction parameter, the intra prediction parameter, and/or the loop filter parameter (or not applied), to obtain the encoded picture data 21 that may be output by an output 272 in a form of, for example, the encoded data 21. The encoded data may be transmitted to the decoder 30 or archived for later transmission or retrieval by the decoder 30. The entropy encoding unit 270 may be further configured to entropy encode another syntax element of a current video slice that is being encoded.

Other structural variations of the encoder 20 may be used to encode a video stream. For example, a non-transform-based encoder 20 may directly quantize a residual signal without the transform processing unit 206 for some blocks or frames. In another implementation, the encoder 20 may have the quantization unit 208 and the inverse quantization unit 210 that are combined into a single unit.

It should be understood that other structural variations of the encoder 20 may be used to encode a video stream. For example, for some image blocks or image frames, the encoder 20 may directly quantize a residual signal without processing by the transform processing unit 206, and correspondingly without processing by the inverse transform processing unit 212. Alternatively, for some image blocks or image frames, the encoder 20 does not generate residual data, and correspondingly does not need processing by the transform processing unit 206, the quantization unit 208, the inverse quantization unit 210, and the inverse transform processing unit 212. Alternatively, the encoder 20 may store a reconstructed image block directly as a reference block without processing by the filter 220. Alternatively, the quantization unit 208 and the inverse quantization unit 210 in the encoder 20 may be combined together. The loop filter 220 is optional, and in lossless compression encoding, the transform processing unit 206, the quantization unit 208, the inverse quantization unit 210, and the inverse transform processing unit 212 are optional. It should be understood that in different application scenarios, the inter prediction unit 244 and the intra prediction unit 254 may be used selectively.

FIG. 3 is a schematic/conceptual block diagram of an example of a decoder 30 configured to implement embodiments of the present invention. The decoder 30 is configured to receive the encoded picture data (for example, encoded data) 21 encoded by the encoder 20, to obtain the decoded picture 231. In a decoding process, the decoder 30 receives, from the encoder 20, video data, for example, encoded video data representing a picture block of an encoded video slice and an associated syntax element.

In the example of FIG. 3, the decoder 30 includes an entropy decoding unit 304, an inverse quantization unit 310, an inverse transform processing unit 312, a reconstruction unit 314 (for example, a summator 314), a buffer 316, a loop filter 320, a decoded picture buffer 330, and a prediction processing unit 360. The prediction processing unit 360 may include an inter prediction unit 344, an intra prediction unit 354, and a mode selection unit 362. In some examples, the decoder 30 may perform a decoding pass substantially inverse to an encoding pass performed by the encoder 20 described above with reference to FIG. 2.

The entropy decoding unit 304 is configured to entropy decode the encoded picture data 21 to obtain, for example, a quantized coefficient 309 and/or a decoded encoding parameter (not shown in FIG. 3), for example, any one or all of an inter prediction parameter, an intra prediction parameter, a loop filter parameter, and/or the another syntax element (that are decoded). The entropy decoding unit 304 is further configured to forward the inter prediction parameter, the intra prediction parameter, and/or the another syntax element to the prediction processing unit 360. The decoder 30 may receive a syntax element at a video slice level and/or a video block level.

The entropy decoding unit 304 is configured to entropy decode the encoded data to generate output symbols for the parameters. The entropy decoding unit 304 may be configured to reconstruct parameters representing a quantized transform coefficient and side information. The entropy decoding unit 304 may be configured to perform entropy decoding in various manners. Typical entropy decoding technologies include exponential Columbus decoding, Columbus Rice decoding, context adaptive binary arithmetic decoding, Huffman decoding, run-length decoding, Lempel-Ziv ("LZ") decoding, dictionary decoding, RANS decoding and ANS decoding, TANS decoding, or other variants of ANS decoding, and a combination thereof. In embodiments of this application, the entropy decoding unit 304 may perform one or more variants of ANS decoding.

The inverse quantization unit 310 may have a same function as the inverse quantization unit 110, the inverse transform processing unit 312 may have a same function as the inverse transform processing unit 212, the reconstruction unit 314 may have a same function as the reconstruction unit 214, the buffer 316 may have a same function as the buffer 216, the loop filter 320 may have a same function as the loop filter 220, and the decoded picture buffer 330 may have a same function as the decoded picture buffer 230.

The prediction processing unit 360 may include an inter prediction unit 344 and an intra prediction unit 354. The inter prediction unit 344 may have a similar function as the inter prediction unit 244, and the intra prediction unit 354 may have a similar function as the intra prediction unit 254. The prediction processing unit 360 is usually configured to: perform block prediction and/or obtain a prediction block 365 from the encoded data 21, and (explicitly or implicitly) receive or obtain a prediction-related parameter and/or information about a selected prediction mode, from, for example, the entropy decoding unit 304.

When a video slice is encoded into an intra encoded (I) slice, the intra prediction unit 354 in the prediction processing unit 360 is configured to generate a prediction block 365 for a picture block of a current video slice based on an intra prediction mode represented based on a signal and data from a previously decoded block of a current frame or picture. When a video frame is encoded into an inter encoded (that is, B or P) slice, the inter prediction unit 344 (for example, a motion compensation unit) in the prediction processing unit 360 is configured to generate a prediction block 365 for a video block of a current video slice based on a motion vector and another syntax element received from the entropy decoding unit 304. For inter prediction, the prediction block may be generated from one reference picture in a reference picture list. The decoder 30 may construct reference frame lists: a list 0 and a list 1 by using a default construction technology based on a reference picture stored in the DPB 330.

The prediction processing unit 360 is configured to: determine prediction information for a video block of the current video slice by parsing the motion vector and the another syntax element, and use the prediction information to generate the prediction block for the current video block that is being decoded. In an example of the present invention, the prediction processing unit 360 uses some received syntax elements to determine a prediction (for example, intra or inter prediction) mode used for encoding a video block of a video slice, an inter prediction slice type (for example, a B slice, a P slice, or a GPB slice), construction information for one or more reference picture lists for the slice, a motion vector for each inter encoded video block of the slice, an inter prediction status for each inter encoded video block of the slice, and other information, to decode video blocks of the current video slice. In another example of this disclosure, a syntax element received by the decoder 30 from the encoded data includes a syntax element in one or more of an adaptive parameter set (adaptive parameter set, APS), a sequence parameter set (sequence parameter set, SPS), a picture parameter set (picture parameter set, PPS), or a slice header.

The inverse quantization unit 310 may be configured to inversely quantize (namely, dequantize) a quantized transform coefficient that is provided in the encoded data and that is decoded by the entropy decoding unit 304. An inverse quantization process may include using a quantization parameter calculated by the encoder 20 for each video block in a video slice, to determine a degree of quantization to be applied and also determine a degree of inverse quantization to be applied.

The inverse transform processing unit 312 is configured to apply an inverse transform (for example, an inverse DCT, an inverse integer transform, or a conceptually similar inverse transform process) to the transform coefficient to generate a residual block in a pixel domain.

The reconstruction unit 314 (for example, the summator 314) is configured to add an inverse transform block 313 (that is, a reconstructed residual block 313) to the prediction block 365 to obtain a reconstructed block 315 in a sample domain, for example, by adding a sample value of the reconstructed residual block 313 to a sample value of the prediction block 365.

The loop filter unit 320 (during an encoding loop or after an encoding loop) is configured to filter the reconstructed block 315 to obtain a filtered block 321, to smooth pixel transitions or improve video quality. In an example, the loop filter unit 320 may be configured to perform any combination of filtering technologies described below. The loop filter unit 320 is intended to represent one or more loop filters, such as a deblocking filter, a sample-adaptive offset (sample-adaptive offset, SAO) filter, or another filter, such as a bilateral filter, an adaptive loop filter (adaptive loop filter, ALF), a sharpening or smoothing filter, or a collaborative filter. Although the loop filter unit 320 is shown in FIG. 3 as an in-loop filter, the loop filter unit 320 may be implemented as a post-loop filter in other configurations.

The decoded video block 321 in a given frame or picture is then stored in the decoded picture buffer 330 that stores a reference picture used for subsequent motion compensation.

The decoder 30 is configured to, for example, output the decoded picture 31 via an output 332, for presentation to a user or viewing by a user.

Other variations of the decoder 30 may be used to decode compressed encoded data. For example, the decoder 30 may generate an output video stream without the loop filter unit 320. For example, a non-transform-based decoder 30 may inversely quantize a residual signal directly without the inverse transform processing unit 312 for some blocks or frames. In another implementation, the decoder 30 may have the inverse quantization unit 310 and the inverse transform processing unit 312 that are combined into a single unit.

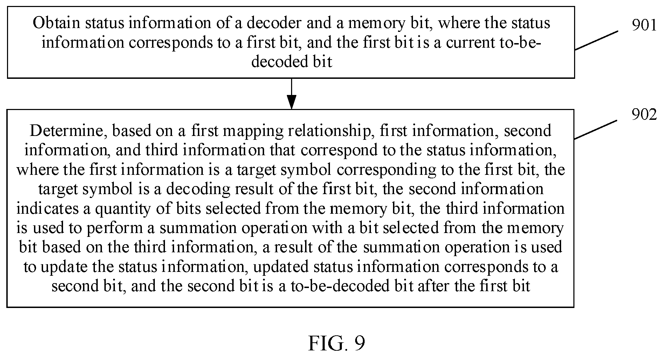

In a specific embodiment, the decoder 30 may be configured to implement a data decoding method described in the following embodiment corresponding to FIG. 9.

It should be understood that, in the encoder 20 and the decoder 30 in the present invention, a processing result of a specific phase may be further processed and then output to a next phase. For example, after interpolation filtering, motion vector derivation, or loop filtering, further operations such as clip or shift shift may be performed on a processing result of a corresponding phase.

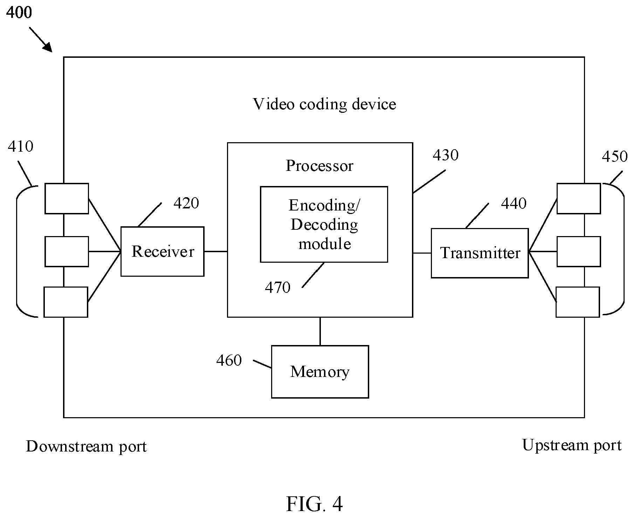

FIG. 4 is a diagram of a structure of a video coding device 400 (for example, a video encoding device 400 or a video decoding device 400) according to an embodiment of the present invention. The video coding device 400 is suitable for implementing embodiments described in this specification. In an embodiment, the video coding device 400 may be a video decoder (for example, the decoder 30 in FIG. 1A) or a video encoder (for example, the encoder 20 in FIG. 1A). In another embodiment, the video coding device 400 may be one or more components in the decoder 30 in FIG. 1A or the encoder 20 in FIG. 1A.

The video coding device 400 includes ingress ports 410 and a receiver (Rx) 420 that are configured to receive data, a processor, a logic unit, or a central processing unit (CPU) 430 that is configured to process the data, a transmitter (Tx) 440 and egress ports 450 that are configured to transmit the data, and a storage 460 configured to store the data. The video coding device 400 may also include an optical-to-electrical conversion component and an electrical-to-optical (EO) component that are coupled to the ingress ports 410, the receiver 420, the transmitter 440, and the egress ports 450, for egress or ingress of optical or electrical signals.

The processor 430 is implemented by hardware and software. The processor 430 may be implemented as one or more CPU chips, cores (for example, a multi-core processor), FPGAs, ASICs, and DSPs. The processor 430 communicates with the ingress ports 410, the receiver 420, the transmitter 440, the egress ports 450, and the storage 460. The processor 430 includes a coding module 470 (for example, an encoding module 470 or a decoding module 470). The encoding/decoding module 470 implements embodiments disclosed in this specification, to implement a chroma block prediction method provided in embodiments of the present invention. For example, the encoding/decoding module 470 implements, processes, or provides various coding operations. Therefore, the encoding/decoding module 470 provides substantial improvements to functions of the video coding device 400, and affects transition of the video coding device 400 to different states. Alternatively, the encoding/decoding module 470 is implemented by using instructions that are stored in the storage 460 and executed by the processor 430.

The storage 460 includes one or more disks, tape drives, and solid state drives, and may be used as an overflow data storage device, to store programs when the programs are selectively executed, and to store instructions and data that are read during program execution. The storage 460 may be volatile and/or non-volatile, and may be a read-only memory (ROM), a random access memory (RAM), a random access memory (ternary content-addressable memory, TCAM), and/or a static random access memory (SRAM).

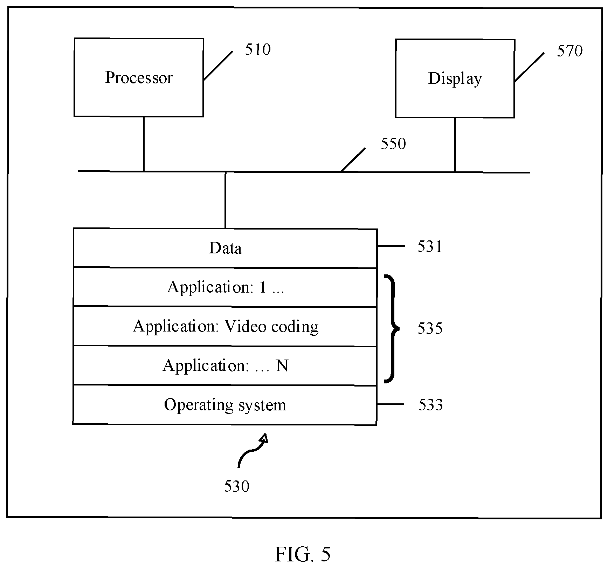

FIG. 5 is simplified block diagram of an apparatus that can be used as any one or two of the source device 12 and the destination device 14 in FIG. 1A according to an example embodiment. The apparatus may implement the technologies of the present invention. In other words, FIG. 5 is a block diagram of an implementation of an encoding device or a decoding device (referred to as a coding device for short) according to an embodiment of the present invention. The decoding device may include a processor 510, a storage 530, and a bus system 550. The processor and the storage are connected through the bus system. The storage is configured to store instructions. The processor is configured to execute the instructions stored in the storage. The storage of the coding device stores program code, and the processor may invoke the program code stored in the storage to execute various video encoding or decoding methods described in the present invention. To avoid repetition, details are not described herein.

In this embodiment of the present invention, the processor 510 may be a central processing unit (Central Processing Unit, "CPU" for short), or the processor 510 may be another general-purpose processor, a digital signal processor (DSP), an application-specific integrated circuit (ASIC), a field programmable gate array (FPGA) or another programmable logic device, a discrete gate or a transistor logic device, a discrete hardware component, or the like. The general-purpose processor may be a microprocessor, or the processor may be any conventional processor or the like.

The storage 530 may include a read-only memory (ROM) device or a random access memory (RAM) device. Any other proper type of storage device may also be used as the storage 530. The storage 530 may include code and data 531 that are accessed by the processor 510 through a bus 550. The storage 530 may further include an operating system 533 and an application program 535, and the application program 535 includes at least one program that allows the processor 510 to execute the video encoding or decoding method described in the present invention. For example, the application program 535 may include applications 1 to N, and further include a video encoding or decoding application (referred to as a video coding application) performing the video encoding or decoding method described in the present invention.

In addition to a data bus, the bus system 550 may further include a power bus, a control bus, a status signal bus, and the like. However, for clear description, various types of buses in the figure are marked as the bus system 550.

Optionally, the coding device may further include one or more output devices, for example, a display 570. In an example, the display 570 may be a touch display that combines a display and a touch unit that operably senses touch input. The display 570 may be connected to the processor 510 through the bus 550.

Although the processor 510 and the storage 530 of the apparatus are depicted in FIG. 5 as integrated into single units, another configuration may be used. The operation of the processor 510 may be distributed in a plurality of machines that can be directly coupled (each machine has one or more processors), or distributed in a local area or another network. The storage 530 may be distributed in a plurality of machines, such as a network-based storage or a storage in a plurality of machines running the apparatus. Although only a single bus is depicted herein, the bus 550 of the apparatus may include a plurality of buses. Further, the storage 530 may be directly coupled to another component of the apparatus or may be accessed through a network, and may include a single integrated unit such as a storage card, or a plurality of units such as a plurality of storage cards. Therefore, the apparatus may be implemented in a plurality of configurations.

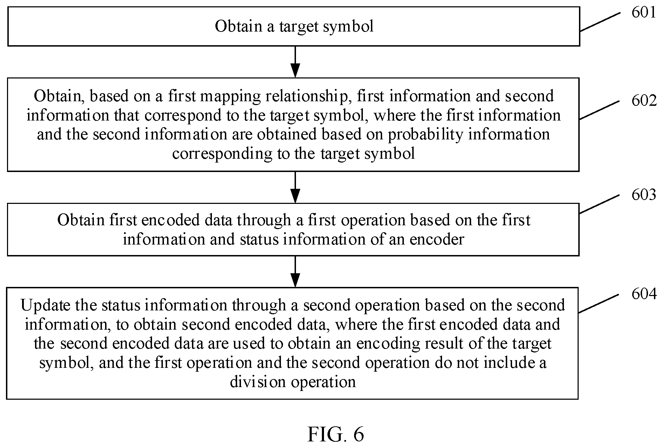

FIG. 6 is a diagram of an embodiment of a data encoding method according to an embodiment of this application. As shown in FIG. 6, the data encoding method provided in this embodiment of this application includes the following steps.

601: Obtain a target symbol.

The data encoding method corresponding to FIG. 6 may be applied to an asymmetric numeral system ANS-based encoder. Specifically, the ANS-based encoder may be used as an entropy encoding unit in a data encoding process. For ease of description, the asymmetric numeral system ANS-based encoder is referred to as an ANS encoder for short below.

In a possible implementation, the ANS encoder may receive an input symbol stream (including the target symbol), encode the input symbol stream, and output encoded data (or may be referred to as an encoding result) as a part of a bit stream. A total quantity of output bits is generally less than a total quantity of input bits, to provide compression effect.

In a possible implementation, the ANS encoder may include an input symbol buffer, configured to store a to-be-encoded input symbol. The target symbol is used as an example. The target symbol may be a parameter for a quantized transform coefficient from media (for example, a video, an image, audio, or a graphic texture), a parameter for other residual data from media, or other data.

In a possible implementation, bits (or may be referred to as codewords) obtained by encoding the input symbol stream may include status information and a memory bit, where the status information s is an integer and supports operations such as summation, subtraction, multiplication, division, shift, and AND/OR/NOT, and the memory (memory) bit is a first-in-last-out bit stream and supports writing (write) a specified quantity of bits and reading (read) a specified quantity of bits. It needs to be ensured that after any valid number is written into a specific quantity of bits, the number can be restored by reading the same quantity of bits. An encoding order is generally opposite to a decoding order, for example, reverse encoding and forward decoding.

In an ANS, probability information needs to be calculated. The probability information may include a quantization probability, a probability mass function (probability mass function, PMF), and a cumulative distribution function (cumulative distribution function, CDF) that correspond to each of a plurality of input symbols. Specifically, the PMF and the CDF may be calculated based on the quantization probability.

In a possible implementation, a probability of each symbol may be quantized into a fraction. For example, denominators (denoted as a value M) of all quantization probabilities are equal, and are an integer power of 2 (denoted as $M = 2^m$). A probability mass function PMF (denoted as $P(x)$) and a cumulative distribution function CDF (denoted as $C(x)$) of each symbol x are calculated based on the quantized probability. $P(x)$ is a numerator of the quantization probability, and in a possible implementation, $C(x)$ is a sum of $P(x)$ of symbols less than x.

In a possible implementation, a plurality of distribution features include a first distribution feature and a second distribution feature, and an entropy of the first distribution feature is greater than an entropy of the second distribution feature, and a value of a denominator of a quantization probability in a mapping relationship corresponding to the second distribution feature is greater than that of a denominator of a quantization probability in a mapping relationship corresponding to the first distribution feature.

In a multi-distribution scenario, different quantization probability denominators may be used to reduce an encoding length. During data encoding, a prediction model and entropy encoding may be included, and the prediction model may input original data, and output a distribution index and to-be-encoded data (for example, the target symbol in this application). An entropy may be calculated based on the distribution index. A larger quantization probability denominator may be used for distribution with a smaller entropy.

During encoding or decoding, different quantization probability denominators may be used for different distribution. Specifically, a larger quantization probability denominator is used for more centralized distribution. For example:

1. In a Gaussian distribution type, a larger quantization probability denominator is used for distribution with a smaller variance, and a smaller quantization probability denominator is used for distribution with a larger variance.

2. In a logistic distribution type, a larger quantization probability denominator is used for distribution with a smaller scatter degree, and a smaller quantization probability denominator is used for distribution with a larger scatter degree.

3. In a Laplace distribution type, a larger quantization probability denominator is used for distribution with a smaller scale parameter, and a smaller quantization probability denominator is used for distribution with a larger scale parameter.

In a possible implementation, the probability information includes a value of the probability mass function PMF, and the value of the PMF is constructed in the following manner: sequentially determining a value of a PMF of each of a plurality of symbols, where the plurality of symbols include the target symbol; and when a value of a PMF of the target symbol is determined, a total value of remaining PMFs other than a PMF of a determined symbol is multiplied by a probability of the target symbol, a ratio of a multiplication result of the multiplication to a remaining probability obtained by excluding the determined symbol is calculated, and the PMF of the target symbol is determined based on a relationship between the ratio and a preset fifth value.

In a possible implementation, the fifth value is 1, and the relationship is taking a larger value.

For example, the total value of remaining PMFs may be initialized to M, and a total remaining probability may be initialized to 1. All symbols within a value range are sorted in ascending order of probabilities. A value of a PMF of each sorted symbol is obtained in the following manner: multiplying the total value of remaining PMFs by a probability of the symbol, dividing a multiplication result by the remaining total probability, rounding a division result up, and obtaining a larger value from 1 and the rounded-up result; and subtracting the value of the PMF of the symbol from the total value of remaining PMFs, and subtracting the probability of the symbol from the remaining total probability.

In a possible implementation, the probability information includes a value of the cumulative distribution function CDF, and the value of the CDF is constructed in the following manner:

sequentially determining a value of a CDF of each symbol in a preset order, where the preset order is determined based on a relationship between values of PMFs corresponding to the plurality of symbols, and the plurality of symbols include the target symbol, where when probability distribution corresponding to the probability information of the target symbol is symmetric distribution, the preset order is an alternating order along two sides of a peak point in the symmetric distribution; or when probability distribution corresponding to the probability information of the target symbol is discrete distribution, the preset order is specifically a descending order; or when probability distribution corresponding to the probability information of the target symbol is discrete distribution, the preset order is specifically an ascending order.

For example, for single-peak symmetric distribution (for example, Gaussian distribution, Laplace distribution, or logistic distribution), C(x) of a peak point x is equal to 0, and values of PMFs may be accumulated from the peak point to two sides, that is, in an order of x, x-1, x+1, x-2, x+2, ..., to obtain a value of a CDF corresponding to each symbol.

For example, for discrete distribution, all symbols within a value range may be sorted in descending order of values of PMFs, and are denoted as x(0), x(1), x(2), ..., where C(x(0)) of x(0) is equal to 0, and the values of the PMFs are accumulated in an order of x(1), x(2), ..., to obtain a value of a CDF corresponding to each symbol.

Optionally, when the CDF is calculated, an order from the middle to two sides may also be x, x+1, x-1, x+2, x-2, ...; and when the values of the PMFs are equal, a plurality of possible manners may be selected to break the drawback, for example, indexes in ascending order (in descending order) and a random seed.

Table 1 is an example of the probability information.

Table 1

| Symbol | Probability | Quantization probability | PMF (P(x)) | CDF (C(x)) |
|--------|-------------|--------------------------|------------|------------|
| A | 0.7 | 5/8 | 5 | 0 |
| B | 0.1 | 1/8 | 1 | 5 |
| C | 0.1 | 1/8 | 1 | 6 |
| D | 0.1 | 1/8 | 1 | 7 |

In this embodiment of this application, the PMF calculation method and the CDF calculation method can ensure that a codeword length is reduced without changing memory and a delay.

In a possible implementation, an encoding table (that is, a mapping relationship in this embodiment of this application, for example, a first mapping relationship) further needs to be obtained. The following uses the first mapping relationship as an example to describe how to construct the encoding table.

In a possible implementation, the first mapping relationship may include a symbol, a corresponding bit addend (which may be referred to as first information), and a corresponding status addend (which may be referred to as second information).

For example, the symbol is the target symbol. In a possible implementation, the first information in the first mapping relationship is constructed in the following manner: performing a summation operation on a preset sixth value and a quantity of leftmost bits that are consecutive 0s in the value of the PMF of the target symbol; and performing a bit shift operation on a summation result of the summation operation, and performing a subtraction operation on a shift result of the bit shift operation and a shift result of a bit shift operation performed on the value of the PMF of the target symbol, to obtain the first information.

In a possible implementation, the sixth value may be m - 31, where m is an integer power of 2 in a denominator of the quantization probability.

In a possible implementation, performing the bit shift operation on the summation result of the summation operation may be specifically performing a left m-bit shift operation on the summation result of the summation operation, and performing the bit shift operation on the value of the PMF of the target symbol may be specifically performing a left $b(x)$-bit shift operation on the value of the PMF of the target symbol, where $b(x)$ may be the summation result of the foregoing summation operation performed on the preset sixth value and the quantity of leftmost bits that are consecutive 0s in the value of the PMF of the target symbol.

For example, when the encoding table is constructed, for each symbol x, a construction method is as follows (Manner 1):

Each time x is encoded, a quantity $b(x) = clz(P(x)) + m - 31$ of basic bits written into a memory bit is calculated. The clz function calculates a quantity of leftmost bits that are consecutive 0s in a 32-bit integer.

A result of calculating the bit addend is $(b(x) \ll m) - (P(x) \ll b(x)) + M$, a range is $[0, m \times M]$, and the result is represented by an $(m + [\log_2 (m + 1)])$-bit unsigned integer.

For example, the symbol is the target symbol. In a possible implementation, the first information in the first mapping relationship is constructed in the following manner: performing a bit shift operation on the summation result of the summation operation, performing a subtraction operation on a shift result of the bit shift operation and the shift result of the bit shift operation performed on the value of the PMF of the target symbol, and performing a summation operation on an operation result of the subtraction operation and a value M, to obtain the first information, where the probability information includes a quantization probability, and M is a denominator of the quantization probability.

For example, when the encoding table is constructed, for each symbol x, a method for constructing the first information is as follows (Manner 2):

In Manner 2, compared with Manner 1, a result of a "bit addend" is changed from $(b(x) \ll m) - (P(x) \ll b(x)) + M$ to $(b(x) \ll m) - (P(x) \ll b(x))$, a range is changed to $[-M, (m - 1) \times M]$, and the result is represented by an $(m + 1 + [\log_2 m])$-bit signed integer. Because a bit OR operation is omitted, overheads and complexity of the operation are reduced. Encoding efficiency can be further improved while a small amount of memory is increased. This manner is applicable to scenarios that require high encoding efficiency.

In a possible implementation, the second information in the first mapping relationship is constructed in the following manner (Manner 1): performing a subtraction operation on a value of a CDF of the target symbol and the value of the PMF of the target symbol, to obtain the second information.

For example, when the encoding table is constructed, for each symbol x, a method for constructing the second information is as follows:

A result of a "status addend" is changed from $C(x) - P(x)$ to $C(x) - P(x) + M$, a range is changed to $[1, M \times 2 - 2]$, and the result is represented by an $(m + 1)$-bit unsigned integer.

In a possible implementation, the second information in the first mapping relationship is constructed in the following manner (Manner 2): performing a subtraction operation on a value of a CDF of the target symbol and the value of the PMF of the target symbol, and performing a summation operation on an operation result of the subtraction operation and a value M, to obtain the second information, where the probability information includes the quantization probability, and M is the denominator of the quantization probability.

For example, when the encoding table is constructed, for each symbol x, a method for constructing the first information is as follows (Manner 2):

In Manner 2, compared with Manner 1, a calculation result of a "status addend" is changed from $C(x) - P(x)$ to "if $C(x) - P(x) \geq 0$, the "status addend" is $C(x) - P(x)$; or if $C(x) - P(x) < 0$, the "status addend" is $C(x) - P(x) + M$". In this case, a value range of the "status addend" is $[0, M - 1]$, and the "status addend" may be represented by an m-bit unsigned integer. An additional bit OR operation increases calculation overheads, and can further improve encoding efficiency while increasing a small amount of memory. This manner is applicable to scenarios that require high encoding efficiency.

In a possible implementation, the second information in the first mapping relationship is constructed in the following manner (Manner 3): when a result of the subtraction operation performed on the value of the CDF of the target symbol and the value of the PMF of the target symbol is greater than or equal to 0, using the result of the subtraction operation as the second information. In the foregoing manner, memory consumption can be further reduced while encoding efficiency is slightly reduced. This manner is applicable to scenarios in which memory is saved to the maximum extent.

In a possible implementation, the second information in the first mapping relationship is constructed in the following manner: when a result of a subtraction operation performed on a value of a CDF of the target symbol and the value of the PMF of the target symbol is less than 0, performing a summation operation on the operation result of the subtraction operation and a value M, to obtain the second information, where the probability information includes the quantization probability, and M is the denominator of the quantization probability.

For example, when the encoding table is constructed, for each symbol x, a method for constructing the first information is as follows (Manner 2):

In Manner 2, compared with Manner 1, a calculation result of a "status addend" is changed from $C(x) - P(x)$ to "if $C(x) - P(x) \geq 0$, the "status addend" is $C(x) - P(x)$; or if $C(x) - P(x) < 0$, the "status addend" is $C(x) - P(x) + M$". In this case, a value range of the "status addend" is $[0, M - 1]$, and the "status addend" may be represented by an m-bit unsigned integer.

Table 2 is an example of the first mapping relationship constructed in Manner 1.

Table 2

| x | Bit addend | Status addend |
|---|---|---|
| A | -2 | 3 |
| B | 16 | 12 |
| C | 16 | 13 |
| D | 16 | 14 |

Table 3 is an example of the first mapping relationship constructed in Manner 2.

Table 3

| x | Bit addend | Status addend |
|---|---|---|
| A | -2 | 3 |
| B | 16 | 12 |
| C | 16 | 13 |
| D | 16 | 14 |

Table 4 is an example of the first mapping relationship constructed in Manner 3.

Table 4

| x | Bit addend | Status addend |
|---|---|---|
| A | 6 | 3 |
| B | 24 | 4 |
| C | 24 | 5 |
| D | 24 | 6 |

In a possible implementation, the first information or the second information may represent an integer value, that is, a single integer. For example, the first information may represent an integer value, and the second information may represent an integer value. In this embodiment of this application, index information in the encoding table includes only symbols, and a mapped object includes only the first information and the second information. This reduces memory usage of the encoding table.

It should be understood that different mapping relationships (including the first mapping relationship) may be further configured for different probability distribution.

In a possible implementation, the target symbol is obtained by transforming pixel data of an image, data obtained by transforming the pixel data of the image meets preset distribution, the transform is further used to obtain a distribution feature of the pixel data, the distribution feature includes a mean value or a variance, and the first mapping relationship corresponding to the distribution feature may be determined from a plurality of mapping relationships based on the distribution feature. In other words, the first mapping relationship corresponding to the distribution feature is determined from the plurality of mapping relationships based on the distribution feature as an index.

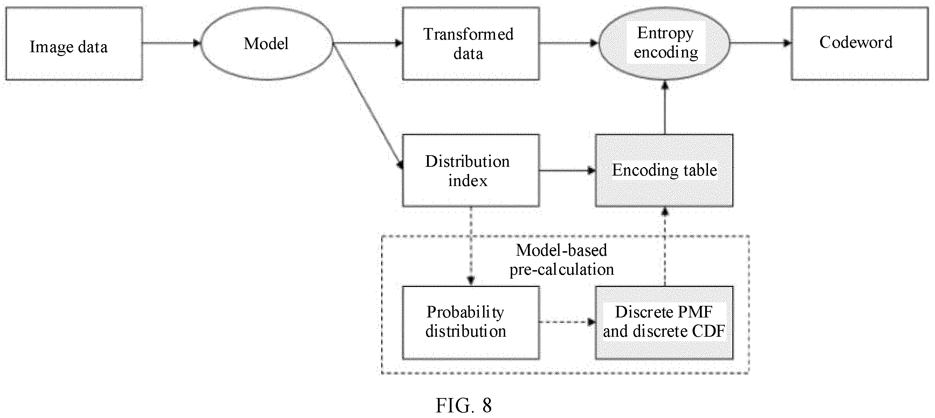

FIG. 8 is a diagram of an encoding process.

A model may include two parts. The first part is an image data processing module. The model transforms image data, and distribution of the transformed data is simpler. This facilitates an entropy encoding process. The model may be a neural network, processes the image data into transformed data, and obtains a distribution index of the transformed data in each dimension. The model may also be preprocessing and quantization processes of image color transformation. For example, YUV or discrete Fourier transform is performed on an RGB image to obtain transformed data, and a specific distribution index is established for the transformed data.

The second part is to predefine some probability distribution (for example, Gaussian distribution and logistic distribution of different variances), and establish a corresponding distribution index and a corresponding encoding table. The encoding table is constructed based on a calculated discrete PMF and a calculated discrete CDF.

In the encoding process, a distribution index corresponding to transformed data in each dimension may be found, and therefore a corresponding encoding table is found; and entropy encoding is performed to form an encoded codeword, and the encoded codeword is stored. The codeword may further store a basic header file, for example, a length and a width of an image, and some necessary parameters.

In a possible implementation, to further reduce memory usage, the first information and the second information may be combined and then stored, and after obtaining combined data, the encoder may restore the first information and the second information according to a specific operation rule.

In a possible implementation, an integer value corresponding to the target symbol may be obtained based on the first mapping relationship; and the integer value is restored to the first information and the second information through a third operation, where the first information and the second information each are an integer value. The foregoing manner can reduce memory consumption, shorten memory read time, and further improve throughput on some hardware devices (for example, a server).

For example, a plurality of integer parameters (at most one of which is a signed integer) may be combined into a single parameter. The method is as follows: placing a signed integer on the leftmost side, and then sequentially storing the parameters by bit based on a quantity of bits of each parameter through a shift operation and a bit OR operation; and when a symbol is read, restoring each parameter through a shift operation and a bit AND operation.

Table 7 is an example of an encoding table before information combination, Table 8 is a diagram of an encoding table after information combination, and Table 9 is a summary of parameter lengths of an encoding table.

Table 7

| x | Bit addend | Status addend |
|---|---|---|
| A | 6 | -5 |
| B | 24 | 4 |
| C | 24 | 5 |
| D | 24 | 6 |

Table 8

| x | Encoding parameter |
|---|---|
| A | -154 |
| B | 152 |
| C | 184 |
| D | 216 |

Table 9

| Encoding table construction manner | Combination sequence | Length of a "bit addend" | Length of a "status addend" | Total length of a combined parameter |
|---|---|---|---|---|
| Manner 1 | [Status addend, bit addend] | $\geq m + \lceil \log_2(m+1) \rceil$ | $\geq m + 1$ | m ≤ 9, 24/32 bits m ≤ 13, 32 bits |
| Manner 2 | [Bit addend, status addend] | $\geq m + 1 + \lceil \log_2(m+1) \rceil$ | $\geq m + 1$ | |
| Manner 3 | Unlimited | $\geq m + \lceil \log_2(m+1) \rceil$ | $\geq m$ | m ≤ 10, 24/32 bits m ≤ 14, 32 bits |

603: Obtain first encoded data through a first operation based on the first information and the status information of the encoder.

604: Update the status information through a second operation based on the second information, to obtain second encoded data, where the first encoded data and the second encoded data are used to obtain an encoding result of the target symbol, and the first operation and the second operation do not include a division operation.

The first encoded data may be a memory bit, and the second encoded data may be a state s.

In a possible implementation, at least one of the first operation and the second operation may not include a division operation, thereby reducing a calculation delay.

In a possible implementation, at least one of the first operation and the second operation may not include a judgment operation, thereby reducing a calculation delay.

In a possible implementation, at least one of the first operation and the second operation may not include a binary search operation, thereby reducing a calculation delay.

In a possible implementation, the first operation includes: performing a summation operation on the first information and the status information, and performing a bit shift operation on a summation result of the summation operation; and selecting some bits from the status information as the first encoded data, where locations of the some bits in the status information are determined based on a shift result of the bit shift operation.

In a possible implementation, the second operation includes: performing a summation operation on the status information and the value M, and performing a bit shift operation on a summation result of the summation operation, where the probability information includes the quantization probability, and M is the denominator of the quantization probability; and performing a summation operation on a shift result of the bit shift operation and the second information.

For example, during encoding, $0 \leq s < M$. s is initialized to 0.

For an encoded symbol x, a "bit addend" and a "status addend" are obtained by table lookup based on x; and a quantity b of bits written into the memory bit is calculated in the following manner: shifting, rightward by m bits, a sum of a current state s and the "bit addend"; and writing the rightmost b bits of the current state s into the memory bit; and updating the state s to a sum of the "status addend" and a result obtained by shifting, rightward by b bits, a sum of the current state s and M.

s may be represented in a binary form of an m-bit unsigned integer, and is combined with the memory bit to obtain an encoding result, that is, a codeword.

Table 5 shows that AAABA is encoded into 00101110 in the foregoing manner (where the first three bits 001 indicate that a state is 1, and 01110 is the memory bit).

Table 5

| s | Memory | x | Quantity of bits written into a memory bit |
|---|---|---|---|
| 0 | | A | 0 |
| 3 | | B | 3 |
| 5 | 011 | A | 1 |
| 1 | 0111 | A | 0 |
| 4 | 0111 | A | 1 |
| 1 | 01110 | | |

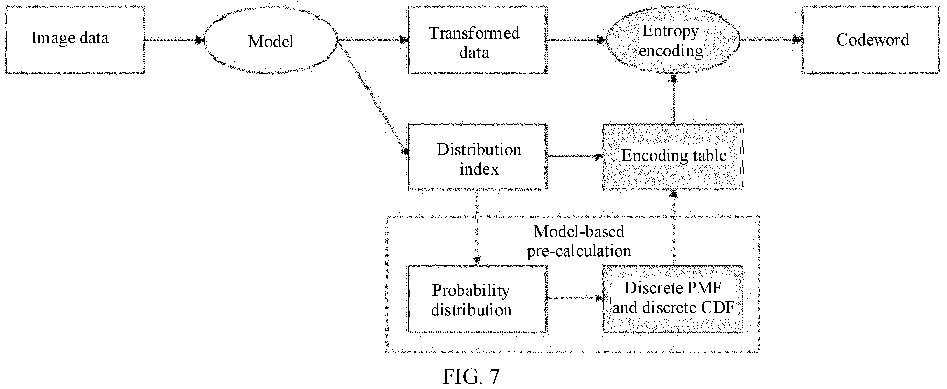

FIG. 7 is a schematic flowchart of constructing an encoding table in the Manner 1 above and performing an encoding process through the first operation and the second operation described above.

In a possible implementation, when an encoding table is constructed in Manner 2 above, the second operation may include: when the status information is initialized to M, performing a bit shift operation on the status information; performing a summation operation on a shift result of the bit shift operation and the second information; and performing a subtraction operation on a summation result of the summation operation and M.

For example, in the entire encoding process, M ≤ s < M × 2, and during encoding, s is initialized to M.

"The sum of the status addend and the result obtained by shifting, rightward by b bits, the sum of the current state s and M" may be changed to "a sum of the status addend and a result obtained by shifting the current state s rightward by b bits"; and s-M is represented in a binary form of an m-bit unsigned integer, and is combined with the memory bit.

Table 6 shows that AAABA is encoded into 00101110 in the foregoing manner (where the first three bits 001 indicate that a state is 1, and 01110 is the memory bit).

Table 6

| s | Memory | x | Quantity of bits written into a memory bit |
|---|---|---|---|
| 8 | | A | 0 |
| 11 | | B | 3 |
| 13 | 011 | A | 1 |
| 9 | 0111 | A | 0 |
| 12 | 0111 | A | 1 |
| 9 | 01110 | | |

An embodiment of this application provides a data encoding method, applied to an asymmetric numeral system ANS-based encoder. The method includes: obtaining a target symbol; obtaining, based on a first mapping relationship, first information and second information that correspond to the target symbol, where the first information and the second information are obtained based on probability information corresponding to the target symbol; obtaining first encoded data through a first operation based on the first information and status information of the encoder; and updating the status information through a second operation based on the second information, to obtain second encoded data. The first encoded data and the second encoded data are used to obtain an encoding result of the target symbol, and the first operation and the second operation do not include a division operation. In this application, index information in an encoding table includes only symbols, and a mapped object includes only the first information and the second information. This is equivalent to reducing memory usage in the encoding table, avoiding an operation that consumes a large amount of memory, and balancing memory and a delay.

In a possible implementation, the second information includes first sub-information (which may also be referred to as a status addend 1), second sub-information (which may also be referred to as a status threshold), and third sub-information (which may also be referred to as a status addend 2).

The first sub-information in the first mapping relationship is constructed in the following manner: performing a subtraction operation on a third value of the target symbol and a value of a PMF of the target symbol, to obtain the first sub-information.

The second sub-information in the first mapping relationship is constructed in the following manner: performing a summation operation on the third value of the target symbol and a first value of the target symbol, and performing a subtraction operation on an operation result of the summation operation and 1, to obtain the second sub-information.

The third sub-information in the first mapping relationship is constructed in the following manner: performing a subtraction operation on a fourth value of the target symbol and the third value of the target symbol, and performing a subtraction operation on an operation result of the subtraction operation and the first value of the target symbol, to obtain the third sub-information.

In a possible implementation, the second operation includes:

performing a summation operation on the status information and a value M, and performing a bit shift operation on a summation result of the summation operation, where the probability information includes a quantization probability, and M is a denominator of the quantization probability; and performing a summation operation on a shift result of the bit shift operation and the first sub-information; and

when an operation result of the summation operation is greater than the second sub-information, using a summation result of the operation result of the summation operation and the third sub-information as the second encoded data; or when an operation result of the summation operation is less than the second sub-information, using the operation result of the summation operation as the second encoded data.

The foregoing manner may be applicable to, but is not limited to, single-peak symmetric distribution (for example, Gaussian distribution, logistic distribution, or Laplace distribution), and is used to reduce an encoding length, but an encoding calculation amount is increased.

1. A value of a PMF of each symbol is divided into two parts: $P(x) = P1(x) + P2(x)$.
2. $C1(x)$ is calculated as a sum of $P1(x)$ of symbols less than x; and $C2(x)$ is calculated as a sum of all values of $P1(x)$ and a sum of $P2(x)$ of the symbols less than x.

The following table shows a specific example.

| Symbol | Probability | Quantization probability | PMF ($P(x)$) | CDF ($C(x)$) | $P1(x)$ | $P2(x)$ | $C1(x)$ | $C2(x)$ |
|---|---|---|---|---|---|---|---|---|
| A | 0.7 | 5/8 | 5 | 0 | 3 | 2 | 0 | 4 |
| B | 0.1 | 1/8 | 1 | 5 | 0 | 1 | 3 | 6 |
| C | 0.1 | 1/8 | 1 | 6 | 1 | 0 | 3 | 7 |
| D | 0.1 | 1/8 | 1 | 7 | 0 | 1 | 4 | 7 |

When the encoding table is constructed, for each symbol x, an example of a construction method is as follows:

(1) Each time x is encoded, a quantity $b(x) = clz(P(x)) + m - 31$ of basic bits written into the memory bit is calculated. The clz function calculates a quantity of leftmost bits that are consecutive 0s in a 32-bit integer.
(2) A result of calculating a bit addend is $(b(x) \ll m) - (P(x) \ll b(x)) + M$, a range is $[2, m \times M]$, and the result is represented by an $(m + [\log_2 (m + 1)])$-bit unsigned integer, z.
(3) A result of calculating the status addend 1 is $C1(x) - P(x)$.
(4) A result of calculating the status threshold is $C1(x) + P1(x) - 1$.
(5) A result of calculating the status addend 2 is $C2(x) - C1(x) - P1(x)$.

The following table shows an example of an encoding table:

| x | Bit addend | Status addend 1 | Status threshold | Status addend 2 |
|---|---|---|---|---|
| A | 6 | -5 | 2 | 1 |
| B | 24 | 2 | 2 | 3 |
| C | 24 | 2 | 3 | 3 |
| D | 24 | 3 | 3 | 3 |

During encoding, a codeword may include a state s and memory memory.
For example, during an entire encoding process, $0 \leq s < M$. s is initialized to 0.
An encoded symbol x:

(1) The "bit addend", the "status addend 1", the "status threshold", and the "status addend 2" are obtained by table lookup based on x.
(2) A quantity b of bits written into the memory bit is calculated by shifting, rightward by m bits, a sum of a current state s and the "bit addend".
(3) The rightmost b bits of the current state s is written into the memory bit.
(4) The state s is updated to a sum of the "status addend 1" and a result obtained by shifting, rightward by b bits, a sum of the current state s and M.
(5) If the status s is greater than the "status threshold", s is updated to a sum of s and the "status addend 2".

Codeword: s is represented in a binary form of an m-bit unsigned integer and is combined with the memory bit.

| s | Memory | x | Quantity of bits written into a memory bit |
|---|--------|---|--------------------------------------------|
| 0 |        | A | 0 |
| 4 |        | B | 3 |
| 6 | 100    | A | 1 |
| 2 | 1000   | A | 1 |
| 0 | 10000  | A | 0 |
| 4 | 10000  |   |   |

In a possible implementation, when the value M is 256, the first information is stored by using 10 bits, the first sub-information is stored by using 8 bits, the second sub-information is stored by using 7 bits, the third sub-information is stored by using 7 bits, a sum of the first values of the plurality of symbols is 128, and the third sub-information is less than 128.

When M=256 (m=8), the following condition is met:
A "bit addend", a "status addend 1", a "status threshold", and a "status addend 2" of each symbol respectively require 10 bits, 8 bits, 7 bits, and 7 bits, that is, 32 bits in total. A sum of all P1(x) is exactly 128, and a value of the "status addend 2" is always less than 128.

When M = 256 (m = 8), a "bit addend", a "status addend 1", a "status threshold", and a "status addend 2" respectively require 12 bits, 8 bits, 8 bits, 8 bits, and 8 bits, that is, 36 bits in total, which cannot be represented by 4 bytes. The four parts may be represented by using 32 bits in total by using the following method:

1. A bit addend B is originally an even number between [2, 2048] and requires 12 bits, and B/2-1 may be represented by using 10 bits.
2. A value of P1(x) and a value of P2 (x) are adjusted, so that a sum of all P1(x) is exactly 128, and a value of the "status addend 2" is always less than 128. In this case, ranges of the "status threshold" and the "status addend 2" are both [0, 127], and the "status threshold" and the "status addend 2" may be represented by using 7 bits.

According to this solution, the "bit addend", the "status addend 1", the "status threshold", and the "status addend 2" of each symbol respectively require 10 bits, 8 bits, 7 bits, and 7 bits, that is, 32 bits in total.

This application further provides a data encoding method, applied to an asymmetric numeral system ANS-based encoder. The method includes: obtaining a first symbol, where a sum of a quantization probability corresponding to the first symbol and a quantization probability corresponding to a second symbol is 1, a difference between the quantization probability corresponding to the first symbol and 1 is less than a threshold, and a difference between the quantization probability corresponding to the second symbol and 0 is less than the threshold; and when a value relationship between status information of the encoder and a value M meets a first condition, performing a first operation on the status information and the value M to obtain first encoded data, and updating the status information to 0; or when a value relationship between status information of the encoder and a value M does not meet a first condition, adding 1 to the status information.

In a possible implementation, the method further includes: obtaining the second symbol; and using the status information of the encoder as the first encoded data, and updating the status information to a difference between the value M and 1.

The foregoing embodiment may be specific to an encoding and decoding solution for a case in which there are two types of symbols in total and a probability of a single symbol is close to 1. In this embodiment, there is no need to construct encoding and decoding tables. Therefore, no additional memory is required to store the tables. It is assumed that there are two types of symbols a and b in total, and a probability of the symbol a is close to 1. In this case, an encoding algorithm is as follows:
The symbol a is compressed: If a state $s \geq M - 2$, s-M+2 (0 or 1) is written into 1 bit and into the memory bit, and then s is updated to 0; or if a state s < M - 2, s is updated to s+1.

The symbol b is compressed: All m bits of s are written into the memory bit, and s is updated to M-1.

FIG. 9 is a diagram of an embodiment of a data decoding method according to an embodiment of this application. As shown in FIG. 9, the data decoding method provided in this embodiment of this application includes the following steps:
901: Obtain status information of a decoder and a memory bit, where the status information corresponds to a first bit, and the first bit is a current to-be-decoded bit.

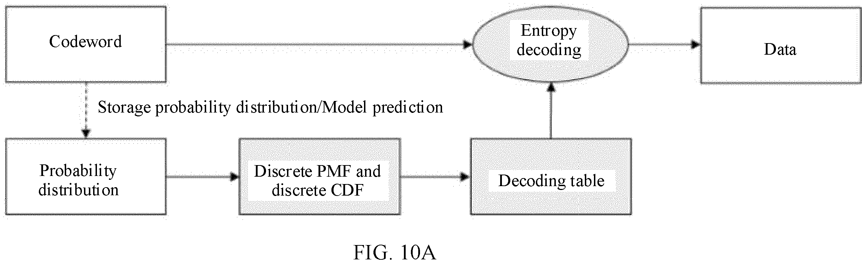

For example, FIG. 10A is a specific diagram of a data decoding method according to an embodiment of this application.

The status information (a decoding status) may be obtained from an encoder side, or may be status information obtained by updating the status information in a decoding process. The memory bit may be obtained from the encoder side, or may be a memory bit obtained by updating the memory bit in the decoding process.

902: Determine, based on a first mapping relationship, first information, second information, and third information that correspond to the status information, where the first information is a target symbol corresponding to the first bit, the target symbol is a decoding result of the first bit, the second information indicates a quantity of bits selected from the memory bit, the third information is used to perform a summation operation with a bit selected from the memory bit based on the third information, a result of the summation operation is used to update the status information, updated status information corresponds to a second bit, and the second bit is a to-be-decoded bit after the first bit.

It should be understood that the first mapping relationship described in FIG. 6 and the first mapping relationship described in FIG. 9 are different mapping relationships. The first mapping relationship described in FIG. 9 is a decoding table.

The first information may be referred to as a decoded symbol, the second information may be referred to as a quantity of read bits, and the third information may be referred to as a status cardinality.

In a possible implementation, the first information, the second information, or the third information is obtained based on probability information; the probability information includes a value of a probability mass function PMF; and the value of the PMF is constructed in the following manner: sequentially determining a value of a PMF of each of a plurality of symbols, where the plurality of symbols include the target symbol, and when a value of a PMF of the target symbol is determined, a total value of remaining PMFs other than a PMF of a determined symbol is multiplied by a probability of the target symbol, a ratio of a multiplication result of the multiplication to a remaining probability obtained by excluding the determined symbol is calculated, and the PMF of the target symbol is determined based on a relationship between the ratio and a preset value.

In a possible implementation, the first information, the second information, or the third information is obtained based on the probability information, and the probability information includes a value of a cumulative distribution function CDF; and the value of the CDF is constructed in the following manner: sequentially determining a value of a CDF of each symbol in a preset order, where the preset order is determined based on a relationship between values of PMFs corresponding to the plurality of symbols, and the plurality of symbols include the target symbol, where when probability distribution corresponding to the probability information of the target symbol is symmetric distribution, the preset order is an alternating order along two sides of a peak point in the symmetric distribution; or when probability distribution corresponding to the probability information of the target symbol is discrete distribution, the preset order is specifically a descending order; or when probability distribution corresponding to the probability information of the target symbol is discrete distribution, the preset order is specifically an ascending order.

In a possible implementation, the first information in the first mapping relationship is constructed in the following manner: using x that satisfies $C(x) \leq s < (C(x) + P(x))$ as the first information, where C represents the value of the CDF, P represents the value of the PMF, and s represents the status information.

In a possible implementation, the second information in the first mapping relationship is constructed in the following manner: using a value of $clz(s - C(x) + P(x)) + X$ as the second information, where clz represents taking a quantity of leftmost bits that are consecutive 0s in a value, and X is a preset fifth value.

In a possible implementation, the third information in the first mapping relationship is constructed in the following manner: performing a bit shift operation on a value of $s - C(x) + P(x)$, to obtain the third information, where a shift quantity of the bit shift operation is obtained based on the second information; or performing a bit shift operation on a value of $s - C(x) + P(x)$, and subtracting a value M from an operation result of the bit shift operation, to obtain the third information, where M is a denominator of a quantization probability, and a shift quantity of the bit shift operation is obtained based on the second information.

For example, when the decoding table is constructed, for each status s, a construction method is as follows: The "decoded symbol" is a value of x that satisfies $C(x) \leq s < C(x) + P(x)$, a value of the "quantity of read bits" is $clz(s - C(x) + P(x)) + m - 31$, and a value of the "status cardinality" is a difference between a result obtained by shifting $s - C(x) + P(x)$ leftward by "quantity of read bits" bits and M.

Table 10 is an example of a decoding table obtained in the foregoing manner.

Table 10

| s | Decoded symbol | Quantity of read bits | Status cardinality |
|---|---|---|---|
| 0 | A | 1 | 2 |
| 1 | A | 1 | 4 |
| 2 | A | 1 | 6 |
| 3 | A | 0 | 0 |

(continued)

| s | Decoded symbol | Quantity of read bits | Status cardinality |
|---|---|---|---|
| 4 | A | 0 | 1 |
| 5 | B | 3 | 0 |
| 6 | C | 3 | 0 |
| 7 | D | 3 | 0 |

In a possible implementation, the first information, the second information, or the third information represents an integer value, that is, a single integer. For example, the first information may represent an integer value, the second information may represent an integer value, and the third information may represent an integer value. In this embodiment of this application, index information in the decoding table includes only symbols, and a mapped object includes only the first information, the second information, and the third information. This reduces memory usage of the encoding table.

It should be understood that different mapping relationships (including the first mapping relationship) may be further configured for different probability distribution.

In a possible implementation, an encoding result may be obtained, where the encoding result is obtained by encoding pixel data of an image, and the status information and the memory bit are obtained based on the encoding result; the encoding result is processed, to obtain a distribution feature of the pixel data, where the distribution feature includes a mean value or a variance; and the first mapping relationship corresponding to the distribution feature is determined from a plurality of mapping relationships based on the distribution feature.

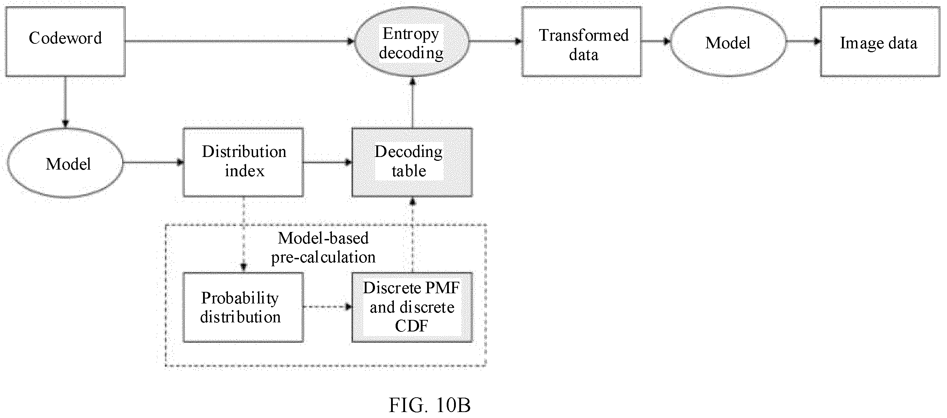

FIG. 10B is a diagram of a decoding process.

A model includes three parts.

The first part is to decode a header file in a codeword, such as a length and a width of an image and some necessary parameters. These parameters may be used to establish a distribution index corresponding to decoded data (transformed data) for information in the codeword.

The second part is to predefine some probability distribution (for example, Gaussian distribution and logistic distribution of different variances), and establish a corresponding distribution index and a corresponding decoding table. The encoding table is constructed based on a calculated discrete PMF and a calculated discrete CDF.

The third part is an image decoder that decodes the transformed data to restore the image. The decoder may be a neural network, or may be a post-processing process of image color transformation, for example, inverse Fourier transform or YUV-to-RGB transform.

During decoding, for a to-be-decoded codeword, a basic configuration in the header file is read by using the model, and a necessary distribution index of the decoded data is established based on the codeword. A decoding table corresponding to decoded data (transformed data) in each dimension is found based on a distribution index, and decoded transformed data is obtained through entropy decoding. Finally, the model is used to restore the transformed data to the original image.

In a possible implementation, an integer value corresponding to the status information may be obtained based on the first mapping relationship; and the integer value is restored to the first information, the second information, and the third information, where the first information, the second information, and the third information each are an integer value.

For example, a "decoded symbol", a "quantity of read bits", and a "status cardinality" may be combined according to the foregoing rule. A length of a single parameter is determined by a quantity $M = 2^m$ of states. To facilitate a computer to read, the length is generally set to 24 bits or 32 bits.

Table 11 is an example of a summary of parameter lengths of a decoding table.

Table 11

| Combination sequence | Length of a "decoded symbol" | Length of a "quantity of read bits" | Length of a "status cardinality" | Total length of a combined parameter |
|---|---|---|---|---|
| Unlimited | $\geq m$ | $\geq \lceil \log_2(m + 1) \rceil$ | $\geq m$ | $m \leq 10$, 24/32 bits<br>$m \leq 14$, 32 bits |

In a possible implementation, the first information is a target symbol corresponding to the first bit, the target symbol is a decoding result of the first bit, and the second information indicates a quantity of bits selected from the memory bit, the third information is used to perform a summation operation with a bit selected from the memory bit based on the third information, a result of the summation operation is used to update the status information, updated status information corresponds to a second bit, and the second bit is a to-be-decoded bit after the first bit. In addition, the selected bit may be removed from the memory bit, to obtain an updated memory bit.

For example, the "decoded symbol", the "quantity of read bits", and the "status cardinality" may be obtained through table lookup based on a value of a current state; and s is updated to a sum of the "status cardinality" and a number obtained by reading "quantity of read bits" bits from a memory bit.

Table 12 is a decoding example in which 00101110 (a state 001 represents 1, and 01110 is the memory bit) is decoded, and a decoding result is AAABA.

Table 12

| s | Memory | x | Quantity of bits read from a memory bit |
|---|--------|---|------------------------------------------|
| 1 | 01110 | A | 1 |
| 4 | 0111 | A | 0 |
| 1 | 0111 | A | 1 |
| 5 | 011 | B | 3 |
| 3 | | A | |

It should be understood that the technical solutions in the embodiment corresponding to FIG. 6 and the embodiment in FIG. 9 may be combined with each other. For example, three sub-tables may be constructed:

Sub-table 1: For each state s, a "decoded symbol" is obtained. A method and a result are the same as those in the foregoing decoding process.

Sub-table 2: For each symbol x, a "status addend" is calculated. A method and a result are the same as those of the "status addend" in Manner 1 described in the foregoing encoding process.

Sub-table 3 (all distribution shares one table): For each integer $i \in [1, M \times 2 - 1]$, a "quantity of status bits" is calculated as clz(i) + m - 31.

A process of decoding a single symbol is as follows:
The current state s is substituted into the sub-table 1, to obtain the "decoded symbol" x obtained through decoding.

x obtained through decoding is substituted into the sub-table 2, to obtain a "status addend".

A quantity of bits that need to be read from the memory bit is calculated in the following manner: substituting a value obtained by subtracting the "status addend" from s into the sub-table 3, to obtain a "quantity of status bits".

The state s is updated as follows: shifting, leftward by "quantity of status bits" bits, a result obtained by subtracting the "status addend" from a value of the current s, and using a value of a sum of a result of the shift operation and a value of "quantity of status bits" bits read from the memory bit to modulo M.

According to the foregoing method, an intermediate result of decoding in each step is the same as the decoding process described in FIG. 9.

Table 13 is an example of a decoding table obtained in the foregoing manner.

Table 13

| State s | 0 | | 1 | 2 | 3 | 4 | 5 | 6 | 7 |
|---------|---|---|---|---|---|---|---|---|---|
| Decoded symbol | A | | A | A | A | A | B | C | D |
| Symbol x | | A | | B | | C | | D | |
| Status addend | | -5 | | 4 | | 5 | | 6 | |
| Number i | 1 | | 2 | 3 | 4 | 5 | 6 | 7 | 8 to 15 |
| Quantity of status bits | 3 | | 2 | 2 | 1 | 1 | 1 | 1 | 0 |

In this embodiment of this application, compression time can be reduced. Compared with rANS, coding time is improved by three to four times.

Table 14 is an example of beneficial effect.

Table 14

| Method | Encode time (μs) | Decode time (μs) | Encode bandwidth (M sym/s) | Decode bandwidth (M sym/s) | Rel. Encode bandwidth | Rel. Decode bandwidth |
|---|---|---|---|---|---|---|
| Range coder (baseline) | 578736 | 1517031 | 36.4 | 13.9 | 108% | 22% |
| rANS (baseline) | 623609 | 341141 | 33.8 | 61.8 | 100% | 100% |
| ANSAI MASS=10 | 129752 | 110278 | 162.6 | 191.3 | 481% | 309% |
| ANSAI MASS=8 | 133935 | 101123 | 157.5 | 208.6 | 466% | 337% |

In this embodiment of this application, table memory is smaller. For a total quantity X of symbols and a quantity M of states, if each element in the table is stored by using 32 bits, a size of an encoding table is 4X, and a size of a decoding table is 3M. If each element in the table is compressed to 24 bits for storage, a size of an encoding table is 3X, and a size of a decoding table is 3M.

Memory usage of a table constructed for specific distribution is less than 100 KB (MASS=8, M=256). The table constructed for the specific distribution corresponds to 10 MB to 20 MB of a tANS table size. Therefore, table memory usage is greatly reduced.

Table 15 is an example of beneficial effect.

Table 15

| MASS/$\log_2(M)$ | Encode | Decode | Encode opt. | Decode opt. |
|---|---|---|---|---|
| Table bits | 32 | 32 | 24 | 24 |
| 8 | 93.9 | 65 | 70.4 | 48.75 |
| 10 | | 260 | | 195 |

In a possible implementation, the first information in the first mapping relationship is constructed in the following manner:

using x that satisfies $C1(x) \leq s < C1(x) + P1(x)$ or $C2(x) \leq s < C2(x) + P2(x)$ as the first information, where C1 represents a third value corresponding to a CDF, P1 represents a first value corresponding to a PMF, C2 represents a fourth value corresponding to the CDF, P2 represents a second value corresponding to the PMF, s represents the status information, and a sum of the first value and the second value is a value of the PMF.

In a possible implementation, the second information in the first mapping relationship is constructed in the following manner:

using a value of $clz(s' - C(x) + P(x)) + X$ as the second information, where clz represents taking a quantity of leftmost bits that are consecutive 0s in a value, X is a preset fifth value, and s' is obtained in the following manner:

if $C2(x) \leq s$, $s' = P1(x) + s - C2(x) + P(x)$, or if $C2(x) > s$, $s' = s - C1(x) + P(x)$.

In a possible implementation, the third information in the first mapping relationship is constructed in the following manner: performing a bit shift operation on a value of $s' - C(x) + P(x)$, to obtain the third information, where a shift quantity of the bit shift operation is obtained based on the second information.

For each state s, a construction method is as follows:

1. A "decoded symbol" is a value of x that satisfies $C1(x) \leq s < C1(x) + P1(x)$ or $C2(x) \leq s < C2(x) + P2(x)$.

2. s' corresponding to s is calculated:

    (a) if $C2(x) \leq s$, $s' = P1(x) + s - C2(x) + P(x)$, or
    (b) if $C2(x) > s$, $s' = s - C1(x) + P(x)$.

3. s' is used to construct a decoding table by using a method same as that in Embodiment 2.

(1) A value of a "quantity of read bits" is $clz(s' - C(x) + P(x)) + m - 31$.

(2) A value of a "status cardinality" is a difference between a result of shifting $s' - C(x) + P(x)$ leftward by "quantity of read bits" bits and M.

| s | s' | Decoded symbol | Quantity of read bits | Status cardinality |
|---|---|---|---|---|
| 0 | 0 | A | 1 | 2 |

(continued)

| s | s' | Decoded symbol | Quantity of read bits | Status cardinality |
|---|---|---|---|---|
| 1 | 1 | A | 1 | 4 |
| 2 | 2 | A | 1 | 6 |
| 3 | 6 | C | 3 | 0 |
| 4 | 3 | A | 0 | 0 |
| 5 | 4 | A | 0 | 1 |
| 6 | 5 | B | 3 | 0 |
| 7 | 7 | D | 3 | 0 |

In addition, each decoded symbol may correspond to one or two consecutive segments of states s. As shown in the preceding table, A corresponds to 0 to 2 and 4 and 5.

When a single symbol is decoded, a "decoded symbol", a "quantity of read bits", and a "status cardinality" may be obtained by table lookup based on a value of a current state s, and s is updated to a sum of the "status cardinality" and a number obtained by reading "quantity of read bits" bits from the memory bit.

| s | Memory | x | Quantity of bits read from a memory bit |
|---|---|---|---|
| 4 | 10000 | A | 0 |
| 0 | 10000 | A | 1 |
| 2 | 1000 | A | 1 |
| 6 | 100 | B | 3 |
| 4 | | A | 0 |

This application further provides a data decoding method, applied to an asymmetric numeral system ANS-based decoder. The method includes:

obtaining status information of the decoder, where the status information corresponds to a first bit, and the first bit is a current to-be-decoded bit; and

if the status information is a difference between a value M and 1, determining that a decoding result of the first bit is a second symbol, and updating the status information to a result of reading the value M bits from a memory bit; or if the status information is not a difference between a value M and 1, determining that a decoding result of the first bit is a first symbol; and if the status information is 0, updating the status information to a summation result of a difference between the value M and 2 and a value of 1 bit read from the memory bit; or if the status information is not 0, updating the status information to a difference between the status information and 1, where updated status information corresponds to a second bit, and the second bit is a to-be-decoded bit after the first bit.

The foregoing embodiment is an encoding and decoding solution for a case in which there are two types of symbols in total and a probability of a single symbol is close to 1.

There are two types of symbols: a and b. In this embodiment, there is no need to construct encoding and decoding tables. Therefore, no additional memory is required to store the tables. It is assumed that there are two types of symbols a and b in total, and a probability of the symbol a is close to 1. In this case, an encoding algorithm is as follows:

The symbol a is compressed: If a state $s \geq M - 2$, s-M+2 (0 or 1) is written into 1 bit and into the memory bit, and then s is updated to 0; or if a state s < M - 2, s is updated to s+1.

The symbol b is compressed: All m bits of s are written into the memory bit, and s is updated to M-1.

A decoding algorithm is as follows: If a current state s is M-1, the symbol b is decoded, and s is updated to a result of reading m bits from the memory bit. Alternatively, if a current state s is not M-1, a is decoded, and then s is updated. (1) If s=0, s is updated to a sum of M-2 and a value of 1 bit read from the memory bit; and (2) or if s≠0, s is updated to s-1.

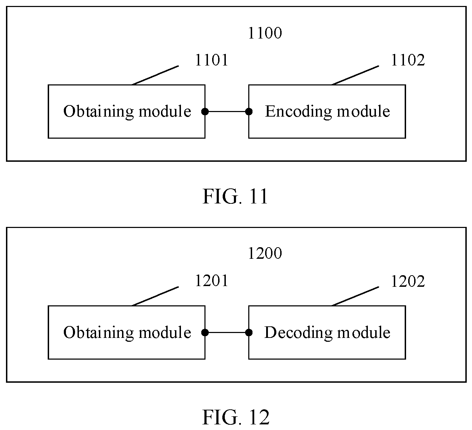

The following describes, from a perspective of an apparatus, a data encoding apparatus provided in an embodiment of this application. FIG. 11 is a diagram of a structure of a data encoding apparatus according to an embodiment of this application. As shown in FIG. 11, a data encoding apparatus 1100 provided in an embodiment of this application includes:

an obtaining module 1101, configured to obtain a target symbol.

For specific descriptions of the obtaining module 1101, refer to descriptions of step 601 in the foregoing embodiments. Details are not described herein again.

The data encoding apparatus 1100 further includes an encoding module 1102, configured to: obtain, based on a first mapping relationship, first information and second information that correspond to the target symbol, where the first information and the second information are obtained based on probability information corresponding to the target symbol;

> obtain first encoded data through a first operation based on the first information and status information of an encoder; and
> update the status information through a second operation based on the second information, to obtain second encoded data.

The first encoded data and the second encoded data are used to obtain an encoding result of the target symbol, and the first operation and the second operation do not include a division operation.

For specific descriptions of the encoding module 1102, refer to descriptions of step 602 in the foregoing embodiments. Details are not described herein again.

In a possible implementation, the first information or the second information represents an integer value.

In a possible implementation, the first operation and the second operation do not include a judgment operation.

In a possible implementation, the first operation includes:

> performing a summation operation on the first information and the status information, and performing a bit shift operation on a summation result of the summation operation; and
> selecting some bits from the status information as the first encoded data, where locations of the some bits in the status information are determined based on a shift result of the bit shift operation.

In a possible implementation, the second operation includes:

> performing a summation operation on the status information and a value M, and performing a bit shift operation on a summation result of the summation operation, where the probability information includes a quantization probability, and M is a denominator of the quantization probability; and
> performing a summation operation on a shift result of the bit shift operation and the second information.

In a possible implementation, the probability information includes a value of a probability mass function PMF, and the value of the PMF is constructed in the following manner:
sequentially determining a value of a PMF of each of a plurality of symbols, where the plurality of symbols include the target symbol.

When a value of a PMF of the target symbol is determined, a total value of remaining PMFs other than a PMF of a determined symbol is multiplied by a probability of the target symbol, a ratio of a multiplication result of the multiplication to a remaining probability obtained by excluding the determined symbol is calculated, and the PMF of the target symbol is determined based on a relationship between the ratio and a preset fifth value.

In a possible implementation, the fifth value is 1, and the relationship is taking a larger value.

In a possible implementation, the probability information includes a value of a cumulative distribution function CDF, and the value of the CDF is constructed in the following manner:

> sequentially determining a value of a CDF of each symbol in a preset order, where the preset order is determined based on a relationship between values of PMFs corresponding to the plurality of symbols, and the plurality of symbols include the target symbol, where
> when probability distribution corresponding to the probability information of the target symbol is symmetric distribution, the preset order is an alternating order along two sides of a peak point in the symmetric distribution; or
> when probability distribution corresponding to the probability information of the target symbol is discrete distribution, the preset order is specifically a descending order; or
> when probability distribution corresponding to the probability information of the target symbol is discrete distribution, the preset order is specifically an ascending order.

In a possible implementation, the target symbol is obtained by transforming pixel data of an image, data obtained by transforming the pixel data of the image meets preset distribution, the transform is further used to obtain a distribution feature of the pixel data, and the distribution feature includes a mean value or a variance; and the obtaining module is further configured to:

determine, from a plurality of mapping relationships based on the distribution feature, the first mapping relationship corresponding to the distribution feature.

In a possible implementation, a plurality of distribution features include a first distribution feature and a second distribution feature, and an entropy of the first distribution feature is greater than an entropy of the second distribution feature; and

a value of a denominator of a quantization probability in a mapping relationship corresponding to the second distribution feature is greater than that of a denominator of a quantization probability in a mapping relationship corresponding to the first distribution feature.

In a possible implementation, the first information in the first mapping relationship is constructed in the following manner:

performing a summation operation on a preset sixth value and a quantity of leftmost bits that are consecutive Os in the value of the PMF of the target symbol; and

performing a bit shift operation on a summation result of the summation operation, and performing a subtraction operation on a shift result of the bit shift operation and a shift result of a bit shift operation performed on the value of the PMF of the target symbol, to obtain the first information; or

performing a bit shift operation on a summation result of the summation operation, performing a subtraction operation on a shift result of the bit shift operation and a shift result of a bit shift operation performed on the value of the PMF of the target symbol, and performing a summation operation on an operation result of the subtraction operation and a value M, to obtain the first information, where the probability information includes the quantization probability, and M is the denominator of the quantization probability.

In a possible implementation, the second information in the first mapping relationship is constructed in the following manner:

performing a subtraction operation on a value of a CDF of the target symbol and the value of the PMF of the target symbol, to obtain the second information; or

performing a subtraction operation on a value of a CDF of the target symbol and the value of the PMF of the target symbol, and performing a summation operation on an operation result of the subtraction operation and a value M, to obtain the second information, where the probability information includes the quantization probability, and M is the denominator of the quantization probability.

In a possible implementation, the second information in the first mapping relationship is constructed in the following manner:

when a result of a subtraction operation performed on a value of a CDF of the target symbol and the value of the PMF of the target symbol is greater than or equal to 0, using the result of the subtraction operation as the second information; or

when a result of a subtraction operation performed on a value of a CDF of the target symbol and the value of the PMF of the target symbol is less than 0, performing a summation operation on the operation result of the subtraction operation and a value M, to obtain the second information, where the probability information includes the quantization probability, and M is the denominator of the quantization probability.

In a possible implementation, the encoding module is specifically configured to:

obtain, based on the first mapping relationship, an integer value corresponding to the target symbol; and restore the integer value to the first information and the second information through a third operation, where the first information and the second information each are an integer value.

In a possible implementation, the probability information includes PMF information corresponding to each symbol, and the PMF information includes a first value and a second value; a sum of the first value and the second value is the value of the PMF; the probability information further includes CDF information corresponding to each symbol, and the CDF information includes a third value and a fourth value; and the third value and the fourth value are constructed in the following manner:

sequentially determining, in the preset order through accumulation based on first values of the plurality of symbols, a third value corresponding to each symbol; and

sequentially determining, in the preset order through accumulation based on second values and third values of the plurality of symbols, a fourth value corresponding to each symbol.

In a possible implementation, the second information includes first sub-information, second sub-information, and third sub-information.

The first sub-information in the first mapping relationship is constructed in the following manner: performing a subtraction operation on a third value of the target symbol and the value of the PMF of the target symbol, to obtain the first sub-information.

The second sub-information in the first mapping relationship is constructed in the following manner: performing a summation operation on the third value of the target symbol and a first value of the target symbol, and performing a subtraction operation on an operation result of the summation operation and 1, to obtain the second sub-information.

The third sub-information in the first mapping relationship is constructed in the following manner: performing a subtraction operation on a fourth value of the target symbol and the third value of the target symbol, and performing a subtraction operation on an operation result of the subtraction operation and the first value of the target symbol, to obtain the third sub-information.

In a possible implementation, the second operation includes:

performing a summation operation on the status information and the value M, and performing a bit shift operation on a summation result of the summation operation, where the probability information includes the quantization probability, and M is the denominator of the quantization probability; and performing a summation operation on a shift result of the bit shift operation and the first sub-information; and
when an operation result of the summation operation is greater than the second sub-information, using a summation result of the operation result of the summation operation and the third sub-information as the second encoded data; or
when an operation result of the summation operation is less than the second sub-information, using the operation result of the summation operation as the second encoded data.

In a possible implementation, when the value M is 256, the first information is stored by using 10 bits, the first sub-information is stored by using 8 bits, the second sub-information is stored by using 7 bits, the third sub-information is stored by using 7 bits, a sum of the first values of the plurality of symbols is 128, and the third sub-information is less than 128.

This application further provides a data encoding apparatus, used in an asymmetric numeral system ANS-based encoder. The apparatus includes:

an obtaining module, configured to obtain a first symbol, where a sum of a quantization probability corresponding to the first symbol and a quantization probability corresponding to a second symbol is 1, a difference between the quantization probability corresponding to the first symbol and 1 is less than a threshold, and a difference between the quantization probability corresponding to the second symbol and 0 is less than the threshold; and
an encoding module, configured to: when a value relationship between status information of the encoder and a value M meets a first condition, perform a first operation on the status information and the value M to obtain first encoded data, and update the status information to 0; or
when a value relationship between status information of the encoder and a value M does not meet a first condition, add 1 to the status information.

In a possible implementation, the obtaining module is further configured to:
obtain the second symbol.

The encoding module is further configured to: use the status information of the encoder as the first encoded data, and update the status information to a difference between the value M and 1.

The following describes, from a perspective of an apparatus, a data decoding apparatus provided in an embodiment of this application. FIG. 12 is a diagram of a structure of a data decoding apparatus according to an embodiment of this application. As shown in FIG. 12, a data decoding apparatus 1200 provided in an embodiment of this application includes:

an obtaining module 1201, configured to obtain status information of a decoder and a memory bit, where the status information corresponds to a first bit, and the first bit is a current to-be-decoded bit.

For specific descriptions of the obtaining module 1201, refer to descriptions of step 901 in the foregoing embodiments. Details are not described herein again.

The data decoding apparatus 1200 further includes a decoding module 1202, configured to determine, based on a first mapping relationship, first information, second information, and third information that correspond to the status information, where the first information is a target symbol corresponding to the first bit, the target symbol is a decoding result of the first bit, the second information indicates a quantity of bits selected from the memory bit, the third information is used to perform a summation operation with a bit selected from the memory bit based on the third information, a result of the summation operation is used to update the status information, updated status information corresponds to a second bit, and the second bit is a to-be-decoded bit after the first bit.

For specific descriptions of the decoding module 1202, refer to descriptions of step 902 in the foregoing embodiments. Details are not described herein again.

In a possible implementation, the decoding module is further configured to:

remove, from the memory bit, the selected bit, to obtain an updated memory bit.

In a possible implementation, the first information, the second information, or the third information represents an integer value.

In a possible implementation, the first information in the first mapping relationship is constructed in the following manner:

using x that satisfies $C(x) \leq s < (C(x) + P(x))$ as the first information, where C represents a value of a CDF, P represents a value of a PMF, and s represents the status information; or

using x that satisfies $C1(x) \leq s < C1(x) + P1(x)$ or $C2(x) \leq s < C2(x) + P2(x)$ as the first information, where C1 represents a third value corresponding to a CDF, P1 represents a first value corresponding to a PMF, C2 represents a fourth value corresponding to the CDF, P2 represents a second value corresponding to the PMF, s represents the status information, and a sum of the first value and the second value is a value of the PMF.

In a possible implementation, the second information in the first mapping relationship is constructed in the following manner:

using a value of $clz(s - C(x) + P(x)) + X$ as the second information, where clz represents taking a quantity of leftmost bits that are consecutive 0s in a value, and X is a preset fifth value; or

performing a bit shift operation on a value of $s - C(x) + P(x)$, to obtain the third information, where a shift quantity of the bit shift operation is obtained based on the second information; or

performing a bit shift operation on a value of $s - C(x) + P(x)$, and subtracting a value M from an operation result of the bit shift operation, to obtain the third information, where M is a denominator of the quantization probability, and a shift quantity of the bit shift operation is obtained based on the second information; or

using a value of $clz(s' - C(x) + P(x)) + X$ as the second information, where clz represents taking a quantity of leftmost bits that are consecutive 0s in a value, X is a preset fifth value, and s' is obtained in the following manner:

if $C2(x) \leq s$, $s' = P1(x) + s - C2(x) + P(x)$; or if $C2(x) > s$, $s' = s - C1(x) + P(x)$.

In a possible implementation, the third information in the first mapping relationship is constructed in the following manner:

performing the bit shift operation on the value of $s - C(x) + P(x)$, to obtain the third information, where the shift quantity of the bit shift operation is obtained based on the second information; or

performing the bit shift operation on the value of $s - C(x) + P(x)$, and subtracting the value M from the operation result of the bit shift operation, to obtain the third information, where M is the denominator of the quantization probability, and the shift quantity of the bit shift operation is obtained based on the second information; or

performing a bit shift operation on a value of $s' - C(x) + P(x)$, to obtain the third information, where a shift quantity of the bit shift operation is obtained based on the second information.

In a possible implementation, the first information, the second information, or the third information is obtained based on probability information, the probability information includes a value of a probability mass function PMF, and the value of the PMF is constructed in the following manner:

sequentially determining a value of a PMF of each of a plurality of symbols, where the plurality of symbols include the target symbol.

When a value of a PMF of the target symbol is determined, a total value of remaining PMFs other than a PMF of a determined symbol is multiplied by a probability of the target symbol, a ratio of a multiplication result of the multiplication to a remaining probability obtained by excluding the determined symbol is calculated, and the PMF of the target symbol is determined based on a relationship between the ratio and a preset value.

In a possible implementation, the preset value is 1, and the relationship is taking a larger value.

In a possible implementation, the first information, the second information, or the third information is obtained based on the probability information, the probability information includes the value of the cumulative distribution function CDF, and the value of the CDF is constructed in the following manner:

sequentially determining a value of a CDF of each symbol in a preset order, where the preset order is determined based on a relationship between values of PMFs corresponding to the plurality of symbols, and the plurality of symbols include the target symbol, where

when probability distribution corresponding to the probability information of the target symbol is symmetric distribution, the preset order is an alternating order along two sides of a peak point in the symmetric distribution; or

when probability distribution corresponding to the probability information of the target symbol is discrete distribution, the preset order is specifically a descending order; or

when probability distribution corresponding to the probability information of the target symbol is discrete distribution, the preset order is specifically an ascending order.

In a possible implementation, the obtaining module is further configured to:

obtain an encoding result, where the encoding result is obtained by encoding pixel data of an image, and the status information and the memory bit are obtained based on the encoding result;

process the encoding result, to obtain a distribution feature of the pixel data, where the distribution feature includes a mean value or a variance; and

determine, from a plurality of mapping relationships based on the distribution feature, the first mapping relationship corresponding to the distribution feature.

This application further provides a data decoding apparatus, used in an asymmetric numeral system ANS-based decoder. The apparatus includes:

an obtaining module, configured to obtain status information of the decoder, where the status information corresponds to a first bit, and the first bit is a current to-be-decoded bit; and

a decoding module, configured to: if the status information is a difference between a value M and 1, determine that a decoding result of the first bit is a second symbol, and update the status information to a result of reading the value M bits from a memory bit; or

if the status information is not a difference between a value M and 1, determine that a decoding result of the first bit is a first symbol; and if the status information is 0, update the status information to a summation result of a difference between the value M and 2 and a value of 1 bit read from the memory bit; or if the status information is not 0, update the status information to a difference between the status information and 1, where updated status information corresponds to a second bit, and the second bit is a to-be-decoded bit after the first bit.

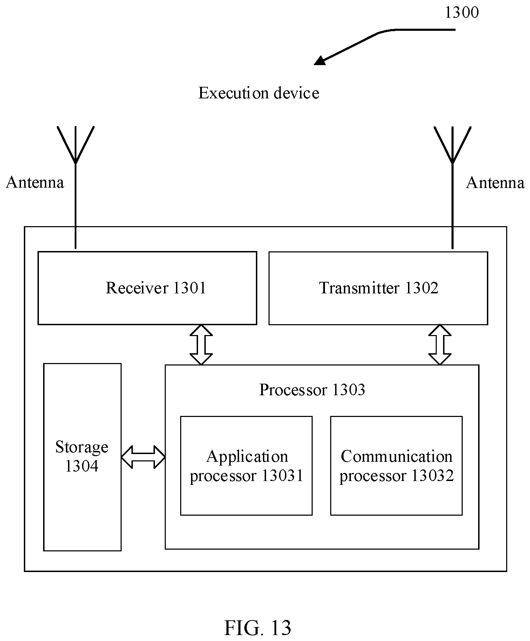

The following describes an execution device provided in an embodiment of this application. FIG. 13 is a diagram of a structure of an execution device according to an embodiment of this application. An execution device 1300 may be specifically a mobile phone, a tablet computer, a notebook computer, an intelligent wearable device, a server, or the like. This is not limited herein. The execution device 1300 implements functions of the data encoding method and the data decoding method in the embodiments corresponding to FIG. 6 and FIG. 9. Specifically, the execution device 1300 includes a receiver 1301, a transmitter 1302, a processor 1303, and a storage 1304 (there may be one or more processors 1303 in the execution device 1300). The processor 1303 may include an application processor 13031 and a communication processor 13032. In some embodiments of this application, the receiver 1301, the transmitter 1302, the processor 1303, and the storage 1304 may be connected through a bus or in another manner.

The storage 1304 may include a read-only memory and a random access memory, and provide instructions and data to the processor 1303. A part of the storage 1304 may further include a non-volatile random access memory (non-volatile random access memory, NVRAM). The storage 1304 stores a processor and operation instructions, an executable module or a data structure, a subset thereof, or an extended set thereof. The operation instructions may include various operation instructions for implementing various operations.

The processor 1303 controls an operation of the execution device. In a specific application, components of the execution device are coupled together through a bus system. In addition to a data bus, the bus system may further include a power bus, a control bus, a status signal bus, and the like. However, for clear description, various types of buses in the figure are referred to as the bus system.

The methods disclosed in the foregoing embodiments of this application may be applied to the processor 1303, or may be implemented by the processor 1303. The processor 1303 may be an integrated circuit chip and has a signal processing capability. In an implementation process, steps in the foregoing methods can be implemented by using a hardware integrated logic circuit in the processor 1303, or by using instructions in a form of software. The processor 1303 may be a processor applicable to an AI operation, such as a general-purpose processor, a digital signal processor (digital signal processing, DSP), a microprocessor or a microcontroller, a vision processing unit (vision processing unit, VPU), or a tensor processing unit (tensor processing unit, TPU), and may further include an application-specific integrated circuit (application-specific integrated circuit, ASIC), a field programmable gate array (field-programmable gate array, FPGA) or another programmable logic device, a discrete gate or transistor logic device, or a discrete hardware component. The processor 1303 may implement or perform the methods, steps, and logic block diagrams disclosed in embodiments of this application. The general-purpose processor may be a microprocessor, or the processor may be any conventional processor or the like. The steps in the methods disclosed with reference to embodiments of this application may be directly performed and completed by a hardware decoding processor, or may be performed and completed by using a combination of hardware and a software module in a decoding processor. The software module may be located in a mature storage medium in the art, such as a random access memory, a flash memory, a read-only memory, a programmable read-only memory, an electrically erasable programmable memory, or a register. The storage medium is located in the storage 1304. The processor 1303 reads information in the storage 1304, and completes, in combination with hardware of the processor 1303, the data encoding method and the data decoding method in the embodiments corresponding to FIG. 6 and FIG. 9.

The receiver 1301 may be configured to: receive input digital or character information, and generate signal input related to related setting and function control of the execution device. The transmitter 1302 may be configured to output digit or character information through a first interface. The transmitter 1302 may be further configured to send instructions to a disk group through the first interface, to modify data in the disk group. The transmitter 1302 may further include a display device such as a display.

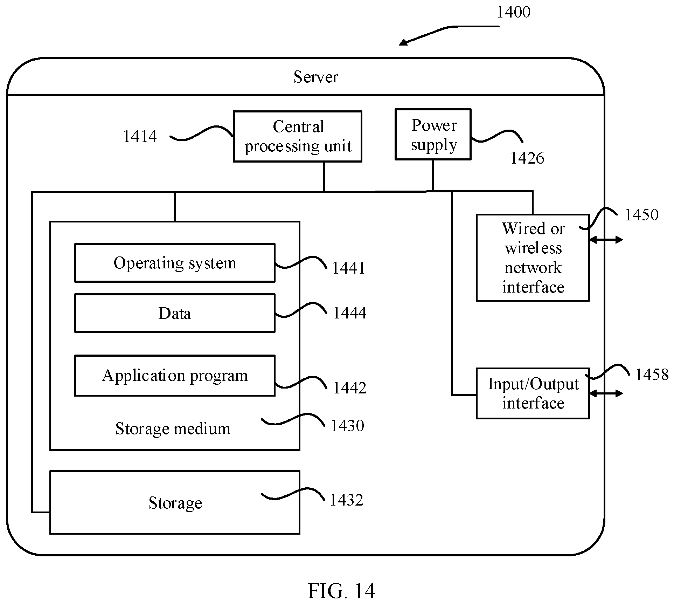

An embodiment of this application further provides a training device. FIG. 14 is a diagram of a structure of a server according to an embodiment of this application. Specifically, a server 1400 is implemented by one or more servers, and the server 1400 may vary greatly due to different configurations or performance, and may include one or more central processing units (central processing units, CPU) 1414 (for example, one or more processors), a storage 1432, and one or more storage media 1430 (for example, one or more mass storage devices) that store an application program 1442 or data 1444. The storage 1432 and the storage medium 1430 may be transient storage or persistent storage. A program stored in the storage medium 1430 may include one or more modules (not shown in the figure), and each module may include a series of instruction operations of the server. Further, the central processing unit 1414 may be configured to: communicate with the storage medium 1430, and perform, on the server 1400, a series of instruction operations in the storage medium 1430.

The server 1400 may further include one or more power supplies 1426, one or more wired or wireless network interfaces 1450, one or more input/output interfaces 1458, or one or more operating systems 1441, for example, Windows ServerTM, Mac OS XTM, UnixTM, LinuxTM, and FreeBSDTM.

Specifically, the server may perform steps related to model training in the foregoing embodiments.

An embodiment of this application further provides a computer program product. When the computer program product runs on a computer, the computer is enabled to perform the data encoding method and the data decoding method in the embodiments corresponding to FIG. 6 and FIG. 9.

An embodiment of this application further provides a computer-readable storage medium. The computer-readable storage medium stores a program used for signal processing, and when the program is run on a computer, the computer is enabled to perform the data encoding method and the data decoding method in the embodiments corresponding to FIG. 6 and FIG. 9.

The execution device, the training device, or the terminal device provided in embodiments of this application may be specifically a chip. The chip includes a processing unit and a communication unit. The processing unit may be, for example, a processor. The communication unit may be, for example, an input/output interface, a pin, or a circuit. The processing unit may execute computer-executable instructions stored in a storage unit, so that a chip in an execution device performs the data processing method described in the foregoing embodiments, or a chip in a training device performs the data processing method described in the foregoing embodiments. Optionally, the storage unit is a storage unit in the chip, for example, a register or a cache; or the storage unit may be a storage unit that is in a radio access device and that is located outside the chip, for example, a read-only memory (read-only memory, ROM), another type of static storage device that can store static information and instructions, a random access memory (random access memory, RAM), or the like.

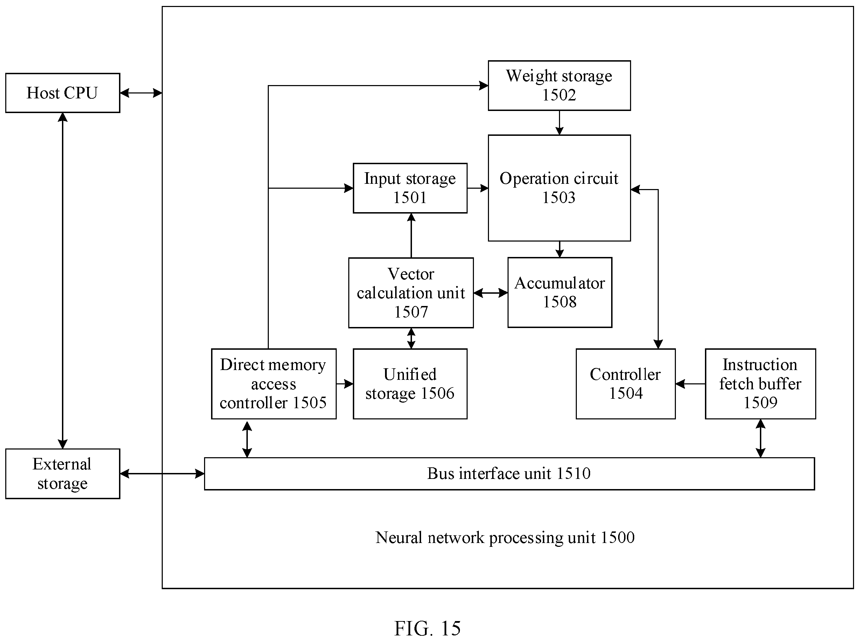

Specifically, FIG. 15 is a diagram of a structure of a chip according to an embodiment of this application. The chip may be represented as a neural network processing unit NPU 1500. The NPU 1500 is mounted to a host CPU (Host CPU) as a coprocessor, and the host CPU allocates a task. A core part of the NPU is an operation circuit 1503, and a controller 1504 controls the operation circuit 1503 to extract matrix data in a storage and perform a multiplication operation.

The NPU 1500 may implement the data encoding method and the data decoding method in embodiments corresponding to FIG. 6 and FIG. 9 through mutual cooperation between internal components.

More specifically, in some implementations, the operation circuit 1503 in the NPU 1500 includes a plurality of processing units (Process Engine, PE). In some implementations, the operation circuit 1503 is a two-dimensional systolic array. The operation circuit 1503 may alternatively be a one-dimensional systolic array or another electronic circuit that can perform mathematical operations such as multiplication and summation. In some implementations, the operation circuit 1503 is a general-purpose matrix processor.

For example, it is assumed that there is an input matrix A, a weight matrix B, and an output matrix C. The operation circuit fetches corresponding data of the matrix B from a weight storage 1502, and buffers the data on each PE in the operation circuit. The operation circuit obtains data of the matrix A from an input storage 1501 to perform a matrix operation with the matrix B, to obtain a partial result or a final result of the matrix, where the result is stored into an accumulator (accumulator) 1508.

A unified storage 1506 is configured to store input data and output data. Weight data is directly transferred to the weight storage 1502 by using a direct memory access controller (Direct Memory Access Controller, DMAC) DMAC 1505. The input data is also transferred to the unified storage 1506 through the DMAC.

A BIU is a bus interface unit, that is, a bus interface unit 1510, is configured for interaction between an AXI bus and the DMAC and interaction between the AXI bus and an instruction fetch buffer (Instruction Fetch Buffer, IFB) 1509.

The bus interface unit 1510 (Bus Interface Unit, BIU for short) is used by the instruction fetch buffer 1509 to obtain instructions from an external storage, and is further used by the direct memory access controller 1505 to obtain original data of the input matrix A or the weight matrix B from the external storage.

The DMAC is mainly configured to transfer input data in the external storage DDR to the unified storage 1506, transfer weight data to the weight storage 1502, or transfer input data to the input storage 1501.

A vector calculation unit 1507 includes a plurality of operation processing units. If required, the vector calculation unit 1507 further processes an output of the operation circuit 1503, for example, performs vector multiplication, vector summation, an exponential operation, a logarithmic operation, or size comparison. The vector calculation unit 1507 is mainly used for non-convolutional/fully connected layer network calculation in a neural network, such as batch normalization (batch normalization), pixel-level summation, and upsampling of a feature map.

In some implementations, the vector calculation unit 1507 can store a processed output vector in the unified storage 1506. For example, the vector calculation unit 1507 may apply a linear function or a non-linear function to the output of the operation circuit 1503, for example, perform linear interpolation on a feature plane extracted by a convolutional layer, for another example, accumulate vectors of values, to generate an activation value. In some implementations, the vector calculation unit 1507 generates a normalized value, a pixel-level summation value, or both a normalized value and a pixel-level summation value. In some implementations, a processed output vector can be used as an activation input to the operation circuit 1503, for example, used at a subsequent layer in the neural network.

The instruction fetch buffer (instruction fetch buffer) 1509 connected to the controller 1504 is configured to store instructions used by the controller 1504.

The unified storage 1506, the input storage 1501, the weight storage 1502, and the instruction fetch buffer 1509 are all on-chip storages. The external storage is private to a hardware architecture of the NPU.

Any one of the processors mentioned above may be a general-purpose central processing unit, a microprocessor, an ASIC, or one or more integrated circuits for controlling program execution.

In addition, it should be noted that the described apparatus embodiment is merely an example. The units described as separate parts may or may not be physically separate, and parts displayed as units may or may not be physical units, may be located in one position, or may be distributed on a plurality of network units. Some or all the modules may be selected according to actual needs to achieve the objectives of the solutions of embodiments. In addition, in the accompanying drawings of the apparatus embodiments provided by this application, connection relationships between modules indicate that the modules have communication connections with each other, and may be specifically implemented as one or more communication buses or signal cables.

Based on the descriptions of the foregoing implementations, a person skilled in the art may clearly understand that this application may be implemented by software in addition to necessary universal hardware, or by dedicated hardware, including a dedicated integrated circuit, a dedicated CPU, a dedicated storage, a dedicated component, and the like. Generally, any functions that can be performed by a computer program can be easily implemented by using corresponding hardware. Moreover, specific hardware structures used to achieve a same function may be in various forms, for example, in a form of an analog circuit, a digital circuit, or a dedicated circuit. However, as for this application, software program implementation is a better implementation in most cases. Based on such an understanding, the technical solutions of this application essentially or the part contributing to the conventional technology may be implemented in a form of a software product. The computer software product is stored in a readable storage medium, for example, a floppy disk, a USB flash drive, a removable hard disk, a ROM, a RAM, a magnetic disk, or an optical disc of a computer, and includes several instructions for instructing a computer device (which may be a personal computer, a training device, a network device, or the like) to perform the methods in embodiments of this application.

All or some of the foregoing embodiments may be implemented by using software, hardware, firmware, or any combination thereof. When the foregoing embodiments are implemented by using software, all or some of the embodiments may be implemented in a form of a computer program product.

The computer program product includes one or more computer instructions. When the computer program instructions are loaded and executed on the computer, the procedures or functions according to embodiments of this application are all or partially generated. The computer may be a general-purpose computer, a dedicated computer, a computer network, or other programmable apparatuses. The computer instructions may be stored in a computer-readable storage medium, or may be transmitted from a computer-readable storage medium to another computer-readable storage medium. For example, the computer instructions may be transmitted from a website, computer, training device, or data center to another website, computer, training device, or data center in a wired (for example, a coaxial cable, an optical fiber, or a digital subscriber line (DSL)) or wireless (for example, infrared, radio, or microwave) manner. The computer-readable storage medium may be any usable medium that can be stored by a computer, or a data storage device, such as a training device or a data center, integrating one or more usable media. The usable medium may be a magnetic medium (for example, a floppy disk, a hard disk, or a magnetic tape), an optical medium (for example, a DVD), a semiconductor medium (for example, a solid state disk (Solid State Disk, SSD)), or the like.

**Claims**

1. A data encoding method, applied to an asymmetric numeral system ANS-based encoder, wherein the method comprises:

   obtaining a target symbol;
   obtaining, based on a first mapping relationship, first information and second information that correspond to the target symbol, wherein the first information and the second information are obtained based on probability information corresponding to the target symbol;
   obtaining first encoded data through a first operation based on the first information and status information of the encoder; and
   updating the status information through a second operation based on the second information, to obtain second encoded data, wherein
   the first encoded data and the second encoded data are used to obtain an encoding result of the target symbol, and the first operation and the second operation do not comprise a division operation.

2. The method according to claim 1, wherein the first information or the second information represents an integer value.

3. The method according to claim 1 or 2, wherein the first operation and the second operation do not comprise a judgment operation.

4. The method according to any one of claims 1 to 3, wherein the first operation comprises:
   performing a summation operation on the first information and the status information, and performing a bit shift operation on a summation result of the summation operation; and selecting some bits from the status information as the first encoded data, wherein locations of the some bits in the status information are determined based on a shift result of the bit shift operation.

5. The method according to any one of claims 1 to 4, wherein the second operation comprises:

   performing a summation operation on the status information and a value M, and performing a bit shift operation on a summation result of the summation operation, wherein the probability information comprises a quantization probability, and M is a denominator of the quantization probability; and performing a summation operation on a shift result of the bit shift operation and the second information; or
   when the status information is initialized to M, performing a bit shift operation on the status information; performing a summation operation on a shift result of the bit shift operation and the second information; and performing a subtraction operation on a summation result of the summation operation and M.

6. The method according to any one of claims 1 to 5, wherein the probability information comprises a value of a probability mass function PMF, and the value of the PMF is constructed in the following manner:

   sequentially determining a value of a PMF of each of a plurality of symbols, wherein the plurality of symbols comprise the target symbol, wherein
   when a value of a PMF of the target symbol is determined, a total value of remaining PMFs other than a PMF of a determined symbol is multiplied by a probability of the target symbol, a ratio of a multiplication result of the multiplication to a remaining probability obtained by excluding the determined symbol is calculated, and the PMF of the target symbol is determined based on a relationship between the ratio and a preset fifth value.

7. The method according to claim 6, wherein the first value is 1, and the relationship is taking a larger value.

8. The method according to any one of claims 1 to 7, wherein the probability information comprises a value of a cumulative distribution function CDF, and the value of the CDF is constructed in the following manner:

   sequentially determining a value of a CDF of each symbol in a preset order, wherein the preset order is determined based on a relationship between values of PMFs corresponding to the plurality of symbols, and the plurality of symbols comprise the target symbol, wherein
   when probability distribution corresponding to the probability information of the target symbol is symmetric distribution, the preset order is an alternating order along two sides of a peak point in the symmetric distribution; or
   when probability distribution corresponding to the probability information of the target symbol is discrete distribution, the preset order is specifically a descending order; or
   when probability distribution corresponding to the probability information of the target symbol is discrete distribution, the preset order is specifically an ascending order.

9. The method according to any one of claims 1 to 8, wherein the target symbol is obtained by transforming pixel data of an image, data obtained by transforming the pixel data of the image meets preset distribution, the transform is further used to obtain a distribution feature of the pixel data, and the distribution feature comprises a mean value or a variance; and the method further comprises:
   determining, from a plurality of mapping relationships based on the distribution feature, the first mapping relationship corresponding to the distribution feature.

10. The method according to claim 9, wherein the plurality of distribution features comprise a first distribution feature and a second distribution feature, and an entropy of the first distribution feature is greater than an entropy of the second distribution feature; and
    a value of a denominator of a quantization probability in a mapping relationship corresponding to the second distribution feature is greater than that of a denominator of a quantization probability in a mapping relationship corresponding to the first distribution feature.

11. The method according to any one of claims 1 to 10, wherein the first information in the first mapping relationship is constructed in the following manner:

    performing a summation operation on a preset sixth value and a quantity of leftmost bits that are consecutive Os in the value of the PMF of the target symbol; and
    performing a bit shift operation on a summation result of the summation operation, and performing a subtraction operation on a shift result of the bit shift operation and a shift result of a bit shift operation performed on the value of the PMF of the target symbol, to obtain the first information; or
    performing a bit shift operation on a summation result of the summation operation, performing a subtraction operation on a shift result of the bit shift operation and a shift result of a bit shift operation performed on the value of the PMF of the target symbol, and performing a summation operation on an operation result of the subtraction operation and the value M, to obtain the first information, wherein the probability information comprises the quantization probability, and M is the denominator of the quantization probability.

12. The method according to any one of claims 1 to 11, wherein the second information in the first mapping relationship is constructed in the following manner:

    performing a subtraction operation on a value of a CDF of the target symbol and the value of the PMF of the target symbol, to obtain the second information; or
    performing a subtraction operation on a value of a CDF of the target symbol and the value of the PMF of the target symbol, and performing a summation operation on an operation result of the subtraction operation and the value M, to obtain the second information, wherein the probability information comprises the quantization probability, and M is the denominator of the quantization probability.

13. The method according to any one of claims 1 to 11, wherein the second information in the first mapping relationship is constructed in the following manner:

    when a result of a subtraction operation performed on a value of a CDF of the target symbol and the value of the PMF of the target symbol is greater than or equal to 0, using the result of the subtraction operation as the second information; or

when a result of a subtraction operation performed on a value of a CDF of the target symbol and the value of the PMF of the target symbol is less than 0, performing a summation operation on the operation result of the subtraction operation and the value M, to obtain the second information, wherein the probability information comprises the quantization probability, and M is the denominator of the quantization probability.

14. The method according to any one of claims 1 to 13, wherein obtaining, based on the first mapping relationship, the first information and the second information that correspond to the target symbol comprises:

obtaining, based on the first mapping relationship, an integer value corresponding to the target symbol; and restoring the integer value to the first information and the second information through a third operation, wherein the first information and the second information each are an integer value.

15. The method according to any one of claims 1 to 14, wherein the probability information comprises PMF information corresponding to each symbol, and the PMF information comprises a first value and a second value; a sum of the first value and the second value is the value of the PMF; the probability information further comprises CDF information corresponding to each symbol, and the CDF information comprises a third value and a fourth value; and the third value and the fourth value are constructed in the following manner:

sequentially determining, in the preset order through accumulation based on first values of the plurality of symbols, a third value corresponding to each symbol; and sequentially determining, in the preset order through accumulation based on second values and third values of the plurality of symbols, a fourth value corresponding to each symbol.

16. The method according to claim 15, wherein the second information comprises first sub-information, second sub-information, and third sub-information, wherein

the first sub-information in the first mapping relationship is constructed in the following manner: performing a subtraction operation on a third value of the target symbol and the value of the PMF of the target symbol, to obtain the first sub-information; the second sub-information in the first mapping relationship is constructed in the following manner: performing a summation operation on the third value of the target symbol and a first value of the target symbol, and performing a subtraction operation on an operation result of the summation operation and 1, to obtain the second sub-information; and the third sub-information in the first mapping relationship is constructed in the following manner: performing a subtraction operation on a fourth value of the target symbol and the third value of the target symbol, and performing a subtraction operation on an operation result of the subtraction operation and the first value of the target symbol, to obtain the third sub-information.

17. The method according to claim 16, wherein the second operation comprises:

performing the summation operation on the status information and the value M, and performing the bit shift operation on the summation result of the summation operation, wherein the probability information comprises the quantization probability, and M is the denominator of the quantization probability; and performing a summation operation on the shift result of the bit shift operation and the first sub-information; and when an operation result of the summation operation is greater than the second sub-information, using a summation result of the operation result of the summation operation and the third sub-information as the second encoded data; or when an operation result of the summation operation is less than the second sub-information, using the operation result of the summation operation as the second encoded data.

18. The method according to claim 16 or 17, wherein when the value M is 256, the first information is stored by using 10 bits, the first sub-information is stored by using 8 bits, the second sub-information is stored by using 7 bits, the third sub-information is stored by using 7 bits, a sum of the first values of the plurality of symbols is 128, and the third sub-information is less than 128.

19. A data encoding method, applied to an asymmetric numeral system ANS-based encoder, wherein the method comprises:

obtaining a first symbol, wherein a sum of a quantization probability corresponding to the first symbol and a quantization probability corresponding to a second symbol is 1, a difference between the quantization probability corresponding to the first symbol and 1 is less than a threshold, and a difference between the quantization probability corresponding to the second symbol and 0 is less than the threshold; and

when a value relationship between status information of the encoder and a value M meets a first condition, performing a first operation on the status information and the value M to obtain first encoded data, and updating the status information to 0; or

when a value relationship between status information of the encoder and a value M does not meet a first condition, adding 1 to the status information.

20. The method according to claim 19, wherein the method further comprises:

obtaining the second symbol; and
using the status information of the encoder as the first encoded data, and updating the status information to a difference between the value M and 1.

21. A data decoding method, applied to an asymmetric numeral system ANS-based decoder, wherein the method comprises:

obtaining status information of the decoder and a memory bit, wherein the status information corresponds to a first bit, and the first bit is a current to-be-decoded bit; and

determining, based on a first mapping relationship, first information, second information, and third information that correspond to the status information, wherein the first information is a target symbol corresponding to the first bit, the target symbol is a decoding result of the first bit, the second information indicates a quantity of bits selected from the memory bit, the third information is used to perform a summation operation with a bit selected from the memory bit based on the third information, a result of the summation operation is used to update the status information, updated status information corresponds to a second bit, and the second bit is a to-be-decoded bit after the first bit.

22. The method according to claim 21, wherein the method further comprises:
removing, from the memory bit, the selected bit, to obtain an updated memory bit.

23. The method according to claim 21 or 22, wherein the first information, the second information, or the third information represents an integer value.

24. The method according to any one of claims 21 to 23, wherein the first information in the first mapping relationship is constructed in the following manner:
using x that satisfies $C(x) \leq s < (C(x) + P(x))$ as the first information, wherein C represents a value of a CDF, P represents a value of a PMF, and s represents the status information.

25. The method according to any one of claims 21 to 23, wherein the first information in the first mapping relationship is constructed in the following manner:
using x that satisfies $C1(x) \leq s < C1(x) + P1(x)$ or $C2(x) \leq s < C2(x) + P2(x)$ as the first information, wherein C1 represents a third value corresponding to a CDF, P1 represents a first value corresponding to a PMF, C2 represents a fourth value corresponding to the CDF, P2 represents a second value corresponding to the PMF, s represents the status information, and a sum of the first value and the second value is a value of the PMF.

26. The method according to any one of claims 21 to 25, wherein the second information in the first mapping relationship is constructed in the following manner:
using a value of $clz(s - C(x) + P(x)) + X$ as the second information, wherein clz represents taking a quantity of leftmost bits that are consecutive Os in a value, and X is a preset fifth value.

27. The method according to any one of claims 21 to 25, wherein the second information in the first mapping relationship is constructed in the following manner:
using a value of $clz(s' - C(x) + P(x)) + X$ as the second information, wherein clz represents taking a quantity of leftmost bits that are consecutive Os in a value, X is a preset fifth value, and s' is obtained in the following manner:
if $C2(x) \leq s$, $s' = P1(x) + s - C2(x) + P(x)$; or if $C2(x) > s$, $s' = s - C1(x) + P(x)$.

28. The method according to any one of claims 21 to 27, wherein the third information in the first mapping relationship is constructed in the following manner:

performing a bit shift operation on a value of s - C(x) + P(x), to obtain the third information, wherein a shift quantity of the bit shift operation is obtained based on the second information; or

performing a bit shift operation on a value of s - C(x) + P(x), and subtracting a value M from an operation result of the bit shift operation, to obtain the third information, wherein M is a denominator of the quantization probability, and a shift quantity of the bit shift operation is obtained based on the second information; or

performing a bit shift operation on a value of s' - C(x) + P(x), to obtain the third information, wherein a shift quantity of the bit shift operation is obtained based on the second information.

29. The method according to any one of claims 21 to 28, wherein the first information, the second information, or the third information is obtained based on probability information; the probability information comprises the value of the probability mass function PMF; and the value of the PMF is constructed in the following manner:

sequentially determining a value of a PMF of each of a plurality of symbols, wherein the plurality of symbols comprise the target symbol, wherein

when a value of a PMF of the target symbol is determined, a total value of remaining PMFs other than a PMF of a determined symbol is multiplied by a probability of the target symbol, a ratio of a multiplication result of the multiplication to a remaining probability obtained by excluding the determined symbol is calculated, and the PMF of the target symbol is determined based on a relationship between the ratio and a preset value.

30. The method according to any one of claims 21 to 29, wherein the first information, the second information, or the third information is obtained based on the probability information, the probability information comprises the value of the cumulative distribution function CDF, and the value of the CDF is constructed in the following manner:

sequentially determining a value of a CDF of each symbol in a preset order, wherein the preset order is determined based on a relationship between values of PMFs corresponding to the plurality of symbols, and the plurality of symbols comprise the target symbol, wherein

when probability distribution corresponding to the probability information of the target symbol is symmetric distribution, the preset order is an alternating order along two sides of a peak point in the symmetric distribution; or

when probability distribution corresponding to the probability information of the target symbol is discrete distribution, the preset order is specifically a descending order; or

when probability distribution corresponding to the probability information of the target symbol is discrete distribution, the preset order is specifically an ascending order.

31. The method according to any one of claims 21 to 30, wherein the method further comprises:

obtaining an encoding result, wherein the encoding result is obtained by encoding pixel data of an image, and the status information and the memory bit are obtained based on the encoding result;

processing the encoding result, to obtain a distribution feature of the pixel data, wherein the distribution feature comprises a mean value or a variance; and

determining, from a plurality of mapping relationships based on the distribution feature, the first mapping relationship corresponding to the distribution feature.

32. The method according to any one of claims 21 to 31, wherein determining, based on the first mapping relationship, the first information, the second information, and the third information that correspond to the status information comprises:

obtaining, based on the first mapping relationship, an integer value corresponding to the status information; and

restoring the integer value to the first information, the second information, and the third information, wherein the first information, the second information, and the third information each are an integer value.

33. A data decoding method, applied to an asymmetric numeral system ANS-based decoder, wherein the method comprises:

obtaining status information of the decoder, wherein the status information corresponds to a first bit, and the first bit is a current to-be-decoded bit; and

if the status information is a difference between a value M and 1, determining that a decoding result of the first bit is a second symbol, and updating the status information to a result of reading the value M bits from a memory bit; or if the status information is not a difference between a value M and 1, determining that a decoding result of the first bit is a first symbol; and if the status information is 0, updating the status information to a summation result of a difference between the value M and 2 and a value of 1 bit read from the memory bit; or if the status information is not 0, updating the status information to a difference between the status information and 1, wherein updated status information corresponds to a second bit, and the second bit is a to-be-decoded bit after the first bit.

34. A data encoding apparatus, used in an asymmetric numeral system ANS-based encoder, wherein the apparatus comprises:

an obtaining module, configured to obtain a target symbol; and
an encoding module, configured to: obtain, based on a first mapping relationship, first information and second information that correspond to the target symbol, wherein the first information and the second information are obtained based on probability information corresponding to the target symbol;
obtain first encoded data through a first operation based on the first information and status information of the encoder; and
update the status information through a second operation based on the second information, to obtain second encoded data, wherein
the first encoded data and the second encoded data are used to obtain an encoding result of the target symbol, and the first operation and the second operation do not comprise a division operation.

35. The apparatus according to claim 34, wherein the first information or the second information represents an integer value.

36. The apparatus according to claim 34 or 35, wherein the first operation and the second operation do not comprise a judgment operation.

37. The apparatus according to any one of claims 34 to 36, wherein the first operation comprises:

performing a summation operation on the first information and the status information, and performing a bit shift operation on a summation result of the summation operation; and
selecting some bits from the status information as the first encoded data, wherein locations of the some bits in the status information are determined based on a shift result of the bit shift operation.

38. The apparatus according to any one of claims 34 to 37, wherein the second operation comprises:

performing a summation operation on the status information and a value M, and performing a bit shift operation on a summation result of the summation operation, wherein the probability information comprises a quantization probability, and M is a denominator of the quantization probability; and
performing a summation operation on a shift result of the bit shift operation and the second information.

39. The apparatus according to any one of claims 34 to 38, wherein the probability information comprises a value of a probability mass function PMF, and the value of the PMF is constructed in the following manner:

sequentially determining a value of a PMF of each of a plurality of symbols, wherein the plurality of symbols comprise the target symbol, wherein
when a value of a PMF of the target symbol is determined, a total value of remaining PMFs other than a PMF of a determined symbol is multiplied by a probability of the target symbol, a ratio of a multiplication result of the multiplication to a remaining probability obtained by excluding the determined symbol is calculated, and the PMF of the target symbol is determined based on a relationship between the ratio and a preset fifth value.

40. The apparatus according to claim 39, wherein the fifth value is 1, and the relationship is taking a larger value.

41. The apparatus according to any one of claims 34 to 40, wherein the probability information comprises a value of a cumulative distribution function CDF, and the value of the CDF is constructed in the following manner:

sequentially determining a value of a CDF of each symbol in a preset order, wherein the preset order is determined based on a relationship between values of PMFs corresponding to the plurality of symbols, and the plurality of symbols comprise the target symbol, wherein

when probability distribution corresponding to the probability information of the target symbol is symmetric distribution, the preset order is an alternating order along two sides of a peak point in the symmetric distribution; or

when probability distribution corresponding to the probability information of the target symbol is discrete distribution, the preset order is specifically a descending order; or

when probability distribution corresponding to the probability information of the target symbol is discrete distribution, the preset order is specifically an ascending order.

42. The apparatus according to any one of claims 34 to 41, wherein the target symbol is obtained by transforming pixel data of an image, data obtained by transforming the pixel data of the image meets preset distribution, the transform is further used to obtain a distribution feature of the pixel data, and the distribution feature comprises a mean value or a variance; and the obtaining module is further configured to:

determine, from a plurality of mapping relationships based on the distribution feature, the first mapping relationship corresponding to the distribution feature.

43. The apparatus according to claim 42, wherein the plurality of distribution features comprise a first distribution feature and a second distribution feature, and an entropy of the first distribution feature is greater than an entropy of the second distribution feature; and

a value of a denominator of a quantization probability in a mapping relationship corresponding to the second distribution feature is greater than that of a denominator of a quantization probability in a mapping relationship corresponding to the first distribution feature.

44. The apparatus according to any one of claims 34 to 43, wherein the first information in the first mapping relationship is constructed in the following manner:

performing a summation operation on a preset sixth value and a quantity of leftmost bits that are consecutive Os in the value of the PMF of the target symbol; and

performing a bit shift operation on a summation result of the summation operation, and performing a subtraction operation on a shift result of the bit shift operation and a shift result of a bit shift operation performed on the value of the PMF of the target symbol, to obtain the first information; or

performing a bit shift operation on a summation result of the summation operation, performing a subtraction operation on a shift result of the bit shift operation and a shift result of a bit shift operation performed on the value of the PMF of the target symbol, and performing a summation operation on an operation result of the subtraction operation and the value M, to obtain the first information, wherein the probability information comprises the quantization probability, and M is the denominator of the quantization probability.

45. The apparatus according to any one of claims 34 to 44, wherein the second information in the first mapping relationship is constructed in the following manner:

performing a subtraction operation on a value of a CDF of the target symbol and the value of the PMF of the target symbol, to obtain the second information; or

performing a subtraction operation on a value of a CDF of the target symbol and the value of the PMF of the target symbol, and performing a summation operation on an operation result of the subtraction operation and the value M, to obtain the second information, wherein the probability information comprises the quantization probability, and M is the denominator of the quantization probability.

46. The apparatus according to any one of claims 34 to 44, wherein the second information in the first mapping relationship is constructed in the following manner:

when a result of a subtraction operation performed on a value of a CDF of the target symbol and the value of the PMF of the target symbol is greater than or equal to 0, using the result of the subtraction operation as the second information; or

when a result of a subtraction operation performed on a value of a CDF of the target symbol and the value of the PMF of the target symbol is less than 0, performing a summation operation on the operation result of the subtraction operation and the value M, to obtain the second information, wherein the probability information comprises the quantization probability, and M is the denominator of the quantization probability.

47. The apparatus according to any one of claims 34 to 46, wherein the encoding module is specifically configured to:

obtain, based on the first mapping relationship, an integer value corresponding to the target symbol; and restore the integer value to the first information and the second information through a third operation, wherein the first information and the second information each are an integer value.

48. The apparatus according to any one of claims 34 to 47, wherein the probability information comprises PMF information corresponding to each symbol, and the PMF information comprises a first value and a second value; a sum of the first value and the second value is the value of the PMF; the probability information further comprises CDF information corresponding to each symbol, and the CDF information comprises a third value and a fourth value; and the third value and the fourth value are constructed in the following manner:

sequentially determining, in the preset order through accumulation based on first values of the plurality of symbols, a third value corresponding to each symbol; and
sequentially determining, in the preset order through accumulation based on second values and third values of the plurality of symbols, a fourth value corresponding to each symbol.

49. The apparatus according to claim 48, wherein the second information comprises first sub-information, second sub-information, and third sub-information, wherein

the first sub-information in the first mapping relationship is constructed in the following manner: performing a subtraction operation on a third value of the target symbol and the value of the PMF of the target symbol, to obtain the first sub-information;
the second sub-information in the first mapping relationship is constructed in the following manner: performing a summation operation on the third value of the target symbol and a first value of the target symbol, and performing a subtraction operation on an operation result of the summation operation and 1, to obtain the second sub-information; and
the third sub-information in the first mapping relationship is constructed in the following manner: performing a subtraction operation on a fourth value of the target symbol and the third value of the target symbol, and performing a subtraction operation on an operation result of the subtraction operation and the first value of the target symbol, to obtain the third sub-information.

50. The apparatus according to claim 49, wherein the second operation comprises:

performing the summation operation on the status information and the value M, and performing the bit shift operation on the summation result of the summation operation, wherein the probability information comprises the quantization probability, and M is the denominator of the quantization probability; and performing a summation operation on the shift result of the bit shift operation and the first sub-information; and
when an operation result of the summation operation is greater than the second sub-information, using a summation result of the operation result of the summation operation and the third sub-information as the second encoded data; or
when an operation result of the summation operation is less than the second sub-information, using the operation result of the summation operation as the second encoded data.

51. The apparatus according to claim 49 or 50, wherein when the value M is 256, the first information is stored by using 10 bits, the first sub-information is stored by using 8 bits, the second sub-information is stored by using 7 bits, the third sub-information is stored by using 7 bits, a sum of the first values of the plurality of symbols is 128, and the third sub-information is less than 128.

52. A data encoding apparatus, used in an asymmetric numeral system ANS-based encoder, wherein the apparatus comprises:

an obtaining module, configured to obtain a first symbol, wherein a sum of a quantization probability corresponding to the first symbol and a quantization probability corresponding to a second symbol is 1, a difference between the quantization probability corresponding to the first symbol and 1 is less than a threshold, and a difference between the quantization probability corresponding to the second symbol and 0 is less than the threshold; and
an encoding module, configured to: when a value relationship between status information of the encoder and a value M meets a first condition, perform a first operation on the status information and the value M to obtain first encoded data, and update the status information to 0; or
when a value relationship between status information of the encoder and a value M does not meet a first condition, add 1 to the status information.

53. The apparatus according to claim 52, wherein the obtaining module is further configured to:

obtain the second symbol; and
the encoding module is further configured to: use the status information of the encoder as the first encoded data, and update the status information to a difference between the value M and 1.

54. A data decoding apparatus, used in an asymmetric numeral system ANS-based decoder, wherein the apparatus comprises:

an obtaining module, configured to obtain status information of the decoder and a memory bit, wherein the status information corresponds to a first bit, and the first bit is a current to-be-decoded bit; and
a decoding module, configured to determine, based on a first mapping relationship, first information, second information, and third information that correspond to the status information, wherein the first information is a target symbol corresponding to the first bit, the target symbol is a decoding result of the first bit, the second information indicates a quantity of bits selected from the memory bit, the third information is used to perform a summation operation with a bit selected from the memory bit based on the third information, a result of the summation operation is used to update the status information, updated status information corresponds to a second bit, and the second bit is a to-be-decoded bit after the first bit.

55. The apparatus according to claim 54, wherein the decoding module is further configured to:
remove, from the memory bit, the selected bit, to obtain an updated memory bit.

56. The apparatus according to claim 54 or 55, wherein the first information, the second information, or the third information represents an integer value.

57. The apparatus according to any one of claims 54 to 56, wherein the first information in the first mapping relationship is constructed in the following manner:

using x that satisfies $C(x) \leq s < (C(x) + P(x))$ as the first information, wherein C represents a value of a CDF, P represents a value of a PMF, and s represents the status information; or
using x that satisfies $C1(x) \leq s < C1(x) + P1(x)$ or $C2(x) \leq s < C2(x) + P2(x)$ as the first information, wherein C1 represents a third value corresponding to a CDF, P1 represents a first value corresponding to a PMF, C2 represents a fourth value corresponding to the CDF, P2 represents a second value corresponding to the PMF, s represents the status information, and a sum of the first value and the second value is a value of the PMF.

58. The apparatus according to any one of claims 54 to 57, wherein the second information in the first mapping relationship is constructed in the following manner:

using a value of $clz(s - C(x) + P(x)) + X$ as the second information, wherein clz represents taking a quantity of leftmost bits that are consecutive 0s in a value, and X is a preset fifth value; or
performing a bit shift operation on a value of $s - C(x) + P(x)$, to obtain the third information, wherein a shift quantity of the bit shift operation is obtained based on the second information; or
performing a bit shift operation on a value of $s - C(x) + P(x)$, and subtracting a value M from an operation result of the bit shift operation, to obtain the third information, wherein M is a denominator of the quantization probability, and a shift quantity of the bit shift operation is obtained based on the second information; or
using a value of $clz(s' - C(x) + P(x)) + X$ as the second information, wherein clz represents taking a quantity of leftmost bits that are consecutive 0s in a value, X is a preset fifth value, and s' is obtained in the following manner:
if $C2(x) \leq s$, $s' = P1(x) + s - C2(x) + P(x)$; or if $C2(x) > s$, $s' = s - C1(x) + P(x)$.

59. The apparatus according to any one of claims 54 to 58, wherein the third information in the first mapping relationship is constructed in the following manner:

performing the bit shift operation on the value of $s - C(x) + P(x)$, to obtain the third information, wherein the shift quantity of the bit shift operation is obtained based on the second information; or
performing the bit shift operation on the value of $s - C(x) + P(x)$, and subtracting the value M from the operation result of the bit shift operation, to obtain the third information, wherein M is the denominator of the quantization probability, and the shift quantity of the bit shift operation is obtained based on the second information; or performing a bit shift operation on a value of s' - C(x) + P(x), to obtain the third information, wherein a shift quantity of the bit shift operation is obtained based on the second information.

60. The apparatus according to any one of claims 54 to 59, wherein the first information, the second information, or the third information is obtained based on probability information; the probability information comprises the value of the probability mass function PMF; and the value of the PMF is constructed in the following manner:

sequentially determining a value of a PMF of each of a plurality of symbols, wherein the plurality of symbols comprise the target symbol, wherein
when a value of a PMF of the target symbol is determined, a total value of remaining PMFs other than a PMF of a determined symbol is multiplied by a probability of the target symbol, a ratio of a multiplication result of the multiplication to a remaining probability obtained by excluding the determined symbol is calculated, and the PMF of the target symbol is determined based on a relationship between the ratio and a preset value.

61. The apparatus according to claim 60, wherein the preset value is 1, and the relationship is taking a larger value.

62. The apparatus according to any one of claims 54 to 61, wherein the first information, the second information, or the third information is obtained based on the probability information, the probability information comprises the value of the cumulative distribution function CDF, and the value of the CDF is constructed in the following manner:

sequentially determining a value of a CDF of each symbol in a preset order, wherein the preset order is determined based on a relationship between values of PMFs corresponding to the plurality of symbols, and the plurality of symbols comprise the target symbol, wherein
when probability distribution corresponding to the probability information of the target symbol is symmetric distribution, the preset order is an alternating order along two sides of a peak point in the symmetric distribution; or
when probability distribution corresponding to the probability information of the target symbol is discrete distribution, the preset order is specifically a descending order; or
when probability distribution corresponding to the probability information of the target symbol is discrete distribution, the preset order is specifically an ascending order.

63. The apparatus according to any one of claims 54 to 62, wherein the obtaining module is further configured to:

obtain an encoding result, wherein the encoding result is obtained by encoding pixel data of an image, and the status information and the memory bit are obtained based on the encoding result;
process the encoding result, to obtain a distribution feature of the pixel data, wherein the distribution feature comprises a mean value or a variance; and
determine, from a plurality of mapping relationships based on the distribution feature, the first mapping relationship corresponding to the distribution feature.

64. The apparatus according to any one of claims 54 to 63, wherein the decoding module is specifically configured to:

obtain, based on the first mapping relationship, an integer value corresponding to the status information; and
restore the integer value to the first information, the second information, and the third information, wherein the first information, the second information, and the third information each are an integer value.

65. A data decoding apparatus, used in an asymmetric numeral system ANS-based decoder, wherein the apparatus comprises:

an obtaining module, configured to obtain status information of the decoder, wherein the status information corresponds to a first bit, and the first bit is a current to-be-decoded bit; and
a decoding module, configured to: if the status information is a difference between a value M and 1, determine that a decoding result of the first bit is a second symbol, and update the status information to a result of reading the value M bits from a memory bit; or
if the status information is not a difference between a value M and 1, determine that a decoding result of the first bit is a first symbol; and if the status information is 0, update the status information to a summation result of a difference between the value M and 2 and a value of 1 bit read from the memory bit; or if the status information is not 0, update the status information to a difference between the status information and 1, wherein updated status information corresponds to a second bit, and the second bit is a to-be-decoded bit after the first bit.

66. A computing device, wherein the computing device comprises a storage and a processor, the storage stores code, and the processor is configured to: obtain the code, and perform the method according to any one of claims 1 to 33.

67. A computer storage medium, wherein the computer storage medium stores one or more instructions, and when the instructions are executed by one or more computers, the one or more computers are enabled to perform the method according to any one of claims 1 to 33.

68. A computer program product, comprising code, wherein when the code is executed, the method according to any one of claims 1 to 33 is implemented.

FIG. 1A

Imaging
device 41

Antenna 42

Processing circuit 46

Encoder 20

Decoder 30

Processor 43

Storage 44

Display device
45

Video coding system 40

FIG. 1B

FIG. 2

EP 4 637 150 A1

FIG. 3

400

Video coding device

410

430

450

Processor

420

Encoding/
Decoding
module

440

Receiver

Transmitter

470

460

Memory

Downstream port

Upstream port

FIG. 4

FIG. 5

| Obtain a target symbol | 601 |

↓

| Obtain, based on a first mapping relationship, first information and second information that correspond to the target symbol, where the first information and the second information are obtained based on probability information corresponding to the target symbol | 602 |

↓

| Obtain first encoded data through a first operation based on the first information and status information of an encoder | 603 |

↓

| Update the status information through a second operation based on the second information, to obtain second encoded data, where the first encoded data and the second encoded data are used to obtain an encoding result of the target symbol, and the first operation and the second operation do not include a division operation | 604 |

FIG. 6

FIG. 7

FIG. 8

EP 4 637 150 A1

| Obtain status information of a decoder and a memory bit, where the status information corresponds to a first bit, and the first bit is a current to-be-decoded bit | 901 |

↓

| Determine, based on a first mapping relationship, first information, second information, and third information that correspond to the status information, where the first information is a target symbol corresponding to the first bit, the target symbol is a decoding result of the first bit, the second information indicates a quantity of bits selected from the memory bit, the third information is used to perform a summation operation with a bit selected from the memory bit based on the third information, a result of the summation operation is used to update the status information, updated status information corresponds to a second bit, and the second bit is a to-be-decoded bit after the first bit | 902 |

FIG. 9

```
┌──────────────┐                                    ⬭ Entropy ⬭      ┌──────────────┐
│   Codeword   │ ─────────────────────────────────▶ ⬭ decoding ⬭ ──▶ │     Data     │
└──────┬───────┘                                    ⬭          ⬭      └──────────────┘
       ┆                                                  ▲
       ┆   Storage probability distribution/Model prediction
       ▼                                                  │
┌──────────────┐     ┌──────────────────┐     ┌──────────────┐
│ Probability  │ ──▶ │ Discrete PMF and │ ──▶ │ Decoding table│
│ distribution │     │  discrete CDF    │     │              │
└──────────────┘     └──────────────────┘     └──────────────┘
```

FIG. 10A

FIG. 10B

1100

1101

1102

| Obtaining module | Encoding module |

FIG. 11

1200

1201

1202

| Obtaining module | Decoding module |

FIG. 12

1300

Execution device

Antenna

Antenna

| Receiver 1301 | Transmitter 1302 |

Processor 1303

Storage 1304

Application processor 13031

Communication processor 13032

FIG. 13

1400

Server

1414 — Central processing unit    Power supply    1426

1450

Wired or wireless network interface

Operating system    1441

Data    1444

Application program    1442

Storage medium    1430

1458

Input/Output interface

Storage    1432

FIG. 14

FIG. 15

EP 4 637 150 A1

# EP 4 637 150 A1

## INTERNATIONAL SEARCH REPORT

International application No.

**PCT/CN2024/071323**

### A. CLASSIFICATION OF SUBJECT MATTER

H04N 19/182(2014.01)i

According to International Patent Classification (IPC) or to both national classification and IPC

### B. FIELDS SEARCHED

Minimum documentation searched (classification system followed by classification symbols)

IPC: H04N

Documentation searched other than minimum documentation to the extent that such documents are included in the fields searched

Electronic data base consulted during the international search (name of data base and, where practicable, search terms used)

CNABS; CNTXT; CNKI; VEN; USTXT; WOTXT; EPTXT; GOOGLE; IEEE: 编码, 解码, 量化, 概率, 状态, 码字, 除法, 编码表, 残差, code, decode, QP, probability, residual, state, table

### C. DOCUMENTS CONSIDERED TO BE RELEVANT

| Category* | Citation of document, with indication, where appropriate, of the relevant passages | Relevant to claim No. |
|---|---|---|
| A | US 2019068994 A1 (GOOGLE LLC) 28 February 2019 (2019-02-28) description, paragraphs [0018]-[0155], and figures 1-14 | 1-68 |
| A | CN 114598873 A (HUAWEI TECHNOLOGIES CO., LTD.) 07 June 2022 (2022-06-07) entire document | 1-68 |
| A | US 2019387232 A1 (QUALCOMM INC.) 19 December 2019 (2019-12-19) entire document | 1-68 |

☐ Further documents are listed in the continuation of Box C.   ☑ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | "&" document member of the same patent family |
| "P" document published prior to the international filing date but later than the priority date claimed | |

| Date of the actual completion of the international search | Date of mailing of the international search report |
|---|---|
| **22 March 2024** | **30 March 2024** |

| Name and mailing address of the ISA/CN | Authorized officer |
|---|---|
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

## INTERNATIONAL SEARCH REPORT
### Information on patent family members

International application No.

**PCT/CN2024/071323**

| Patent document cited in search report | | | Publication date (day/month/year) | Patent family member(s) | | | Publication date (day/month/year) |
|---|---|---|---|---|---|---|---|
| US | 2019068994 | A1 | 28 February 2019 | US | 2019068970 | A1 | 28 February 2019 |
| | | | | US | 10735736 | B2 | 04 August 2020 |
| | | | | US | 2020228804 | A1 | 16 July 2020 |
| | | | | US | 10887595 | B2 | 05 January 2021 |
| | | | | US | 2021120249 | A1 | 22 April 2021 |
| | | | | US | 11405618 | B2 | 02 August 2022 |
| | | | | WO | 2019045798 | A1 | 07 March 2019 |
| | | | | WO | 2019045797 | A1 | 07 March 2019 |
| | | | | EP | 3677027 | A1 | 08 July 2020 |
| | | | | EP | 3677027 | B1 | 08 November 2023 |
| | | | | JP | 2020522182 | A | 27 July 2020 |
| | | | | JP | 6923677 | B2 | 25 August 2021 |
| | | | | EP | 3677035 | A1 | 08 July 2020 |
| | | | | US | 10448019 | B2 | 15 October 2019 |
| | | | | KR | 20200003888 | A | 10 January 2020 |
| | | | | KR | 102314801 | B1 | 18 October 2021 |
| | | | | US | 2019394467 | A1 | 26 December 2019 |
| | | | | US | 10645389 | B2 | 05 May 2020 |
| CN | 114598873 | A | 07 June 2022 | CN | 114598873 | B | 20 June 2023 |
| US | 2019387232 | A1 | 19 December 2019 | KR | 20210021988 | A | 02 March 2021 |
| | | | | SG | 11202011478 | SA | 28 January 2021 |
| | | | | BR | 112020025748 | A2 | 16 March 2021 |
| | | | | US | 10939115 | B2 | 02 March 2021 |
| | | | | AR | 115577 | A1 | 03 February 2021 |
| | | | | CA | 3101059 | A1 | 26 December 2019 |
| | | | | WO | 2019246258 | A1 | 26 December 2019 |
| | | | | EP | 3811615 | A1 | 28 April 2021 |

Form PCT/ISA/210 (patent family annex) (July 2022)

## EP 4 637 150 A1

### REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202310028884

- CN 202310295323